(19)

**Europäisches Patentamt**
**European Patent Office**
**Office européen des brevets**

(11) **EP 4 636 762 A1**

(12) **EUROPEAN PATENT APPLICATION**

(43) Date of publication:
**22.10.2025 Bulletin 2025/43**

(21) Application number: **25171287.3**

(22) Date of filing: **17.04.2025**

(51) International Patent Classification (IPC):
**G10L 21/0364** *(2013.01)* **H03G 3/32** *(2006.01)*
**H03G 9/00** *(2006.01)* **H03G 9/02** *(2006.01)*

(52) Cooperative Patent Classification (CPC):
**G10L 21/0364; H03G 3/32; H03G 9/005;
H03G 9/025**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **19.04.2024 US 202463636400 P**
**12.09.2024 US 202463694107 P**

(71) Applicant: **Disney Enterprises, Inc.
Burbank, CA 91521 (US)**

(72) Inventor: **Briand, Manuel
Burbank, 91521 (US)**

(74) Representative: **Peterreins Schley
Patent- und Rechtsanwälte PartG mbB
Hermann-Sack-Straße 3
80331 München (DE)**

Remarks:
A request for correction of the description has been
filed pursuant to Rule 139 EPC. A decision on the
request will be taken during the proceedings before
the Examining Division (Guidelines for Examination
in the EPO, A-V, 3.).

(54) **SYSTEM AND METHOD TO PROVIDE PERSONALIZED AUDIO STREAMING AND RENDERING**

(57) Systems and methods to provide personalized audio streaming and rendering include receiving a cinematic audio track for selected content and a maximum accessible audio track for the content, and adjustably combining the cinematic audio track and accessible audio track to provide an improved dialogue audio track which allows a user/listener to hear the dialogue over an environmental noise floor, the combining being provided by a cross-fade renderer adjusted manually by the user/-listener or automatically adjusted based on a measured noise floor, and optionally providing a personalized equalizer for hearing impairments. It also allows a content provider to create the maximum accessible audio track for a given content separate from the user/listener, which may also use a X-Fade renderer to verify quality of the accessible audio track.

FIG. 15A

## Description

### Cross Reference to Related Applications

The present application claims priority to US Provisional Patent Application No. 63/636,400, filed April 19, 2024, and US Provisional Patent Application No. 18/999,628, filed December 23, 2024, which are both incorporated herein by reference to the fullest extent permitted by applicable law.

### Background

Current audio streaming solutions typically rely on a single audio bitstream and decoder per streaming application which limits the ability of the content owners and streaming service providers to personalize the audio experience it provides to the end user.

In particular, existing steaming services provide separate streams for different versions enhanced dialogue, e.g., English dialogue boost high, English dialogue boost medium, and the like. In that case, the user must select which version they want to listen to. Also, to change to another audio version, e.g., because the background environment noise changed, the user must make a request, and a new version is retrieved from the appropriate content server. Additionally, most TV devices apply post-processing to the decoded audio bitstream, such as AI sound enhancements, to reduce noise or boost dialogue which does not preserve the integrity of the original sound mix nor the creative intent of the content owners.

Switching audio streams can be cumbersome, slow and incur digital streaming file buffering/loading delays during the audio delivery from the Content Delivery Network (CDN) to the end user. Also, conventional systems only provide a pre-defined number of dialogue enhanced versions (e.g., 3-5 versions), without any guarantee that a given selected version may be ideal for the noise environment of the listener/user. Such an approach can make it difficult for the user to hear the dialogue of the audio content when the background noise becomes louder than intended for the selected stream. For example, if the user selects the "English - Low Dialogue Boost" track but experience higher than expected environmental noise, the selected audio stream might not be able to provide full dialogue intelligibility for the end user, most likely the "English - High Dialogue Boost" would have been preferred.

Also, existing streaming services require each user in the room or listening environment to consume the exact same audio mix.

Thus, it would be desirable to have a system and method that overcomes the shortcoming of the current approaches and enhances the audio experience of the user without having to switch stream and reach all the way back to the CDN or the origin server of the content provider where all the pre-defined streams are available.

### Brief Description of the Drawings

FIG. 1 is a top-level block diagram of components of a content provider (CP) side of a system to provide personalized audio streaming and rendering which creates a maximum version of an accessible audio mix, in accordance with embodiments of the present disclosure.

Fig. 2A is a top-level block diagram of a user/listener side of a system to provide personalized audio streaming and rendering for a Smart TV with remote control or user device controlled cross-fade audio mix, in accordance with embodiments of the present disclosure.

Fig. 2B is a top-level block diagram of a user/listener side of a system to provide personalized audio streaming and rendering for a single user device, in accordance with embodiments of the present disclosure.

Fig. 2C is a top-level block diagram of a user/listener side of a system to provide personalized audio streaming and rendering for a Smart TV with multiple user devices each having a personalized cross-fade audio mix, in accordance with embodiments of the present disclosure.

Fig. 2D is a top-level block diagram of a user/listener side of a system to provide personalized audio streaming and rendering for a Smart TV with multiple user devices each having a personalized cross-fade audio mix and content selection, in accordance with embodiments of the present disclosure.

Fig. 3A, Fig. 3B, Fig. 3C, Fig. 3D, and Fig. 3E show block diagrams of alternative embodiments of the Dialogue Clarity Engine (DCE) of Fig. 1, which includes a combination of Dialogue Isolation (DI), Dialogue Enhancement (DE), Dynamic Range Compression (DRC), Enhanced Dialogue Insertion (EDI), and Audio Loudness Normalization (ALN) in various signal processing positions, and a corresponding effect on dynamic range, in accordance with embodiments of the present disclosure.

Fig 4 shows two diagrams of dynamic range adjustment for Dialogue Enhancement (DE), a first diagram where the integrated loudness (IL) of the dialogue (Dx) audio is the same as the non-dialogue (or music and effects or M&E or MNE) audio and a second diagram where the integrated loudness (IL) of the dialogue (Dx) is different from the non-dialogue audio (or music and effects M&E or MNE), in accordance with embodiments of the present disclosure.

Fig. 5A is a diagram of an interleaved original Cinematic Mix (Cin-Mix) and maximum accessible mix (Max-Acc-Mix) content audio stream for providing accessible audio, in accordance with embodiments of the present disclosure.

Fig. 5B, is a diagram of an interleaved Cin-Mix, Mid-Acc-Mix and Max-Acc-Mix content audio stream for providing accessible audio, in accordance with embodiments of the present disclosure

Fig. 5C is a diagram of an interleaved Cin-Mix and Max-Acc-Mix content audio stream for providing accessible audio with two languages for voiceover audio, in accordance with embodiments of the present disclosure.

Fig 5D is a block diagram showing a non-encoded content server having separately-saved non-encoded Cin-Mix and Max-Acc-Mix and Cin-Mix, Mid-Acc-Mmix, and Max-Acc-Mix audio content streams as an input to an audio encoder and an encoded content server having an interleaved Cin-Mix/Max-Acc-Mix and Cin-Mix/Mid-Acc-Mix/Max-Acc-Mix audio content as an output from an audio encoder, in accordance with embodiments of the present disclosure.

Fig. 5E is a table showing various encoding and decoding options for a given stream type and user desired configuration, in accordance with embodiments of the present disclosure.

Fig. 6 is a block diagram of various components of a system to provide personalized audio streaming and rendering connected via a network, in accordance with embodiments of the present disclosure.

Fig. 7 shows a block diagram of the Dialogue Enhancement (DE) Logic of Figs. 3A-3E, in accordance with embodiments of the present disclosure.

Fig. 8 shows a block diagram of the Dynamic Range Compression (DRC), Enhanced Dialogue Insertion (EDI), and Audio Loudness Normalization (ALN) of Figs. 3A-3E, in accordance with embodiments of the present disclosure.

Fig. 9 is a graph showing a varying gain function that may be used by the DRC of Figs. 3A-3E to vary the DRC gain to provide range compression, in accordance with embodiments of the present disclosure.

Fig. 10A is a block diagram of a cross-fade renderer (X-Fade) and a corresponding graph showing X-Fade power preserving gain curves, in accordance with embodiments of the present disclosure.

Fig. 10B is a block diagram of a cross-fade renderer (X-Fade) for a stereo (L/R) input audio and a corresponding graph showing X-Fade power preserving gain curves for the range of positions of a X-Fade slider adjustment, in accordance with embodiments of the present disclosure.

Fig. 10C is a block diagram of a cross-fade renderer (X-Fade) for a stereo (L/R) input audio with three inputs and a corresponding graph showing X-Fade power preserving gain curves for the range of positions of a X-Fade slider adjustment, in accordance with embodiments of the present disclosure.

Fig. 11 is a block diagram of components of a personalized equalizer (Pers. EQ) logic, in accordance with embodiments of the present disclosure.

Fig. 12A is a screen illustration of a graphical user interface (UI) for DCE gain adjustment & Max-Acc-Mix monitoring used by a CP user/administrator for a content provider with the ability to set/adjust the DCE gains and noise floor and listen to the result across the cross-fade range, in accordance with embodiments of the present disclosure.

Fig. 12B is a diagram of a Smart TV remote control for manually adjusting the cross-fade (X-fade) renderer of Figs. 2A, 2C and 2D, in accordance with embodiments of the present disclosure.

Fig. 12C is a screen illustration of a graphical user interface (UI) for an Acc App used by a user with the ability to set/adjust the cross-fade and enable certain features, in accordance with embodiments of the present disclosure.

Fig. 12D is a screen illustration of a graphical user interface (UI) for a listening test to determine parameters for a personal equalizer, in accordance with embodiments of the present disclosure.

Fig. 13A shows a flow diagram for Portal/DCE Logic of Fig. 1, in accordance with embodiments of the present disclosure.

Fig. 13B shows a flow diagram for Portal UI Logic of Fig. 1, in accordance with embodiments of the present disclosure.

Fig. 13C shows a flow diagram for Hub Accessibility (Acc) App Logic of Figs. 2A,2C,2D, in accordance with embodiments of the present disclosure.

Fig. 13D shows a flow diagram for Acc App UI Logic of Figs. 2A,2C,2D, in accordance with embodiments of the present disclosure.

Fig. 14A, Fig. 14B, Fig. 14C, Fig. 14D and Fig. 14E, show block diagrams of various embodiments for different types of audio inputs to be streamed and adjustably rendered by the cross-fade renderer of Fig. 10A, Fig. 10B or Fig. 10C, in accordance with embodiments of the present disclosure.

Fig. 15A and Fig.15B show block diagrams of various embodiments for different types of audio inputs to be streamed and adjustably rendered by the crossfade renderer of Fig. 10A, Fig. 10B or Fig. 10C for video on demand (VOD) and live sports/events (Live) applications, respectively, in accordance with embodiments of the present disclosure.

**Detailed Description**

As discussed in more detail below, in some embodiments, the present disclosure is directed to a system and method to provide personalized audio streaming and rendering, including cross-fade content delivery, according to the rules, requirements and needs of the content owners.

The present disclosure provides a personalized audio streaming experience to the end user by providing an accessible audio mix or track created from the original studio cinematic mix which enables the user to understand the story-telling dialogue (Dx) in across a wide range of user devices and environmental background noise levels. The accessible mix is created by providing enhanced audio with dialogue clarity and/or dynamic range compression (adaptive to the environmental noise floor), and multiple-dialogue audio streams simultaneously across single or multiple devices (applies to languages, sports commentaries etc.).

The system and method of personalized audio streaming & rendering of the present disclosure provides various applications and configurations, including: for video on demand (VOD) applications, it provides accessible audio streaming including enhanced dialogue, audio description (or narration) and voice-over (VO), and for live sports/events audio streaming applications, it provides options such as home-&-away sports team commentaries and sports team commentary focus or stadium sound focus, as discussed herein.

The present disclosure provides the rendering aspect of the decoded streams based on what the end user wants to hear to provide an optimized individual listening experience or a personalized audio experience. It also provides audio with multi-stream to enhance the audio experience (with accessibility, localization, and synchronization) and can perform single or multiple audio software decoding within the streaming app itself. No existing streaming service is able to simultaneously play and render at least two distinct audio mixes, as described in the present disclosure.

Current commercial solutions for providing an enhanced listening experience have been standardized as shown in the standard ATSC-3.0, which supports both Dolby AC-4 and MPEG-H codec audio decoders, and are designed to provide personalized listening and an immersive audio experience with enhanced dialogue clarity. However, these existing commercial solutions rely on an audio production format that has not yet been embraced by the entertainment industry and requires a multi-dimensional audio renderer which is complex and difficult for Smart TV manufacturer (OEM) partners & for streaming services to implement.

One of the advantages of the system and method of the present disclosure is the ability to provide a single or multi-device synchronized audio-visual (AV) experience that is also accessible, personalized and localized. The solution is "accessible" because of a native and adaptive dialogue enhancement solution provided by the present disclosure. Also, the solution is "localized" because of the nature of the multi-dialogue audio support with alternate language rendering of native/enhanced (or accessible) dialogue tracks, as well as supporting a simultaneous dominant and ducted (non-dominant) dialogue track. This applies to alternate language tracks, narration (audio description or AD) tracks, voice-over (VO), live sports commentary (home/away team commentary), and the like. The solution is "synchronized" because there is only one streaming application performing the audio decoding, which allows multiple users watching different streams of the same show, e.g., in different languages, to be synchronized. Conventional solutions of co-watching using multiple streaming applications on different devices do not provide perfect sync.

While current AC-4 and MPEG-H compatible products offer some dialogue enhancement features, they do not use the noise floor of the listening environment to automatically adjust a ratio between original audio cinematic mix (of dialogue and non-dialogue) and dialog-enhanced (or accessible) audio tracks, or the blended ratio of same, done by a cross-fade renderer of the present disclosure. They also do not provide the ability to do the adjust the ratio between original audio cinematic mix (of dialogue and non-dialogue) and dialog-enhanced (or accessible) audio tracks manually by the user in real-time, which also provides a fine-tuning capability without changing (or switching) streams. Also, the conventional products do not support the ability to reproduce multiple and self-contained audio tracks such as , cinematic/ accessible mixes including ED (enhanced dialogue), AD (audio description) and VO (voice-over) as well as sports/- personalized mixes including Home/Away team commentaries, and Stadium mix,) from a single streaming application, as described herein.

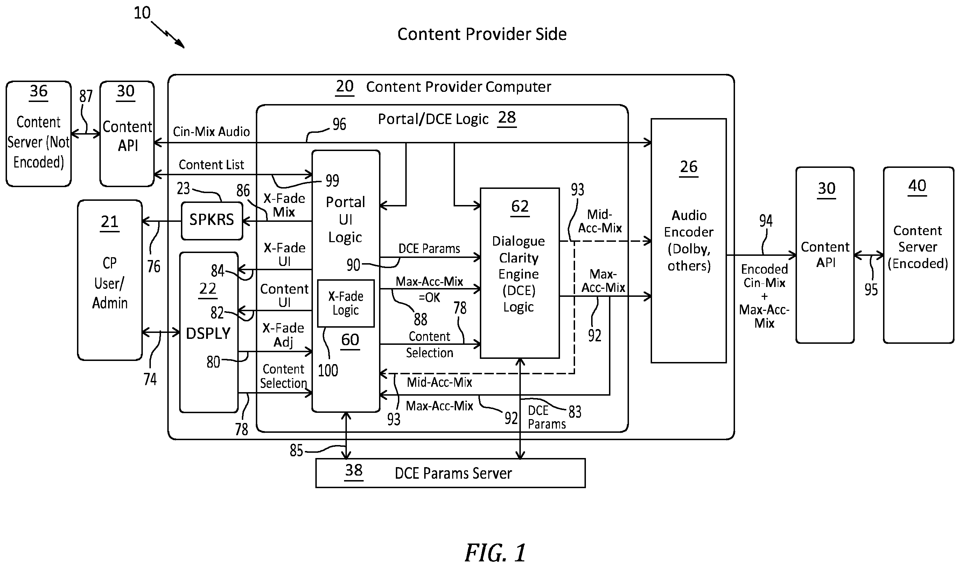

Referring to Fig. 1, a top-level block diagram is shown of components of a Content Provider (CP) side of a system to provide personalized audio streaming and rendering which creates a maximum version of an accessible audio mix (Max-Acc-Mix or MaxAcc mix), in accordance with embodiments of the present disclosure. In particular, the system 10 includes a content provider computer 20, that receives instructions from a content provider (CP) User/Admin 21 (e.g., content selection) and has Portal/DCE Logic 28 running on the CP computer 20, which receives non-encoded (or unencoded) audio portion of selected content, e.g., the original cinematic for theatrical near-field audio mix (or Cin-Mix or CinMix) from a Content Selection API (or Content API) 30, as indicated by a line 96, which may be obtained from a Non-Encoded Content Server 36, on a line 87. The "near-field audio mix" or "near-field mix" in theatrical audio refers to an audio mix created for home entertainment, such as streaming or dvd, using a smaller, near-field speaker setup to simulate a home theater environment. Such a mix is typically done after the standard theatrical mix has been approved and finalized by the studio. The near-field mix is designed to be listened to in a more intimate setting where the speakers are closer to the listener, unlike the large, reverberant spaces of a movie theater. The present disclosure will also work with an original cinematic mix that is a standard theatrical mix designed for movie theaters and the like. The content provider computer 20 may be a smart phone, computer, laptop, tablet, or other computer-based device.

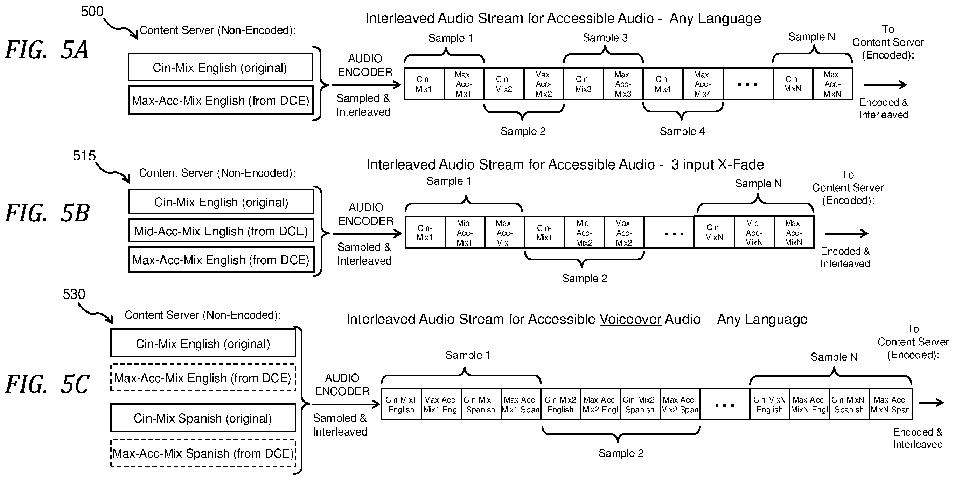

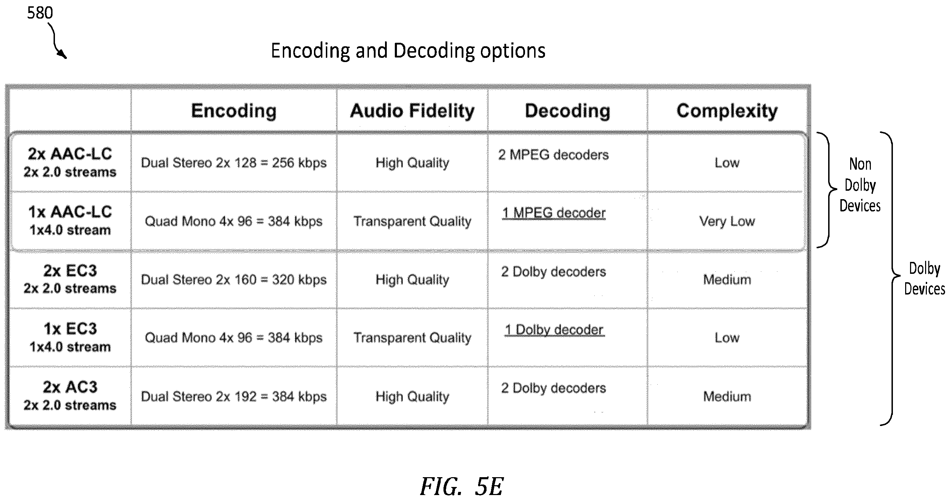

The Portal/DCE Logic 28 provides a Maximum Accessibility Mix (Max-Acc-Mix) audio track on a line 92 based on the original Cin-Mix content selected by the CP User/Admin 21 and audio signal processing performed by a Dialogue Clarity Engine 62 having DCE parameters or DCE Params (e.g., DCE gains, noise floor, and the like) set by default from previously stored values or set (or adjusted) by the CP user/admin 21 (discussed hereinafter). The Portal/DCE Logic 28 provides the Max-Acc-Mix on a line 92 to a known Audio Encoder 26, such as those described herein with Fig. 5E, discussed hereinafter. The Audio Encoder 26 also receives the original Cin-Mix audio signal (or track) on the line 96 from the DCE 62 and encodes the audio content of both stereo/surround/immersive tracks into a desired digital audio format (e.g., dual-stereo, extended-surround, extended-immersive encoded into Dolby E-AC3, Dolby ATMOS, MPEG AAC-LC, Opus or the like) and interleaves them into a single bit stream as shown by a line 94, as discussed with Figs 5A,5B,5C hereinafter. The Audio Encoder 26 saves the interleaved and encoded content output (Encoded Cin-Mix + Max-Acc-Mix) in an Encoded Content Server 40 using the Content API 30, as shown by a line 95. Once the encoded content is stored in the Encoded Content Server 40, it is available for streaming by the content provider to an authorized user (or listener) of the CP content. In some embodiments, the Portal/DCE Logic 28 may also provide a Mid-Acc-Mix audio track on a line 93 to the Encoder 26, having a loudness level or an enhancement level (partial DRC + DE or DRC only or DE only) between that of the Cin-Mix and the Max-Acc-Mix, discussed more hereinafter.

The Portal/DCE Logic 28 may include components such as a Portal UI Logic 60 and a Dialogue Clarity Engine 62, which work together to provide the Max-Acc-Mix and optional Mid-Acc-Mix.

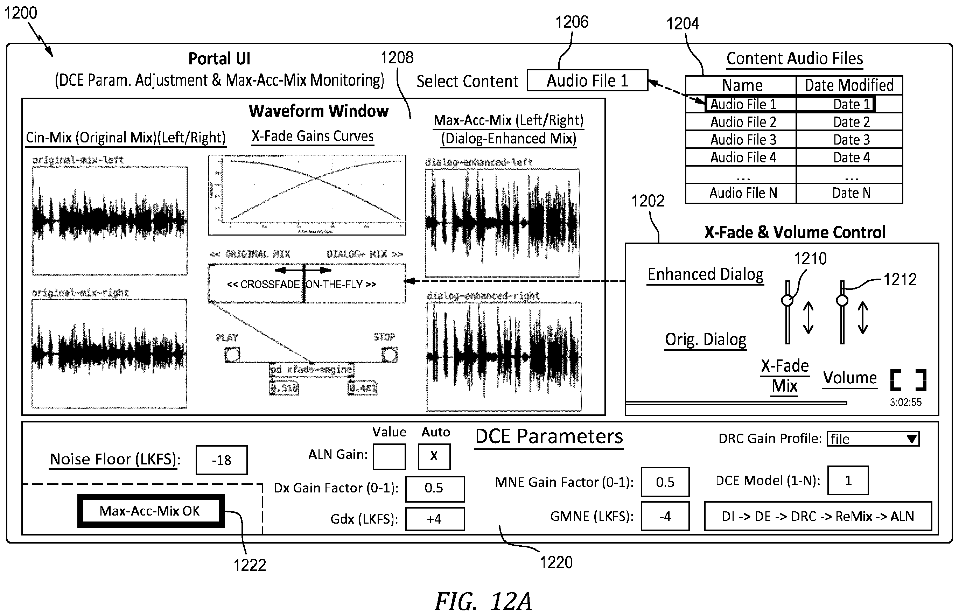

In particular, the Portal UI Logic 60 provides a portal user interface (or Portal UI) for the CP user/admin 21, which may have a Content UI section provided on a line 82 to the user/admin 21 via the display 22, shown by a line 74, which may display a listing of audio content (or audio files) available (see Fig. 12A) to create accessible audio mixes, which may be obtained from the Content API on the line 96. Portal UI Logic 60 also receives a content selection from the CP user/admin 21 on a line 78 via the user interaction with the Portal UI display 22 (or other input device connected to the CP computer 20 such as a keyboard, mouse or other device). The content selection on the line 78 may also be provided to the DCE 62 to allow the DCE to select the content if needed, which may be provided directly or from the Portal UI Logic 60. The UI for content selection may be shown as "Content Audio Files" on the display 22 as shown in Fig. 12A, as indicated by the line 74, discussed more hereinafter.

The Portal UI Logic 60 also requests and receives the original Cin Mix audio from the Non-Encoded Content Server 36 via the Content API 30 on the line 96. Also, the Portal UI Logic 60 provides DCE Params, e.g., DCE Gains/Model type and Noise Floor (NF), on a line 90 to a Dialogue Clarity Engine 62, which performs audio signal processing on the selected Cin-Mix audio track using the DCE Params, discussed more hereinafter. The Portal UI Logic 60 may also communicate on a line 85 with the DCS Params Server 38 to retrieve or save DCE Params. The Portal UI Logic 60 may receive the DCE Params from the user, e.g., via a Portal UI (see Fig. 12A) or from the DCE Params Server associated with the selected content, or from metadata embedded within the digital audio content (if previously determined for the content). The Portal UI Logic 60 provides a maximum accessible audio mix (Max-Acc-Mix) on the line 92, which is also provided (or fed back) to the Portal UI Logic 60 to allow the CP User/Admin 21 to adjust the accessible mix (Max-Acc-Mix) as desired though a Portal UI, as described herein.

The Dialogue Clarity Engine 62 also receives the DCE parameters (or DCE Params), e.g., NF, DCE Gains, and DCE Model type, on the line 90 from the Portal UI Logic 60 and receives a Max-Acc-Mix=OK signal on a line 88 from the Portal UI Logic 60, and also receives the Cin-Mix audio on the line 96 from the Encoded Content Server 36 via the Content API 30.

In some embodiments, the DCE 62 or the Portal UI Logic 60 may retrieve default or initial values for the DCE Params (e.g., Gains, Model type, NF and any other needed parameters) associated with the selected content from a DCE Parameters Server 38 on a line 83. In addition, the DCE 62 or the Portal UI Logic 60 saves the values of the DCE Params provided by the CP user/admin 21 for the selected content to a DCE Parameters Server 38.

The output of the DCE Logic 62 is the Max-Acc-Mix track provided on line 92 to the Audio Encoder 26, discussed hereinafter. The DCE 62 may also store the Max-Acc-Mix track on the Non-Encoded Content Server 36. The other input to the Encoder 26 is the original Cin-Mix audio track on a line 96. In some embodiments, the DCE may also provide a second output Mid-Acc-Mix on a line 93, which is an audio track tapped off from a predetermined intermediate (or mid) position within the DCE, as discussed hereinafter. The output of the Encoder 26 is an encoded and interleaved audio stream, having both the Cin-Mix and Max-Acc-Mix in a single bit stream, such as that shown in Figs. 5A, 5B, 5C, which is stored on the Encoded Content Server 40, via the Content API 30 shown by lines 94, 95, as discussed hereinafter.

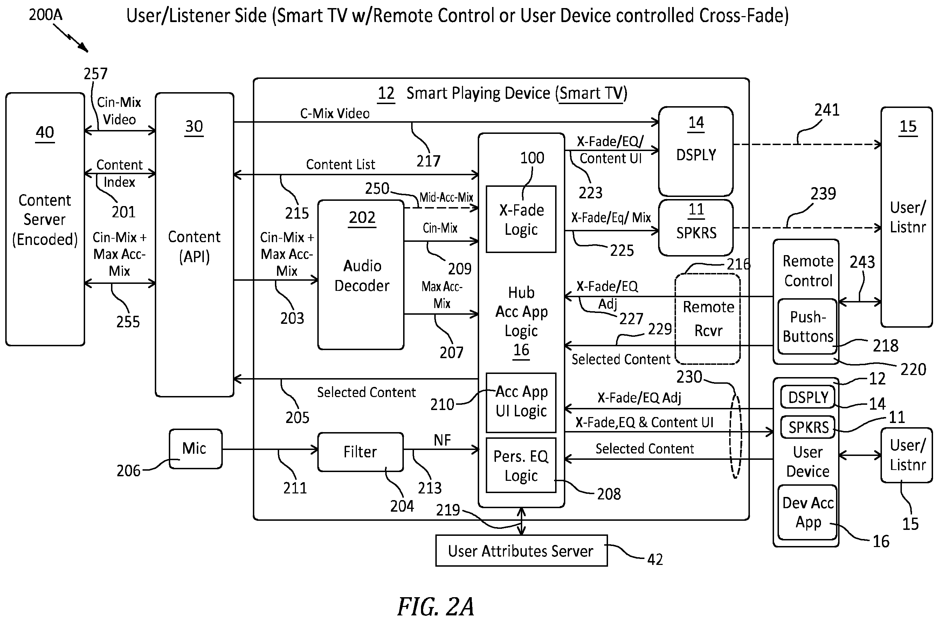

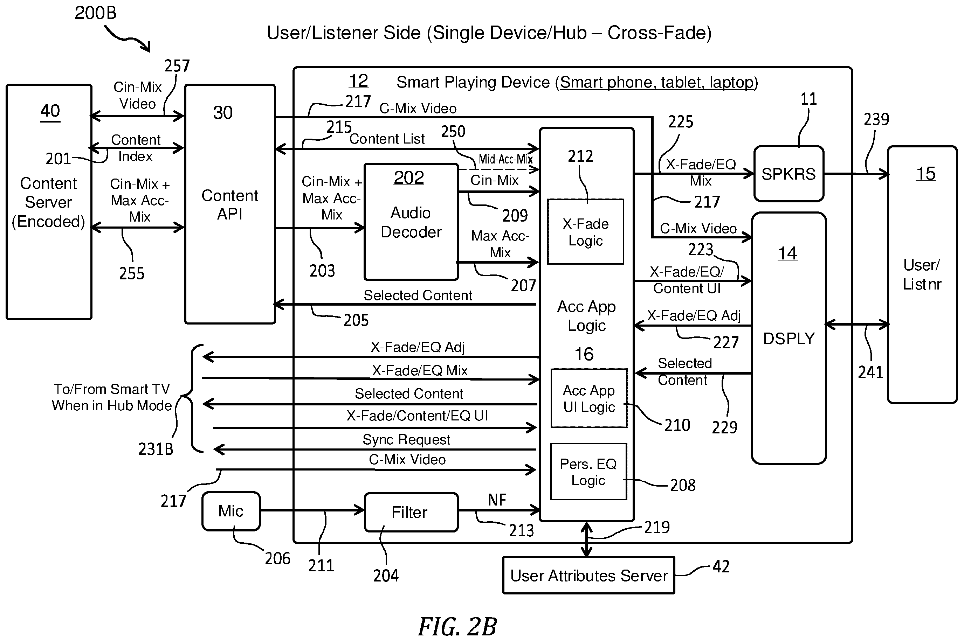

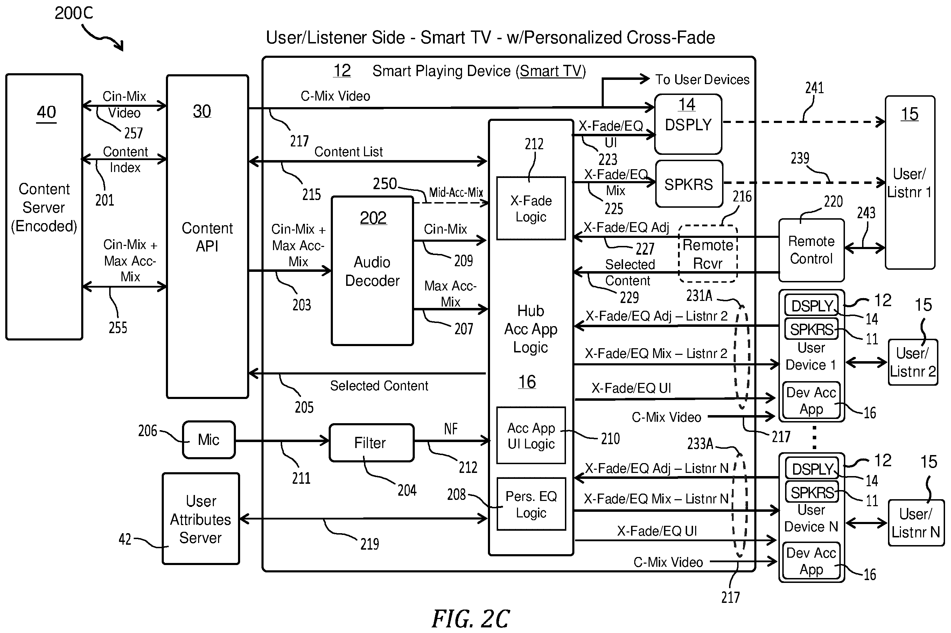

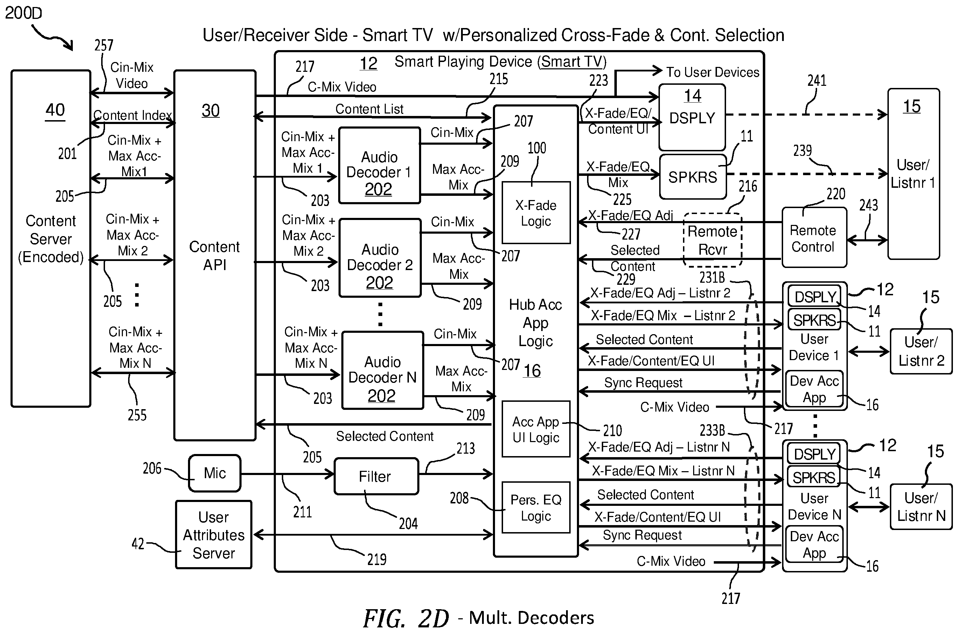

Referring to Figs. 2A,2B, 2C,2D, several top-level block diagrams 200A,200B, 200C, 200D, respectively, are shown for different configurations or applications of a user/listener side of the system and method of the present disclosure which accesses the Cin-Mix/Max-Acc-Mix encoded and interleaved content from the Encoded Content Server 40 and decodes the digital stream back into individual tracks Cin-Mix and Max-Acc-Mix (or Cin-Mix and Max-Pers-Mix) for use by a cross-fade renderer (X-Fade) 100 (discussed more hereinafter) to provide an personalized accessible cross-fade mix for one or more user/listeners 15, as described herein. The user/listener side of the system and method of the present disclosure will be described in detail hereinafter.

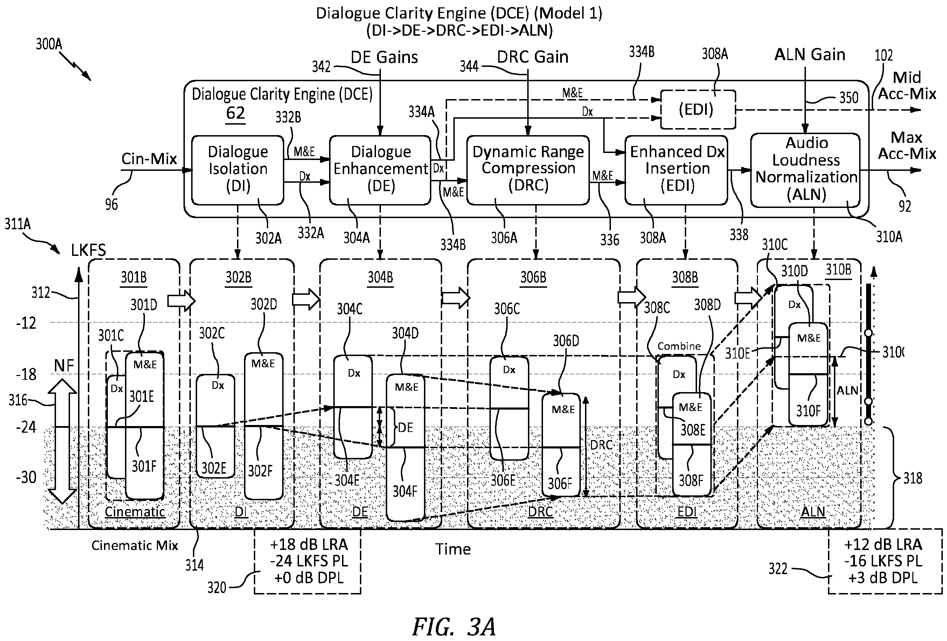

Referring back to Fig. 1 and to Figs. 3A-3E, block diagrams are shown of alternative embodiments of the Dialogue Clarity Engine (DCE) of Fig. 1 and a corresponding effect on audio dynamic range or audio loudness range, in accordance with embodiments of the present disclosure. In particular, the DCE includes several components or logic including Dialogue Isolation (DI) 302A, Dialogue Enhancement (DE) 304A, Dynamic Range Compression (DRC) 306A, Enhanced Dialogue Insertion (EDI) 308A, and Audio Loudness Normalization (ALN) 310A, that may be configured in several different ways to provide the maximum accessible mix audio (Max-Acc-Mix) on the line 92. The DCE model configuration depends on the selected content and the desired accessible audio mix results from the content provider CP user/admin 21. Also, the DCE may also receive DCE parameters from a DCE Params Server 38 on a line 83 (discussed hereinafter).

Referring to Fig. 3A a first DCE model 300A (DCE Model 1) configuration is shown having an order of components from left to right being DI-DE-DRC-EDI-ALN, 302A,304A,306A,308A,310A, and showing corresponding loudness range (LRA) bar graphs 302B,304B,306B, 308B,310B, respectively, that show the effect of each component on an input cinematic mix (Cin-Mix) LRA bar graph 301, discussed more hereinafter.

The LRA bar graphs 301B,02B,304B,306B,308B,310B are plotted on a graph 311 having a vertical axis 312 of loudness measured in LKFS (Loudness K-weighted Full Scale), and a horizontal time axis (or chronology). The vertical axis 312 also shows a noise floor (NF) range 316, and a noise floor setting region 318 used by the DCE to determine the desired Max-Acc-Mix.

The LRA bar graphs 301B,302B,304B,306B,308B,310B have an audio loudness range (LRA) for the overall program (or program loudness PL), as well as a loudness range (LRA) for the dialogue (Dx) portion of the audio (or Dialogue LRA or Dx LRA) 301C,302C,304C,306C,308C,310C and a loudness range (LRA) for the non-dialogue (or music and effects or M&E or MNE) portion of the audio (or Non-Dialogue LRA or M&E LRA) 301D,302D,304D,306D,308D,310D.

The LRA bar graphs 301B,302B,304B,306B,308B,310B may also include an average loudness or integrated loudness (IL) for the dialogue (Dx) portion of the audio (or Dialogue LRA or Dx LRA) 301E,302E,304E,306E, 308E,310E, and an average loudness or integrated loudness (IL) for the non-dialogue (or music and effects (M&E)) portion of the audio 301D,302D,304D,306D,308D,310D (or Non-Dialogue LRA or M&E LRA), and an average loudness or integrated loudness (IL) for the overall program (or program loudness (PL)) 310G.

In the DCE Model 1 of Fig. 3A, the input Cin-Mix is processed by the Dialogue Isolation (DI) logic 302A, which separates the audio dialogue (Dx) from the non-dialogue (or M&E) portions of the audio using known tools and provides two audio tracks, the Dx track on line 332A and the M&E track on line 332B. Tools that may be used for the DI Logic 302A include AI machine learning (ML) models (open-source and commercial) for extracting dialogue from video stream, such as SpleeterTM® (by Deezer Research), Demucs® (by MetaTM), AudioShake® (by AudioShake), or the like. The ML models used for DI would be trained using existing data sets for extracting dialogue from video across a broad range of content. Any other method or tool or model for isolating (or extracting or separating) the Dx from the M&E may be used if desired, provided it provides the function and performance described herein.

In this example, the loudness range LRA for the two track (which in this case is dominated by the M&E track) LRA = +18 dB (-16 - (-34) = +18), the program loudness (PL) = -24 LKFS and dialogue to program (or to residual or non-dialogue or M&E) loudness (DPL or DRL) = +0 dB (as the IL for both Dx and M&E are at -24 LKFS), as shown by a dashed box 320. The Dx and M&E audio tracks on the lines 332A,332B are provided to the Dialogue Enhancement (DE) logic 304A, which amplifies the Dx track and attenuates the M&E track while keeping the average or integrated loudness the same.

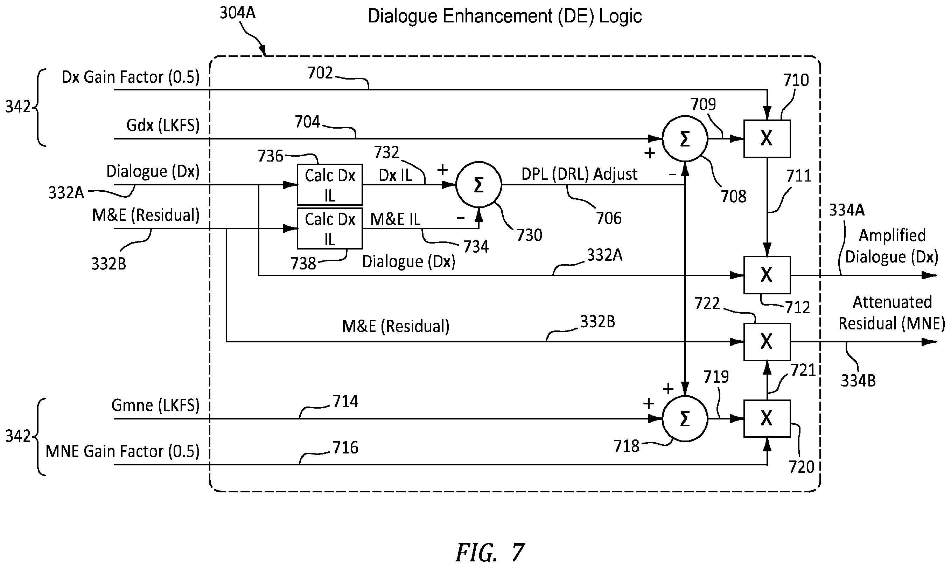

Referring to Fig. 7, a block diagram is shown of an embodiment of the Dialogue Enhancement (DE) Logic of Figs. 3A-3E, in accordance with embodiments of the present disclosure. In particular, the DE logic 304 receives the Dx audio track on the lines 332A and amplifies the Dx audio by multiplying Dx by a gain on a line 711 at a gain multiplication block 712 having a value greater than 1.0 (which equates to a resulting gain indicated by -LKFS herein) to provide an amplified dialogue (or amplified Dx) signal or track on the line 334A. The DE logic 304 also receives the M&E audio track on the lines 332B and attenuates the M&E audio by multiplying M&E by a gain on a line 721 at a gain multiplication block 722 having a value less than 1.0 (which equates to a resulting attenuation indicated by -LKFS herein) to provide an attenuated M&E (or non-dialogue or residual) signal or track on the line 334B.

The DE gains Gdx and Gmne, provide the desired boost in dialogue (Dx) over the M&E while keeping the average or integrated loudness (IL) substantially unchanged. In some embodiments, this is done by equally splitting the Dx amplification and M&E attenuation amounts, as indicated by the Dx Gain Factor and the M&E Gain Factor, on lines 702,716, respectively, which both have a value of 0.5 in the example shown, which provides an even split between Dx amplification gain Gdx and M&E attenuation gain Gmne. In particular, the Dx Gain Factor (e.g., 0.5) on the line 702 is multiplied by an adjusted Dx amplification gain Gdx on the line 709 at the gain multiplication block 710 to provide the actual Dx gain on line 711 to be multiplied by Dx on the line 332A at the gain block 712 to provide the amplified dialogue on the line 334A. Similarly, the M&E Gain Factor (e.g., 0.5) on the line 716 is multiplied by an adjusted M&E attenuation gain Gmne on the line 719 at the gain block 720 to provide the actual M&E gain on a line 721 to be multiplied by M&E on the line 332B at the gain block 722 to provide the amplified M&E on the line 334B.

In some embodiments, where the IL for the dialogue (Dx) is not the same as IL for the M&E, e.g., the Dx IL is louder (less negative) than the M&E IL, there may be an adjustment made to Dx and M&E gains, as shown by summation blocks 708,718. In particular, a DPL Adjust signal is provided on a line 706 to the summation blocks 708,718 to equally adjust the gain value for both the Dx and M&E. In that case, if the Dx IL is greater than M&E IL, the summation block 708 will reduce the Dx amplification gain Gdx on the line 704 to provide an adjusted Dx gain on line 709 and the summation block 718 will adjust the M&E attenuation gain Gmne on the line 714 (i.e., make it less negative) to provide the adjusted M&E gain on line 719 that is adjusted equally to the Gdx adjustment. In some embodiments, the DPL Adjust amount on the line 706 is determined by the DE Logic 304 by calculating the difference between the Dx IL on a line 732 and the M&E IL on a line 734, as shown by a summation block 730 (i.e., Dx IL - M&E IL). Also, in some embodiments, the DCE Logic 304A may calculate the integrated loudness (IL) of the dialogue Dx and the IL of the M&E (non-dialogue) from the input audio tracks Dx and M&E on lines 332A, 332B by performing a Calculate Dx IL logic 736 and Calculate M&E IL logic 738, respectively, using known methods or tools, and providing Dx IL on a line 732 to a positive (or plus) input of the summing block 730 and M&E IL on a line 734 to a negative (or minus) input of the summing block 730. IL may be determined by known tools such as Insight 2 or RX by iZotope, Inc., or an open source software IL tool, such as described at: https://github.com/csteinmetz1/pyloudnorm, or loudness software by Youlean (see: https://youlean.co). Other techniques for determining IL may be used if desired. In some embodiments, the Dx IL and M&E IL on lines 732,734, respectively, may be determined separately outside the DCE Logic 304 and provided as an input to the DCE Logic 304A. In that case, the Calculate Dx IL logic 736 and Calculate M&E IL would not be used.

Also, in some embodiments, instead of a single gain adjustment DPL Adjust, there may be separate adjustments (not shown) to the Dx and M&E gains based on the desired resulting audio output. Also, the Dx Gain Factor, Gdx, MNE Gain Factor, Gmne may be referred to collectively as DE gains 342.

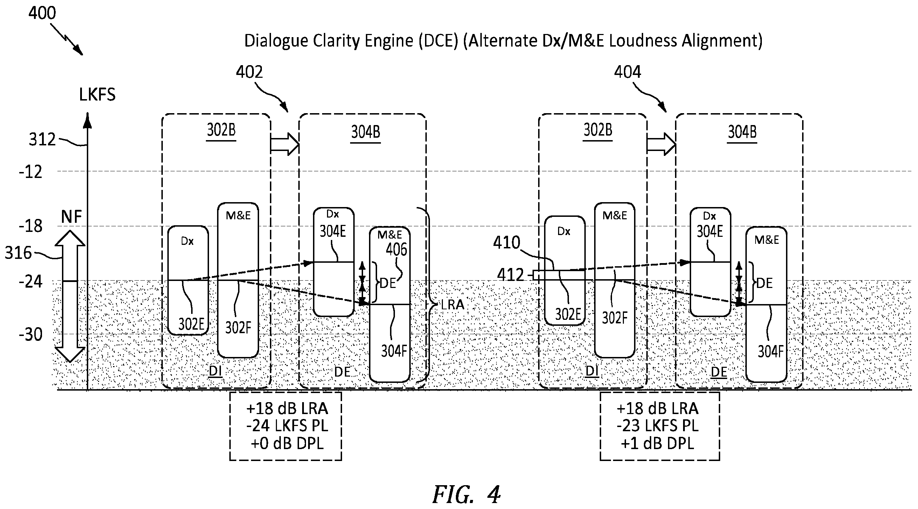

Referring to Fig. 4 and Fig. 7, a pair of LRA bar graphs 402, 404 is shown that illustrates a Dx IL offset similar to that discussed above. The graph 402 (on the left) shows a Dx and M&E in equal IL values (or DPL = 0 dB). In that case, the Gdx and Gmne would be the same value. The graph 404 shows a Dx and M&E where the Dx IL is higher than the M&E IL, giving a non-zero DPL, e.g., 1.0 dB. For example, if the Dx IL = 1.0 dB and the M&E IL = 0 dB, the DPL would be 0.5 dB (halfway between 0 (M&E IL) and 1 (Dx IL)). In that case, the DPL Adjust would reduce the dialogue gain Gdx (Fig. 7) to 3 dB (adjusted Gdx) and change the M&E attenuation Gmne (Fig. 7) to -3 dB (adjusted Gmne). After multiplying by the Dx Gain Factor and the M&E Gain Factor (each having a value of 0.5), this creates a Dx amplification of 1.5 dB and a M&E attenuation of -1.5 dB on lines 711,721. The resultant value for Dx would be 2.5 dB and the resultant value for M&E would be -1.5 dB, providing the desired separation of 4 LKFS (2.5 - (-1.5)). It also provides a resultant DPL of 0.5 (2.5 - 4/2), which retains the DPL value of 0.5 in this example. Accordingly, the DE logic 304A provides the desired dialogue (Dx) enhancement (e.g., 4 LKFS) over the non-dialogue (M&E), while keeping the dialogue to program (or to residual or M&E) loudness DPL unchanged (e.g., DPL = 0.5).

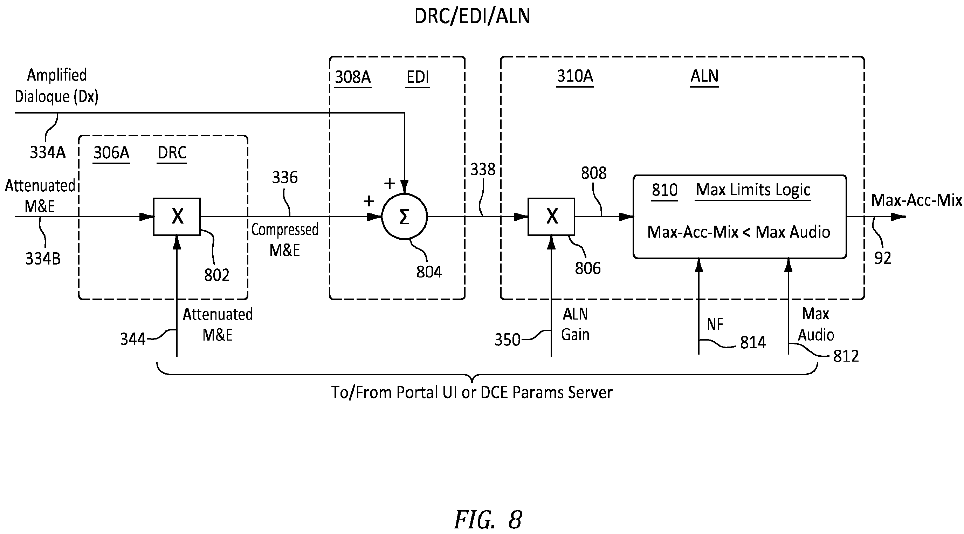

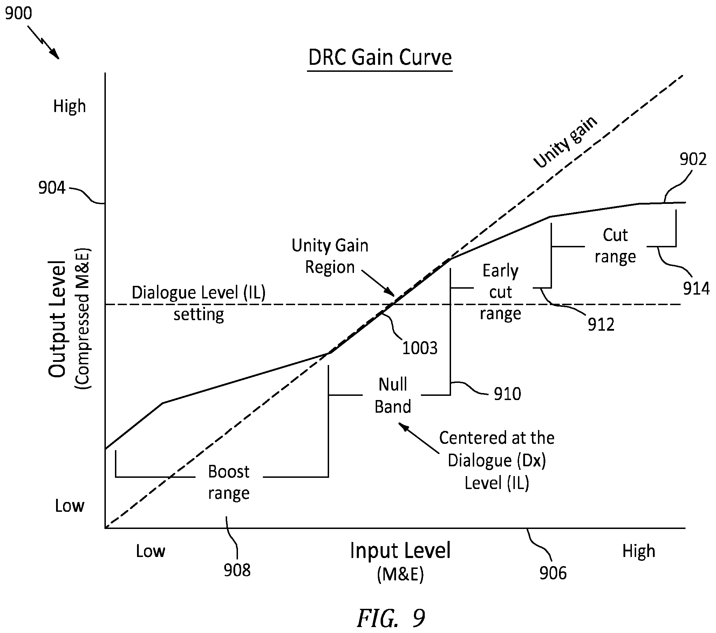

Referring to Fig. 3A, Fig. 8 and Fig. 9, the Dynamic Range Compression (DRC) Logic 306A receives the attenuated M&E audio track on a line 334B and a DCE gain profile on a line 344 and provides a compressed M&E audio track on a line 336. In particular, referring to Fig. 8 and Fig. 9, the DRC Logic 306A compresses the input M&E track by multiplying the input M&E audio track on a line 334B by the value of a DRC gain curve (or profile) on line 344, such as that shown in Fig. 9, by a multiplication block 802 (Fig. 8). Referring to Fig. 9, in particular, a known DRC gain curve 902 is shown plotted on a graph 900 of Output level (vertical axis) vs Input level (horizontal axis). The DRC gain curve 902 may have sections or ranges which provide the desired M&E loudness range ALR compression, including: a boost range 908, a null band or unity gain region 910, an early cut range 912 and a cut range 914. Other types of DRC gain curves and ranges may be use if desired. The boost range 908 increases (or amplifies) the low level (or quieter) audio M&E sounds with a gain greater than 1.0, the unity gain region preserves the audio M&E sounds with a gain of 1.0, and the early cut range 912 provides a slight attenuation of the audio M&E sounds and the cut range 914 provides a large attenuation of the audio M&E sounds with gains of less than 1.0. The early cut range 912 and the cut range 914 are set to provide the desired amount of M&E compression. In some embodiments, the amount of compression (and low-end boost) provided by the DRC Logic 306A may be adjusted by the CP user/admin by adjusting the DRC gain curve 902, which may be done via a CP user interface or Portal UI, discussed more hereinafter.

Referring to Fig. 3A and Fig. 8, the Enhanced Dialogue Insertion (EDI) Logic 308A receives the attenuated and compressed M&E audio track on a line 336 and the amplified dialogue Dx on the line 334A and provides a recombined (or remixed) composite audio track on a line 338. In particular, referring to Fig. 8, the EDI Logic 308A adds the input amplified Dx on the line 334A to the compressed M&E on the line 336 at the summation 804 to provide a recombined audio track on the line 338 with the enhanced (or amplified) dialogue Dx inserted into the compressed M&E audio track.

Referring to Fig. 3A and Fig. 8, the Audio Loudness Normalization (ALN) Logic 310A receives the recombined audio track on a line 338 and an ALN gain on the line 350 and provides the maximum accessibility mix (Max-Acc-Mix) track on the line 92. In particular, referring to Fig. 8, the ALN Logic 310A multiplies the input audio signal on the line 338 by the ALN gain on the line 350 at the multiplication gain block 806 to provide a Max-Acc-Mix on line 808 to Max Limits Logic 810, which ensures that the ALN gain does not cause the loudness range (LRA) of the Max-Acc-Mix exceed improper limits.

In particular, there are two equations that define the limits for the values of DCE gains (e.g., DE Gains, DRC Gains, ALN Gains) of the Dialogue Clarity Engine 62. In particular, below. Eq. 1 below defines the max value of the accessible mix Max-Acc-Mix:

$$Max(TruePeak(MaxAccMix)) < -2.0 \text{ dB} = Max \text{ Audio} \qquad \textbf{Eq. 1}$$

Where Max(TruePeak(MaxAccMix)) is the maximum value of the TruePeak value (in dB) of the Max-Acc-Mix track.

Also, if the noise floor (NF) is known, and Eq. 1 is satisfied, then the below Eq. 2 must also be satisfied to provide the best user listening experience:

$$Min(TruePeak(DX)) > NF \qquad \textbf{Eq. 2}$$

where Min(TruePeak(DX)) is the minimum value of TruePeak of the dialogue Dx portion of the mix and NF is the noise floor level. This may require that the DCE be adjusted based on the result of Eq. 2.

The Max Audio value to avoid audio clipping is 0 dB True Peak. Some content providers require the Max Audio value to be -2 dB to provide some additional buffer before clipping occurs. Also, typically the Max Audio value is set as a dB True Peak value or dBTP, which is the maximum peak audio level of the content, as is known. The Max Limits Logic 810 (Fig. 8) within the ALN Logic 310A will not allow the Max-Acc-Mix to exceed the requirements of Eq. 1.

In particular, the Max Limit Logic 810 receives the Max-Acc-Mix on line 808 and determines if the value for Max-Acc-Mix meets Eq.1 using the current noise floor NF setting from the CP user/admin 21 or from the DCE Params Server 38 and the Max Audio on line 812 from the DCE Params Server 38. If so, the Max-Acc-Mix is passed to the output on line 92 unmodified as the Max-Acc-Mix. Also, if NF is known and Eq. 1 is satisfied, then the DCE Params of the DCE may be adjusted as needed to cause Eq. 2 to be true.

If the value for Max-Acc-Mix does not meet Eq. 1, the Max-Acc-Mix will be reduced to a value that meets Eq. 1 and the modified version of Max-Acc-Mix is passed to the output on line 92 as the Max-Acc-Mix.

Thus, if the CP user/admin 21 attempts to set the ALN Gain or the DE Gain or Noise Floor (NF) (or any other gain or factor in the DCE) such that it causes the Max-Acc-Mix to exceed the requirements of Eq. 1 for a given content provider, the Max Limits Logic 810 will clamp the ALN gain to a value that allows Max-Acc-Mix to satisfy Eq. 1. The Max Audio value may be an input to the Max Limit Logic 810 provided on a line 812 from the DCE Params Server 38 and may be preset by the content provider to a value that meets the content provider's audio requirements, e.g., -2 dbTP. Other values may be used if desired.

In some embodiments, the CP user/admin 21 may set the ALN Gain from the UI (discussed hereinafter). In some embodiments, the system may automatically calculate the ALN Gain using Eq. 1 to maximize the LRA of the Max-Acc-Mix, based on the DE Gain or Noise Floor that have been set by the CP user/admin 21.

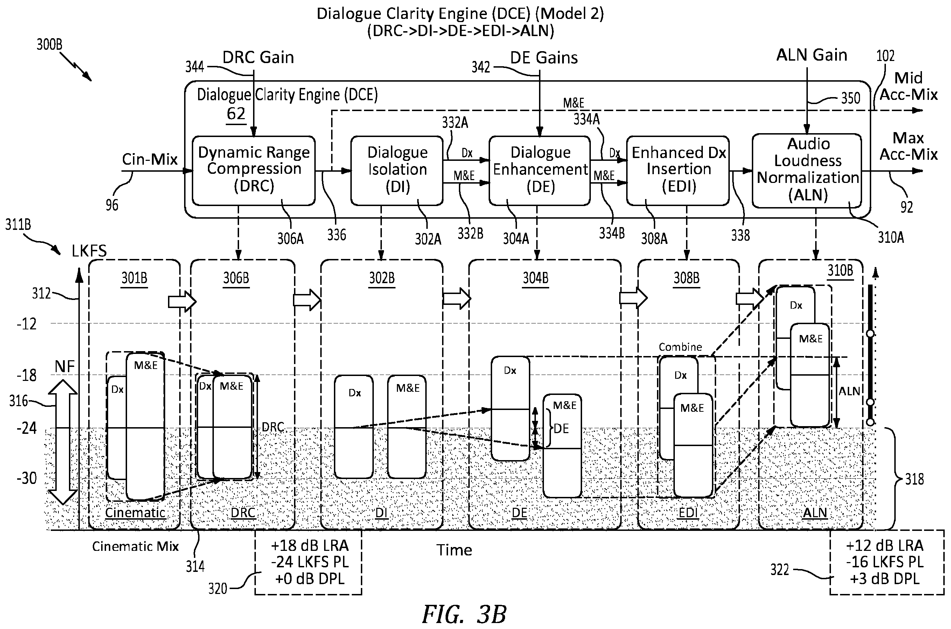

Referring to Fig. 3B, a second DCE model 300B (DCE Model 2) configuration is shown having an order of components from left to right being DRC-DI-DE-EDI-ALN, 306A,302A,304A,308A,310A, and showing corresponding loudness range (LRA) bar graphs 306B,302B,304B,308B,310B, respectively, that show the effect of each component on an input cinematic mix (Cin-Mix) LRA bar graph 301B, discussed more hereinafter. As discussed hereinabove, the LRA bar graphs 306B,302B,304B,308B,310B are plotted on a graph 311B having a vertical axis 312 of loudness measured in LKFS, and a horizontal time axis (or chronology). The vertical axis 312 also shows a noise floor (NF) range 316, and a noise floor setting region 318 used by the DCE to determine the desired Max-Acc-Mix, similar to that of Fig. 3A.

The DCE 62 processing of Figs. 3A-3E may be performed on the entire audio file or may be applied to shorter size/duration audio chunks of the audio content and may be performed on the chunks simultaneously (in parallel) or sequentially (one after the other). Also, the DCE params may be different for every chunk if necessary or desired.

In the DCE Model 2 of Fig. 3B, the input Cin-Mix is processed first by the Dynamic Range Compression (DRC) Logic 306A which receives the Cin-Mix audio track on the line 92 and a DCE gain profile on the line 344 and provides a compressed Cin-Mix audio track on a line 336. The DRC 306A functions similar to that described hereinbefore with Fig. 3A. In particular, referring to Fig. 8 and Fig. 9, the DRC Logic 306A compresses the input Cin-Mix audio track by multiplying the input Cin-Mix audio track on the line 96 by the value of a DRC gain curve (or profile) on line 344, such as that shown in Fig. 9, by a multiplication block 802 (Fig. 8). Referring to Fig. 9, in particular, a known DRC gain curve 902 is shown plotted on a graph 900 of Output level (vertical axis) vs Input level (horizontal axis). The difference from Model 1 300A in Fig. 3A is that the entire mix is compressed, instead of just the M&E.

The compressed Cin-Mix on the line 336 is provided to the Dialogue Isolation (DI) logic 302A, which separates the audio dialogue (Dx) from the non-dialogue (or M&E) portions of the audio, as discussed above with Fig. 3A, and provides two audio tracks, the Dx track on line 332A and the M&E track on line 332B.

The Dx and M&E audio tracks on the lines 332A,332B are provided to the Dialogue Enhancement (DE) logic 304A, which receives DE Gains on the line 342 and amplifies the Dx track and attenuates the M&E track while keeping the average or integrated loudness the same, similar to that discussed with Fig. 3A above.

The Dx and M&E audio tracks on the lines 334A,334B from the Dialogue Enhancement (DE) logic 304A are provided to the Enhanced Dialogue Insertion (EDI) Logic 308A which receives the attenuated and compressed M&E audio track on a line 334B and the amplified dialogue Dx on the line 334A and provides a recombined (or remixed) composite audio track (similar to that discussed with Fig. 3A above) on the line 338 to the Audio Loudness Normalization (ALN) Logic 310A.

The Audio Loudness Normalization (ALN) Logic 310A receives the recombined audio track on the line 338 and an ALN gain on the line 350 and provides the maximum accessibility mix (Max-Acc-Mix) track on the line 92, similar to that discussed with Fig. 3A above.

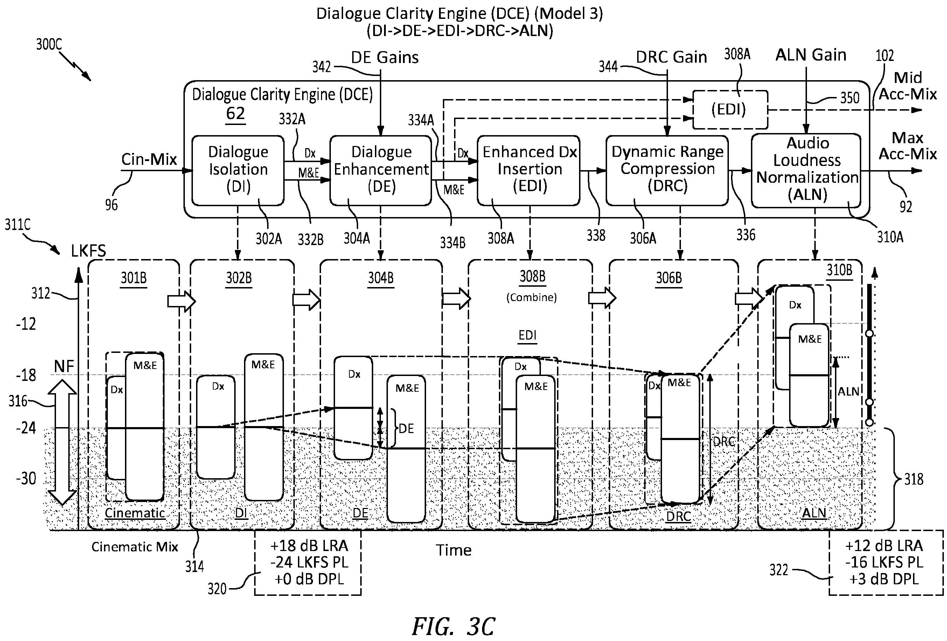

Referring to Fig. 3C, a third DCE model 300C (DCE Model 3) configuration is shown having an order of components from left to right being DI-DE-EDI-DRC-ALN, 302A,304A,308A,306A,310A, and showing corresponding loudness range (LRA) bar graphs 302B,304B,308B,306B,310B, respectively, that show the effect of each component on an input cinematic mix (Cin-Mix) LRA bar graph 301B, discussed more hereinafter. As discussed hereinabove, the LRA bar graphs 302B,304B,308B, 306B,310B are plotted on a graph 311C having a vertical axis 312 of loudness measured in LKFS and a horizontal time axis (or chronology). The vertical axis 312 also shows a noise floor (NF) range 316, and a noise floor setting region 318 used by the DCE to determine the desired Max-Acc-Mix, similar to that of Fig. 3A.

In the DCE Model 3 of Fig. 3C, the input Cin-Mix is processed first by the Dialogue Isolation (DI) logic 302A, which separates the audio dialogue (Dx) from the non-dialogue (or M&E) portions of the audio, as discussed above with Fig. 3A, and provides two audio tracks, the Dx track on line 332A and the M&E track on line 332B, similar to that of Fig. 3A.

The Dx and M&E audio tracks on the lines 332A,332B are provided to the Dialogue Enhancement (DE) logic 304A, which receives DE Gains on the line 342 and amplifies the Dx track and attenuates the M&E track while keeping the average or integrated loudness the same, similar to that discussed with Fig. 3A above.

The Dx and M&E audio tracks on the lines 334A,334B from the Dialogue Enhancement (DE) logic 304A are provided to the Enhanced Dialogue Insertion (EDI) Logic 308A which receives the attenuated and compressed M&E audio track on a line 334B and the amplified dialogue Dx on the line 334A and provides a recombined (or remixed) composite audio track (similar to that discussed with Fig. 3A above) on the line 338 to the Dynamic Range Compression (DRC) Logic 306A.

The Dynamic Range Compression (DRC) Logic 306A receives the recombined (or remixed) composite audio track on the line 338 and the DCE gain profile on the line 344 and provides a compressed Cin-Mix audio track on a line 336 to the Audio Loudness Normalization (ALN) Logic 310A.

The Audio Loudness Normalization (ALN) Logic 310A receives the recombined audio track on the line 338 and an ALN gain on the line 350 and provides the maximum accessibility mix (Max-Acc-Mix) track on the line 92, similar to that discussed with Fig. 3A above.

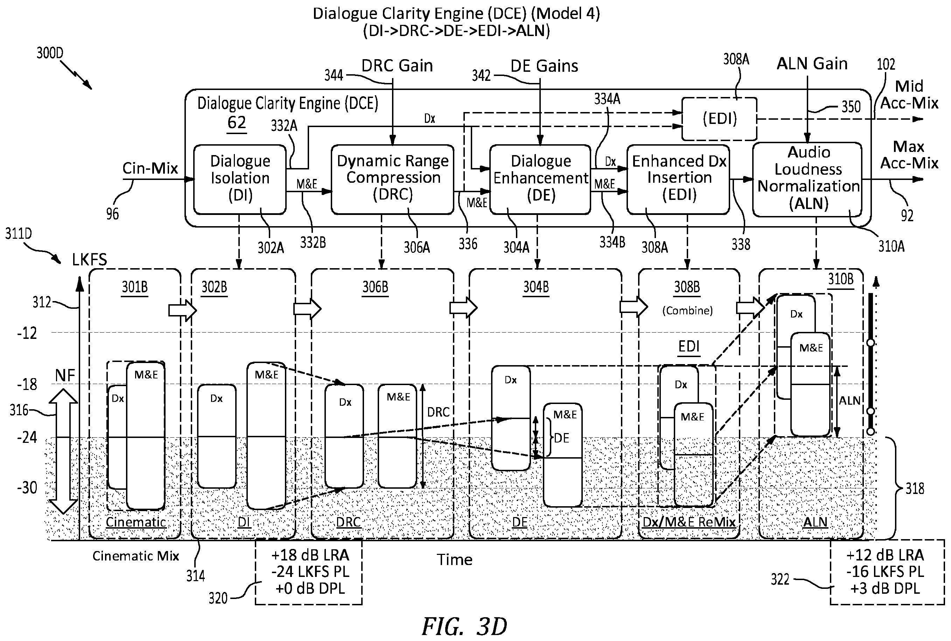

Referring to Fig. 3D, a fourth DCE model 300D (DCE Model 4) configuration is shown having an order of components from left to right being DI-DRC-DE- EDI-ALN, 302A,306A,304A,308A,310A, and showing corresponding loudness range (LRA) bar graphs 302B,306B,304B,308B,310B, respectively, that show the effect of each component on an input cinematic mix (Cin-Mix) LRA bar graph 301D, discussed more hereinafter. As discussed hereinabove, the LRA bar graphs 302B,306B,304B,308B,310B are plotted on a graph 311D having a vertical axis 312 of loudness measured in LKFS and a horizontal time axis (or chronology). The vertical axis 312 also shows a noise floor (NF) range 316, and a noise floor setting region 318 used by the DCE to determine the desired Max-Acc-Mix, similar to that of Fig. 3A. In the DCE Model 4 of Fig. 3D, the configuration of components or logic is similar to that of Fig. 3A, except that the position of DE Logic 304A and DRC Logic 306A are swapped.

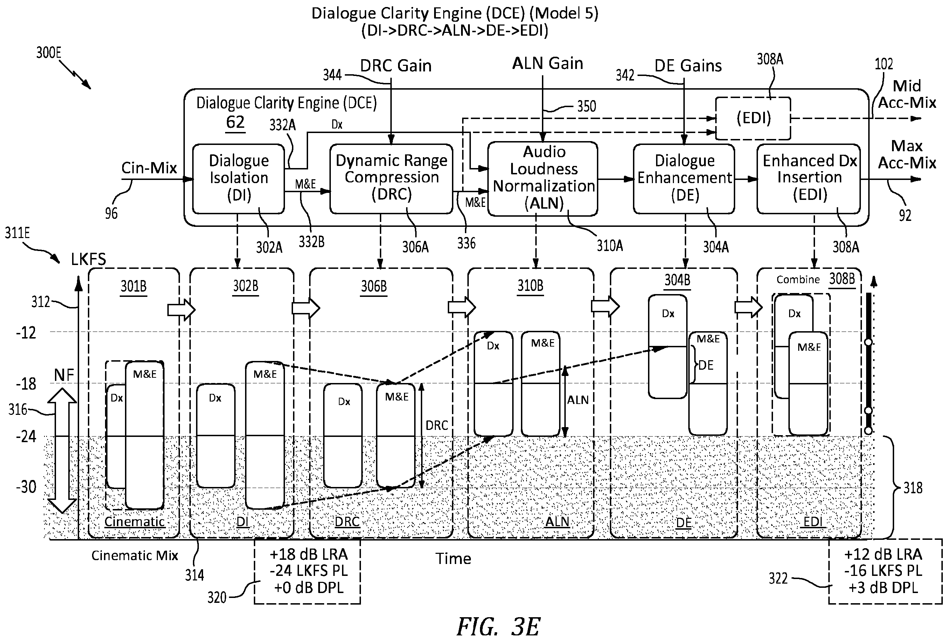

Referring to Fig. 3E, a fifth DCE model 300E (DCE Model 5) configuration is shown having an order of components from left to right being DI-DRC-ALN-DE-EDI, 302A,306A,310A,304A,308A, , and showing corresponding loudness range (LRA) bar graphs 302B,306B,310B,304B,308B, respectively, that show the effect of each component on an input cinematic mix (Cin-Mix) LRA bar graph 301E, discussed more hereinafter. As discussed hereinabove, the LRA bar graphs 302B,306B,310B, 304B,308B, are plotted on a graph 311E having a vertical axis 312 of loudness measured in LKFS and a horizontal time axis (or chronology). The vertical axis 312 also shows a noise floor (NF) range 316, and a noise floor setting region 318 used by the DCE to determine the desired Max-Acc-Mix, similar to that of Fig. 3A. In the DCE Model 5 of Fig. 3E, the configuration of components or logic is similar to that of Fig. 3D, except that the position of ALN Logic 310A is located after DRC Logic 306A.

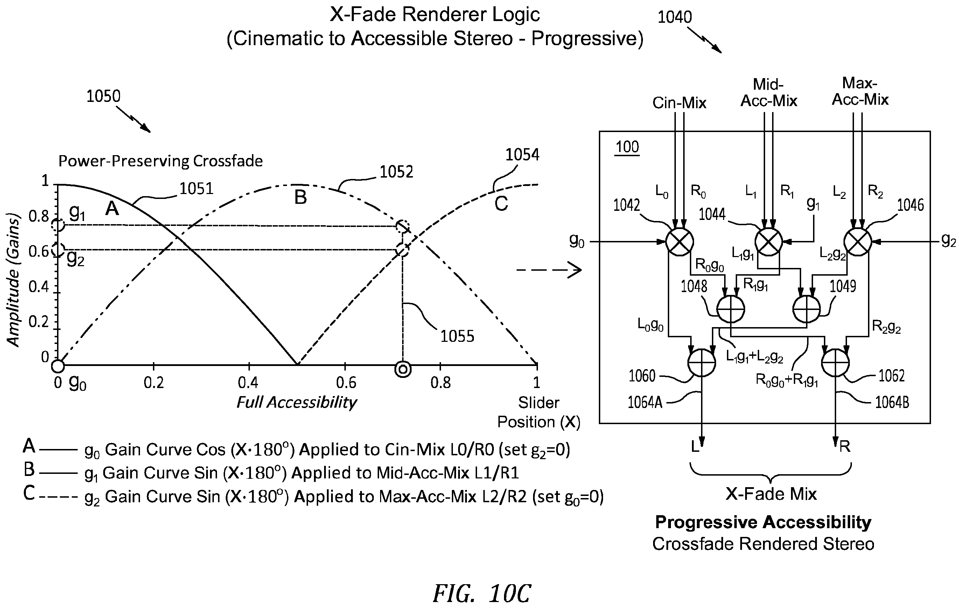

Referring to Figs. 3A-3E, in some embodiments, the DCE 62 may also provide a second output Mid-Acc-Mix on a line 93, which is an audio track tapped off of a predetermined position in the DCE 62. The Mid-Acc-Mix is tapped off after the Dialogue Enhancement Logic (DE) 304A and before the Dynamic Range Compression (DRC) Logic 306A or after the Dynamic Range Compression (DRC) Logic 306A and before the Dialogue Enhancement (DE) Logic 304A, depending on the DCE model, as shown in Figs. 3A-3E, which allows for the use of a 3-input X-Fade renderer as discussed herein and shown in Fig. 10C. For some of the DCE models, e.g., DCE Model 1, Model 3, Model 4, and Model 5, the location of the tap-off requires the audio track to be recombined into a single track. In that case, there is an additional EDI Logic block 308A shown as a dashed box which performs the combination to create the Mid-Acc-Mix on the line 102.

Referring back to Fig. 1, the output of the DCE Logic 62 is the Max-Acc-Mix track, which is provided on line 92 to the Audio Encoder 26, it may also be stored on the Non-Encoded Content Server 36. The other input to the Encoder 26 is the original Cin-Mix audio track on a line 96. In some embodiments, the DCE may also provide a second output Mid-Acc-Mix on a line 93, as discussed herein above with Fig. 1, which is an audio track tapped off of a predetermined position in the DCE.

In general, the input for the Audio Encoder 26 is an audio source waveform(s) (e.g., PCM/WAV audio uncompressed format), with the resulting output being an audio bitstream (or bs), e.g., digitally compressed audio tracks, encoded using MPEG-4 AAC (Advanced Audio Coding) developed by MPEG Audio, or Dolby AC3/EC3. Other coding standards or codecs may be used for encoding if desired. Use of bitstream (bs) allows for the transmission of complex surround sound formats like Dolby Atmos or DTS:X. The Audio Encoder 26 uses known software running on streaming service-owned/provisioned hardware, such as the CP computer 20. Certain AAC encoding and decoding technology is available for licensing from a known AAC patent pool.

As discussed herein above, the output of the Encoder 26 is an encoded and interleaved audio stream such as that shown in Figs. 5A, 5B, 5C, which is stored on the Encoded Content Server 40, via the Content API 30 shown by lines 94, 95.

Referring again to Fig. 1 and Fig. 12A, the Portal UI Logic 60 also provides a UI to allow the CP user/admin 21 to adjust the X-Fade by the via the display 22 and receives a X-Fade Adjust selection from the CP user/admin 21 via user interaction with the display 22 (or other input device connected to the CP computer such as a keyboard, mouse or other device). The UI for X-Fade control and monitoring and selection on the display 22 may be as shown in Fig. 12A, discussed more hereinafter.

As discussed herein, the Portal UI Logic 60 may have X-Fade Logic 100 (or a cross-fade renderer logic) which provides a power-preserving blend of the Cin-Mix and the current value of the Max-Acc-Mix. In particular, the X-Fade Logic 100 (Fig. 1) provided a Portal UI which has a X-Fade slider 1210 (Fig. 12A) that allows the user to adjust the X-Fade slider which provides a cross-fade rendering or blending or mixing of the Cin-Mix and the Max-Acc-Mix from the DCE Logic 62, to provide a resulting blend of the two input signals using power-preserving gain curves, based on the position of an X-Fade slider 1210 (Fig. 12A), which provides a X-Fade Adjustment or X-Fade Adj on a line 80 to the X-Fade Logic 100.

The power preserving equation used by the X-Fade Logic 100 is shown below as Eq. 3:

$$\text{Sin}^2(\theta) + \text{Cos}^2(\theta) = 1 \qquad \textbf{Eq. 3}$$

Where the value of $\theta$ (in degrees) ranges from 0 to 90 degrees or 0 to 180 degrees (depending on the configuration) and corresponds to a position X of a X-Fade slider (0 deg representing the low slider limit X=0, and 90 deg representing the high slider limit X=1.0). The power preserving nature of Eq. 3 allows the system of the present disclosure to provide loudness changes such that stereo/spatial image is not affected, especially for stereo, surround, or immersive sound or audio applications. As the audio signals are processed using the audio signal amplitudes, the sin and cos functions, respectively, may be used as coefficients (or multiplicative attenuating gains with values < or = 1.0) on the cross-fade input audio signals to produce a power preserving cross-fade result.

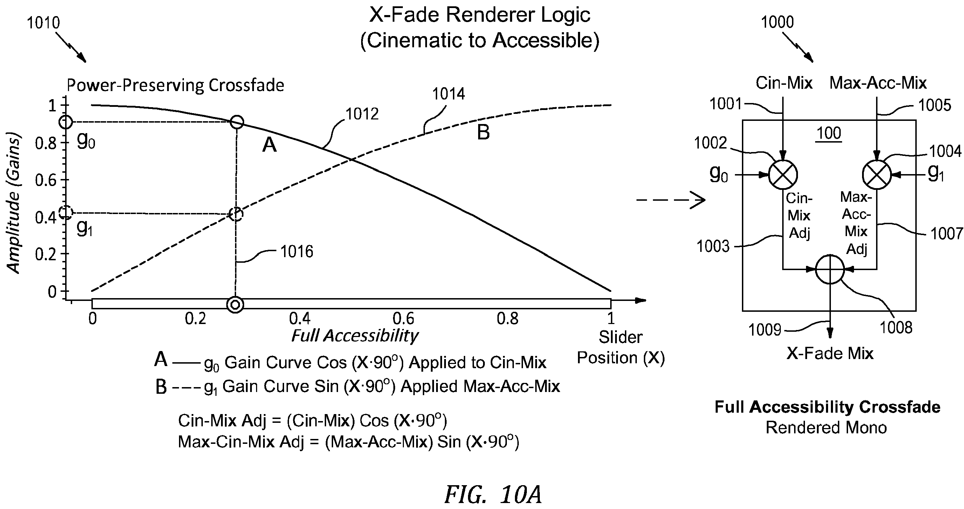

Referring to Fig. 10A, the X-Fade Logic 100 is shown by a block diagram 1000 and a corresponding graph 1010. The X-Fade logic 100 has two inputs Cin-Mix and Max-Acc-Mix on lines 1001, 1005, that are each adjusted by a gain g0 and g1, respectively, which are defined by a cosine gain curve 1012 (or curve A) and a sine gain curve 1014 (or curve B), respectively, and provides an output X-Fade mix audio signal on line 1009. In particular, the X-Fade Logic 100 receives the Cin-Mix signal on line 1001 which is fed to a multiplication gain block 1002, which is multiplied by a gain g0, shown below as Eq. 4. The result of the gain block 1002 is the adjusted Cin-Mix value (Cin-Mix Adj) provided on a line 1003 to a summation block 1008. The X-Fade Logic 100 also receives the Max-Acc-Mix signal on line 1005 which is fed to a multiplication gain block 1004, which is multiplied by the gain g1, shown below in Eq. 5. The result of the gain block 1004 is the adjusted Max-Acc-Mix value (Max-Acc-Mix Adj) provided on a line 1007 to the summation block 1008. The summation block 1008 sums the values of Cin-Mix Adj and Max-Acc-Mix Adj on the lines 1003, 1007 and provides the result of the sum on a line 1009 as the X-Fade Mix. Also, the graph 1010 shows the Cos curve 1014, which determines the value of the gain g0, and the Sin curve 1016, which determines the value of the gain g1. Also, a vertical line 1016 shows the X value (X=0 to 1.0) based on slider position and the location where the value of X intersects the curves 1012 and 1014 determines the values for the gains g0 and g1. Below are Eq. 4 and Eq. 5 which determine the values of Cin-Mix Adj and Max-Acc-Mix Adj.

$$\text{Cin-Mix Adj} = (\text{Cin-Mix})^*\text{Cos}(X^*90) = (\text{Cin-Mix})^*g0 \qquad \textbf{Eq. 4}$$

$$\text{Max-Acc-Mix Adj} = (\text{Max-Acc-Mix})^*\text{Sin}(X^*90) = (\text{Max-Acc-Mix})^*g1 \qquad \textbf{Eq. 5}$$

where the value of X ranges from 0 to 1.0 based on the location percentage of the X-Fade slider, e.g., X=0 when slider is at low end (minimum) end of the slider range and X=1.0 when slider is at high (max) end of the slider range.

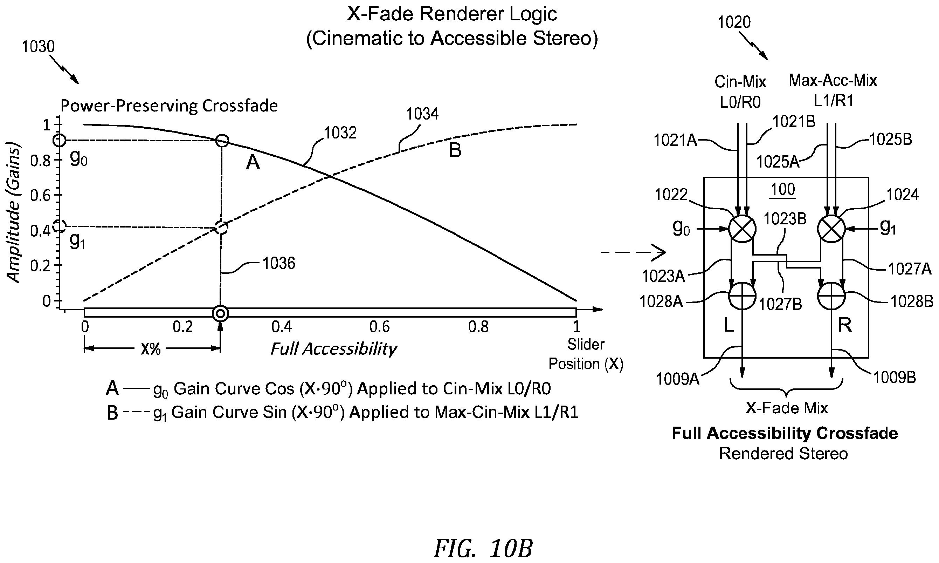

Referring to Fig. 10B, the X-Fade Logic 100 is shown for stereo audio content (having Left/Right channels indicated by L/R, respectively) by a block diagram 1020 and a corresponding graph 1030having a sine function curve 1034 (curve B) and a cosine function curve 1032 (curve A), similar to that shown in Fig. 10A. In particular, the X-Fade Logic 100 receives the Cin-Mix stereo signal on lines 1021A,1021B for left, right (L0/R0) channels respectively, which are fed to a multiplication gain block 1022, where both Cin-Mix L0 and Cin-Mix R0 are multiplied by a gain g0, determined by the sine function curve 1034 (B), such that when the X-Fade position X is at the low end (X=0), the gain g0=1 (cos(0*90) = 1), and Cin-Mix L0 and Cin-Mix R0 pass through the multiplier (or gain) 1022 without any attenuation (gain=1), and when the X-Fade position X is at the high end (X=1.0), the gain g0=0 (cos(1*90) = 0), and Cin-Mix L0=0 and Cin-Mix R0=0 full attenuation (gain=0). The gain block 1022 provides an adjusted Cin-Mix on lines 1023A, 1023B for the left, right (L/R) channels, respectively.

Similarly, the X-Fade Logic 100 receives the Max-Acc-Mix stereo signal on lines 1025A,1025B for left, right (L1/R1) channels respectively, which are fed to a multiplication gain block 1024, where each of Max-Acc-Mix L1 and Max-Acc-Mix R1 is multiplied by a gain g1, determined by the sine function curve 1034 (B), such that when the X-Fade position X is at the low end (X=0), the gain g1=0 (sin(0*90) = 0) and Max-Acc-Mix L1=0 and Max-Acc-Mix R1=0, i.e., full attenuation (gain=0) and when the X-Fade position X is at the high end (X=1.0), the gain g0=1 (sin(1*90) = 1), and Cin-Mix L0 and Cin-Mix R0 pass through the multiplier (or gain) 1024 without any attenuation (gain=1). The gain block 1024 provides an adjusted Max-Acc-Mix on lines 1023A, 1023B for the left,right (L/R) channels, respectively.

The adjusted Cin-Mix L0 on line 1023A and the adjusted Max-Cin-Mix L1 on the line 1027B are provided to a summation block 1028A, and the output is provided as a combined left channel adjusted signal or X-Fade mix L (Left Channel) on a line 1009A. Similarly, the adjusted Cin-Mix R0 on the line 1023B and the adjusted Max-Cin-Mix R1 on the line 1027A are provided to a summation block 1028B, and the summation output is provided as a combined right channel adjusted signal or X-Fade mix R (right channel) on a line 1009B.

Referring to Fig. 10C, the X-Fade Logic 100 is shown for input stereo audio content (having Left/Right channels indicated by L/R, respectively) by a block diagram 1040 for a three-input cross-fade renderer (or X-Fade) and a corresponding graph 1050, having three gain curves 1051 (or curve A), 1052 (or curve B), 1054 (or curve C). In particular, in some embodiments, the DCE 62 (Fig. 1) may provide an additional output Mid-Acc-Mix, shown by a dashed line 93 (Fig. 1). In that case, the X-Fade Logic 100 has three inputs (or three pairs of inputs for stereo audio): Cin-Mix L0/R0, Mid-Acc-Mix L1/R1, and Max-Acc-Mix L2/R2, that are adjusted or multiplied by three gains g0, g1, g2, respectively, having gain values defined by the three gain curves 1051 (or curve A), 1052 (or curve B), 1054 (or curve C), respectively. In particular, the equations for the output Left (L) channel and output right (R) channel on lines 1064A,1064B, respectively, are shown below:

$$\text{X-Fade (L)} = L0g0 + L1g1 + L2g2 \qquad\qquad \text{Eq. 6}$$

$$\text{X-Fade (R)} = R0g0 + R1g1 + R2g2 \qquad\qquad \text{Eq. 7}$$

Where the values for g0, g1, g2 are defined by the three gain curves (sine or cosine curves) 1051, 1052, 1054, respectively, and g0, g1, g2 vary or change based on the X-Fade slider position X, as described hereinafter, where gain curve 1051 is a cosine curve from X=0 to 0.5 (used for first half of slider range between Cin-Mix and Mid-Acc-Mix for g0 values), gain curve 1052 (for gain g1 values) is a sin curve from X=0 to 1.0 (used for the full range of slider range from Cin-Mix to Mid-Acc-Mix to Max-Acc-Mix for g1 values), and gain curve 1054 (for gain g2 values) is a sine curve from X=0.5 to 1.0 (used for second half of slider range between Mid-Acc-Mix to Max-Acc-Mix for g2 values). Also, in some embodiments, the gain curve 1052 (for gain g1 values) may also be viewed as a sine curve from X=0 to 0.5 and a cosine curve from X=0.5 to 1.

In particular, the three-input X-Fade logic 100 receives the Cin-Mix L0/R0 (left and right channels, referred to herein as L0,R0 respectively), which is provided to a multiplication (or gain) block 1042, which also receives the gain g0, and computes values for L0*g0 (or L0g0) and R0*g0 (or R0g0), which are adjusted (or attenuated) values for Cin-Mix L0/R0 left and right channels. L0g0 is fed to a summation block 1060 which also receives values for (L1g1 + L2g2) from a summation bock 1049, discussed hereinafter. The result of the summation 1060 provides the value of the X-Fade mix (L or left channel) from Eq. 6 above on a line 1064A. Also, the value of R0g0 from gain block 1042 is provided to summation block 1048, discussed below.

In addition, the three-input X-Fade logic 100 receives the Mid-Acc-Mix L1/R1 (left and right channels, referred to herein as L1,R1 respectively), which is provided to a gain multiplication block 1044, which also receives the gain g1, which calculates values for L1*g1 (or L1g1) and R1*g1 (or R1g1), which are adjusted (or attenuated) values for Mid-Acc-Mix L1/R1 left and right channels. R1g1 is provided to a summation block 1048 together with R0g0 (from the multiplication block 1042), and the result of the summation 1048 (R1g0 + R1g1) is provided to a summation block 1062, which adds the values R0g0 + R1g1 (from the summation block 1048) to R2g2 (from block 1046), to provide the value of the X-Fade mix (R or right channel) from Eq. 7 above on a line 1064B. L1g1 is provided to a summation block 1049 together with L2g2 from a gain block 1046, discussed more hereafter, and the result of the summation 1049 (L1g1 + L2g2) is provided to the summation block 1060, discussed herein above.

In addition, the three-input X-Fade logic 100 receives the Max-Acc-Mix L2/R2 (left and right channels, referred to herein as L2,R2 respectively), which is provided to a gain multiplication block 1046, which also receives the gain g2, which provides values for L2*g2 (or L2g2) and R2*g2 (or R2g2), which are adjusted (or attenuated) values for Max-Acc-Mix L2/R2 left and right channels. L2g2 is fed to the summation block 1049 together with L1g1, and the result of the summation 1049 (L1g1 + L2g2) is provided to the summation block 1060, to provide the value of the X-Fade mix (L) from Eq. 6 on a line 1064A.

Regarding the gain curves, the following Eqtns 8, 9, and 10 may be used to determine the gain values for gains g0, g1, g2, e.g., Cin-Mix Adj (L0g0, R0g0), Mid-Acc-Mix adj (L1g1, R1g1), Max-Acc-Mix adj (L2g2, R2g2), for left and right channels (for a stereo application).

$$g0= Cos(X*180) \text{ for: } (X=0 \text{ to } 0.5; \text{ if } X>0.5, \text{ set } g2=0) \quad \textbf{Eq. 8}$$

$$g1 = Sin(X*180) \text{ for: } (X=0 \text{ to } 1.0) \quad \textbf{Eq. 9}$$

$$g2 = Sin(X*90) \text{ for: } (X=0.5 \text{ to } 1.0; \text{ if } X<0.5, \text{ set } g0=0) \quad \textbf{Eq. 10}$$

where the value of X ranges from 0 to 1.0 based on the location percentage of the X-Fade slider, e.g., X=0 when slider is at low end (minimum) end of the slider range and X=1.0 when slider is at high (max) end of the slider range, as discussed herein. Also, g0 is set to 0 when in the second half and g2 is set to 0 when in the first half of the slider range.

In particular, for the first half of the X-Fade slider range (X = 0 to 0.5), the X-Fade Logic 100 performs a cross-fade rendering or blending of the Cin-Mix and Mid-Acc-Mix (e.g., from 0 to 90 deg of the sin and cos curves), providing values for gains g0 and g1, and the value of g2 is set to 0 as it is not relevant for the first half of the slider range.. The second half of the X-Fade slider range (X = 0.5 to 1.0) the X-Fade Logic 100 performs a cross-fade rendering or blending of the Mid-Acc-Mix and Max-Acc-Mix (e.g., from 90 to 180 deg of the sin and cos curves), providing values for gains g1 and g2, and the value of g0 is set to 0. as it is not relevant for the first half of the slider range. The result is a X-Fade slider which ranges from X=0 to 1.0 and provides a progressive blending of Cin-Mix to Mid-Acc-Mix and then Mid-Acc-Mix to Max-Acc-Mix. For each section, the two input signals use preserving gain curves, based on the position of a X-Fade Slider (or X-Fade Adjustment or X-Fade Adj), as discussed herein.

Also, the graph 1050 shows a Cos curve 1051, which determines the value of g0, and a Sin curve 1052, which determines the value of g1 and a Sin curve 1054, which determines the value of g2. Also, a vertical line 1055 shows the X value based on slider position and where it intersects the curves 1052 and 1054 determines the values for g1 and g2, respectively. In particular, the graph 1051 (Cos function) determines the value for g0, graph 1052 (Sin function) determines the value for g1 from 0-90 and from 90-180, and graph 1054 (Cos function) determines the value for g2 from 90-180, as also shown by Eq. 8, 9, and 10. Also, the value of g2 may be set to 0 for the first half of the slider range (X=0 to 0.5) and the value of g0 may be set to 0 for the second half of the slider range (X=0.5 to 1.0), as discussed herein.

The Portal UI Logic 60 provides the X-Fade UI on the line 84 and a Content UI on a line 82 to the Display 22, which allows the CP user/admin 21 to select the content which is provided to the Portal UI Logic 60 on a line 78, and receives a X-Fade slider input from the CP user/admin 21 on line 80 (X-Fade Adj) which indicates the current position of the X-fade renderer. The output of the X-Fade logic 100 is a X-Fade mix audio signal or track, provided on a line 86 to speaker(s) 23 of the CP computer 20, which allows the CP User/Admin 21 to listen to the resulting accessible mix (e.g., Max-Acc-Mix), as shown by a line 76. The Portal UI Logic 60 may also request and receive a content list (or index) on a line 99 which lists the audio content or audio files available on the Non-Encoded Content Server 36 for review and selection by the CP user/admin 21.

Referring to Figs. 2A, 2B, 2C, and 2D, several top-level block diagrams 200A,200B, 200C, 200D, respectively, are shown for different configurations or applications of a user/listener side of a system for the present disclosure. In particular, Fig. 2A is a block diagram 200A showing a Smart TV as a smart playing device 12 as the main interface with the user via the TV display 14 and speakers 11. In that case, the X-Fade feature and Personalized EQ feature are controlled by the user/listener 15 using a Smart TV Remote Control (or Remote) 220 or using a user device 12, such as a smart phone. In either case, the user 15 can control the X-Fade and various other Acc App features or parameters by viewing the Smart TV display 14. The details of Fig. 2A are discussed more hereinafter. Fig. 2B is a block diagram 200B showing a single smart playing device used by a single user, e.g., smart phone, table, laptop, and the like, which can operate in two modes: stand-alone mode (or single device mode) or in Hub receiver (or slave) mode, where the device is slave to a Smart TV operating in a Hub Mode. In the standalone mode, the device 12 receives content and interacts with the user similar to the Smart TV described hereinabove, except there is no remote control. In the Hub receiver (or slave) mode, the device 12 receives and provides commands on the lines 231B as well as receives the C-Mix Video on the line 217, all from a Smart TV operating in Hub Mode. The remainder of the features are the same as described in Fig. 2A. In some embodiments, the Acc App may be referred to as the Hub Acc App, when configured in a hub mode configuration or mode of operation.

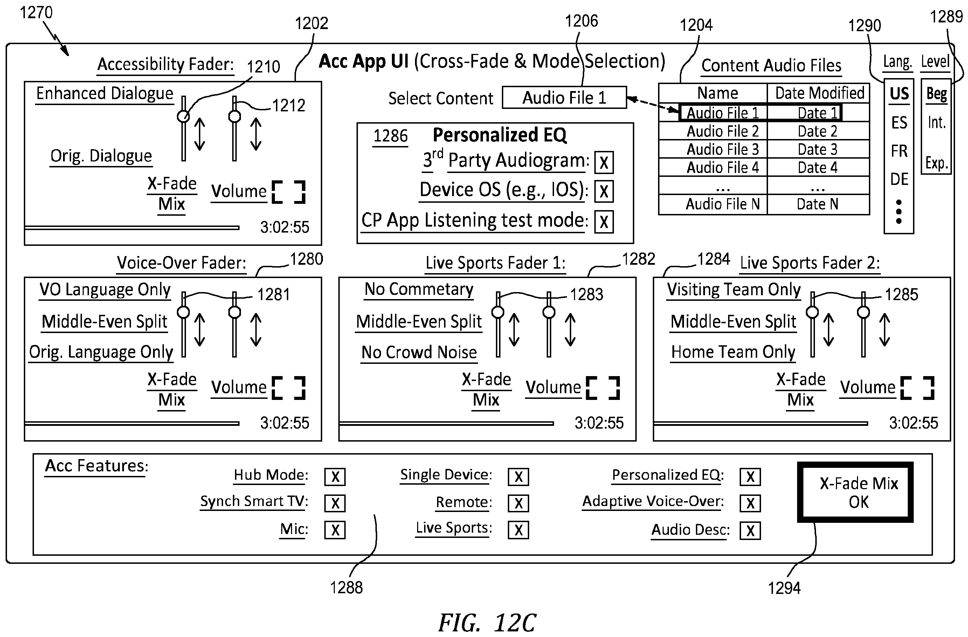

Fig. 2C is a block diagram 200C showing a Smart TV 12 configured to act in Hub Mode, which allows for multiple user devices 12, e.g., User Device 1 to User Device N. In this mode, each user/listener 15 may use their own device 12 to watch and listen to the content being played on the Smart TV 12. In that case, each of the user devices 1-N receives the UI (including X-Fade UI and Pers. EQ UI) and is able to view and listen to the selected content from the Smart TV, via lines 231A and 233A. This permits people in the same room watching the same show on a Smart TV to have a personalized audio experience. For example, each user/listener 1-N has their own X-Fade slider that they can set to their own personal setting. This also applies to the Pers. EQ feature for each user/listener. Fig 2D is similar to Fig. 2C, showing a block diagram 200D having a Smart TV 12 configured to act in Hub Mode, except that in this case there are multiple decoders 202 which allow the multiple users/listeners to watch the same show as the others in the room, but also can select the form of video and language, e.g., language, voice-over, narration, and the like, for the same show (see Fig. 12C for the UI, discussed hereinafter). For example, in that case, user/listener1 may be listening to the show in English, user/listener 2 may be listening to the show in French, user/listener 3 may be listening to Spanish voiceover, user/listener 4 may be listening to the same show with narration, and the like. Thus, each user/listener 15 may use their own device 12 to watch and listen to the same show, but from different streams due to the type of content being played, as illustrated in Figs 5A-5D, which show how the data is stored and encoded and interleaved. In this case, each of the user devices 1-N receives the UI (including X-Fade UI, Pers EQ UI, and Content UI) and is able to view and listen to the selected content. The user/listener can also choose to synch up with the other listeners or not based on a selectable Synch (or Smart TV Synch) button on the Acc App UI 1270 (Fig. 12C) (discussed more hereinafter).

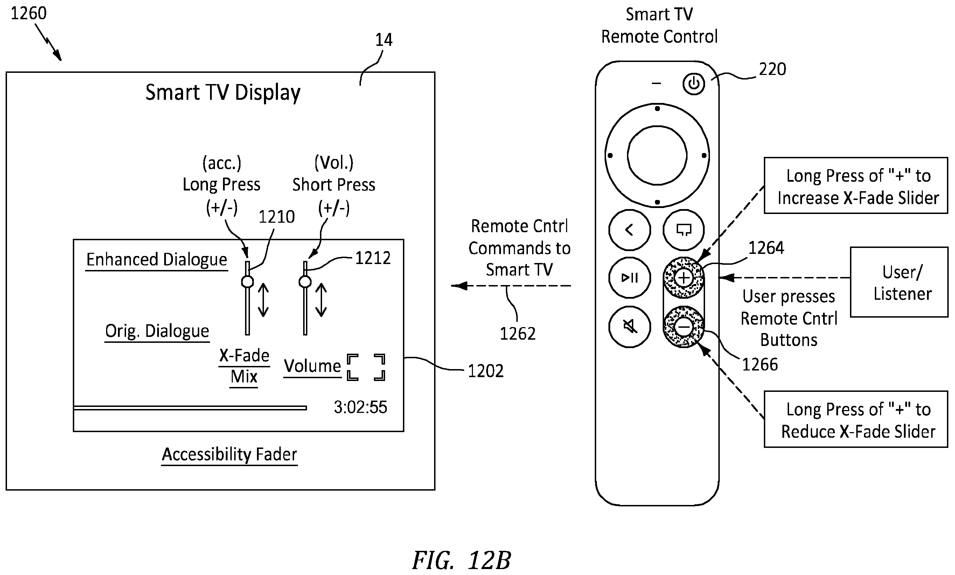

More specifically, referring to Fig. 2A, a top-level block diagram 200A is shown of a user/listener side of a system to provide personalized audio streaming and rendering for a Smart TV with remote control or user device controlled cross-fade audio mix, in accordance with embodiments of the present disclosure. In particular, a smart playing device 12, such as a Smart TV, is shown having a remote control (or Remote) 220 or a user device 12, used to control a crossfade logic (X-Fade Logic) 100 feature and other Acc App UI features discussed herein via the Smart TV Display 14. In some embodiments, the user/listener 15 may communicate with the Smart TV and the Acc App Logic 16 using the Remote control 220 which communicates (wirelessly or wired) with a remote-control interface or Remote Receiver 216 within the Smart TV 20. In that case, the user/listener 15 will press buttons 218 on the Remote 220, shown by a line 243, which will cause the Acc App logic 16 within the Smart TV to provide the X-Fade/EQ/Content UI on line 223 to the Smart TV Display 14, discussed more hereinafter with Fig. 12B, which UI may include a X-Fade slider and other UI display features shown in Fig. 12C (including audio content lists, personalized equalizer and other Acc App UI features discussed herein).

More specifically, an Acc App Logic 16 receives Max-Acc-Mix and Cin-Mix on lines 207, 209, from a known Audio Decoder 202, such as a known AAC-LC decoder which are currently provided and supported by streaming apps by Apple®, Amazon®, Roku®, and the like. The Audio Decoder 202, receives an encoded audio signal or mix, which may include Cin-Mix and Max-Acc-Mix interleaved in a single bit stream, and decodes the bit stream (or bs), using known decoding software, into the individual streams as Cin-Mix provided on line 207 and Max-Acc-Mix on line 209. Also, The Audio Decoder or Decoder 202 (Figs. 2A, 2B, 2C, 2D), as is known, parses and decodes an input audio bitstream into the pre-encoded tracks, e.g., Cin-Mix and Max-Acc-Mix. The Audio Decoder 202 may use software running on the operating system (OS) (e.g., iOS, Android, Roku, etc.) of the devices streaming content, and uses the same codec as that used by the Encoder 26.

In addition, the Acc App Logic 16 receives a noise floor (NF) signal on a line 213 indicative of the noise floor in the listening environment. The environmental noise floor NF may be estimated by receiving ambient sound from a microphone 206, which provides environmental sounds on a line 211 to a known filter 204 which filters out (or blocks) human voice frequency range and provides the NF on the line 213. The value of NF may be used to adjust the X-Fade slider position of the X-Fade Logic 100. In particular, when NF is available, the system may first set the X-Fade slider position to a value that allows the minimum loudness of the dialogue (Dx) LRA (loudness range) to be above the noise floor (NF) or the maximum value of the X-Fade slider position, whichever loudness value is lower. In some embodiments, the X-Fade Logic 100 or Acc App Logic 16 may also check to ensure that the LRA of the Dx and the M&E do not exceed the max permitted audio level, e.g., -2dB (True Peak), discussed more hereinafter. Accordingly, the Acc App Logic may also have known loudness detection software for determining the LRA. In some embodiments, the value of the LRA for the content may be provided in the metadata of the video content or may be stored separately from the video on Encoded Content Server 40, or other server.

The Acc App Logic 16 also receives a content selection on a line 229 from a remote control 220 and receives a X-Fade/EQ Adjust signal on a line 227 from the remote control 220. The Acc App Logic 16 also provides a X-Fade/EQ audio mix on a line 225 to the speakers 11 and provides a X-Fade/EQ & Content UI to the display 14 on a line 223. The X-Fade/Eq audio mix is a digital audio signal when it exits the X-Fade Logic and is then processed through a known digital-to-analog converter (DAC) to convert the mix to an analog signal before it is provided to the speaker(s) 11. Also, the Acc App Logic 16 provides a X-Fade/EQ & Content UI and on a group of lines 230 to the User Device 12 and receives a Selected Content request and a X-Fade/EQ Adjust signal on the group of lines 230, which communicates with a user device 12. The Acc App Logic 16 also communicates on a line 219 with a User Attributes Server 42, which holds information and data associated with a given user device 12 or user/listener 15. The Acc App Logic 16 also requests and receives an audio content list (or index or audio file list) on a line 215 from the Encoded Content Server 40 on a line 201, which lists the audio content or audio files available on the Encoded Content Server 40 for review and selection by the user 15. The Acc App Logic 16 also provides the content selection requests received from the user/listener 15 to the Content API 30 on a line 205, which obtains the requested content a line 255 from the Encoded Content Server 40, and provides the selected content (e.g., Cin-Mix + Mac-Acc-Mix, interleaved in a single bit stream) to the Audio Decoder 202 on a line 203.

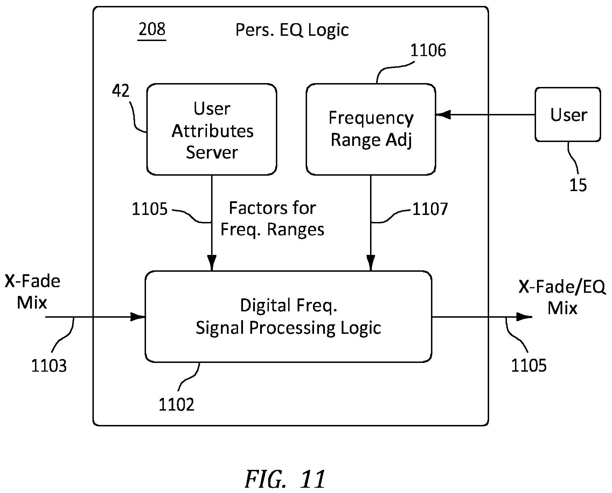

In addition, The Acc App Logic 16 has logic that perform various functions, such as X-Fade Logic 100, Acc App UI Logic 210, and Personalized Equalizer (Pers. EQ) Logic 208. In particular, the X-Fade Logic 100 performs a cross-fade rendering or blending of the Cin-Mix and the Max-Acc-Mix, to provide a resulting blending of the two input signals using power preserving gain curves, based on the position of a X-Fade Slider (or X-Fade Adjustment), using the power preserving X-Fade equation (Eq. 3) discussed hereinabove with Fig. 1. The Personalized Equalizer (Pers. EQ) Logic 208 is described with Fig. 11 hereinafter.

The Acc App UI Logic 210 provides a user interface (UI) to the display 14 of the Smart TV including a X-Fade UI and a Content UI on line 223, such as that shown in Fig. 12B and Fig.12C discussed hereinafter. The Acc App 16 receives a X-Fade adjust command from either the Remote on line 227 or from the user device 12 on the group of lines 231. The X-Fade Logic 100 performs the X-Fade function based on the command from the X-Fade slider, similar to that discussed herein with Fig. 1. The output of the X-Fade logic 100 is a X-Fade Mix (or Acc-Mix or personalized mix or personalized accessibility mix or Pers-Mix) provided on a line 225 to the speakers 11, and the resulting output audio from the speaker is provided (through the air) to the user/listener 15, shown by a dashed line 239. Also, the video portion of the selected content Cin-Mix (or C-Mix) is provided on a line 217 from the Content API 30 to the Display 14 of the Smart TV, which may be obtained from the Encoded Content Server 40, on a line 257. The video portion C-Mix video and the X-Fade/EQ/Content UI on line 223 (described hereinafter) are provided to the user/listener 15 by the Display 14, as shown by a dashed line 241.

The Acc App Logic 16 may also request and receive a content list (or index) on a line 215, which lists the audio content or audio files available on the Encoded Content Server 40 for review and selection by the user/listener 15.

Referring to Fig. 2B, a top-level block diagram 200B is shown of a user/listener side of a system to provide personalized audio streaming and rendering for a single user device, in accordance with embodiments of the present disclosure, as discussed above. Referring to Fig. 2C, a top-level block diagram 200D is shown of a user/listener side of a system to provide personalized audio streaming and rendering for a Smart TV with multiple user devices each having a personalized cross-fade audio mix, in accordance with embodiments of the present disclosure, as discussed above. Referring to Fig. 2D is a top-level block diagram 200 of a user/listener side of a system to provide personalized audio streaming and rendering for a Smart TV with multiple user devices each having a personalized cross-fade audio mix and content selection, in accordance with embodiments of the present disclosure, as discussed above.

Referring to Fig. 5A, a diagram 500 is shown of an interleaved Cin-Mix and Max-Acc-Mix content audio stream for accessible audio provided by the Audio Encoder 26, in accordance with embodiments of the present disclosure. As discussed herein, the Audio Encoder 26 (Fig. 1), analyzes and compresses an input audio source associated with a video source. The left side of Fig. 5A shows two non-encoded files, a Cin-Mix English (original) audio file and a Max-Cin-Mix audio file (or track), which are inputs to the Encoder 26, for a selected content. The right side of Fig. 5A shows the output of the Encoder 26 as an interleaved audio stream for accessible audio to be stored in the Encoded Content Server by the content provider computer 20 (Fig. 1), as discussed herein. In particular, the input audio files are each sampled and interleaved as shown in Fig. 5A, as Sample 1, Sample 2, etc. and each sample has a sampled portion of each input file.

Referring to Fig. 5B, a diagram 515 is shown of an interleaved Cin-Mix, Mid-Acc-Mix and Max-Acc-Mix content audio stream, in accordance with embodiments of the present disclosure.

Referring to Fig. 5C, a diagram 530 is shown of an interleaved Cin-Mix and Max-Acc-Mix content audio stream for accessible audio with two languages for voiceover audio, in accordance with embodiments of the present disclosure. In that case, for a stereo audio mix, two or three of the four mixes (if in stereo) shown may be used together to provide a voice-over or adaptive voice-over feature. For example, one or both of the dashed boxes may be optional. Thus, the stream may include: If the audio mixes are in mono (one channel per track), all four tracks shown may be used, if desired. In that case, when four tracks are received, the Acc App may select three to provide to the X-Fade renderer or, in some embodiments, a four input X-Fade renderer may be used if desired.

In particular, the Audio Encoder 26 (Fig. 1) provides interleaved data by sequentially placing samples from each audio channel (e.g., left and right channels in a stereo mix) one after another in a single stream, effectively "weaving" the channels together, such that the data for the first channel is followed by the data for the second channel, and so on, resulting in a single continuous data stream that can be easily decoded and played back by a compatible audio player, as is known.

The present disclosure uses the Encoder 26 to also interleave two (or more) different tracks (e.g., Cin-Mix and Max-Acc-Mix), as shown in Figs. 5A, 5B, 5C, which provides a single stream having both tracks embedded in the stream, which allows a user/listener (after decoding) to cross-fade between the two (or more) tracks to obtain a personalized listening experience while receiving only a single stream. Thus, for a standard stereo mix, the present disclosure would use four channels, two for Cin-Mix (L/R) and two for Max-Acc-Mix (L/R), i.e., two additional channels. In the case of three stereo tracks, e.g., Cin-Mix, Mid-Acc-Mix, and Max-Acc-Mix, the present disclosure would use six channels, two for Cin-Mix (L/R), two for Mid-Acc-Mix, and two for Max-Acc-Mix (L/R), i.e., four additional channels. For a Surround 5.1 mix, having 5 channels, and Immersive 5.1.4 mix, having 10 channels (including the subwoofer), only the Center channel (or dialogue channel) of the mix would be processed by the DCE to create the Max-Acc-Mix, so the Encoder would only need to interleave one additional channel for Max-Acc-Mix, or two additional channels if Mid-Acc-Mix and Max-Acc-Mix are used.

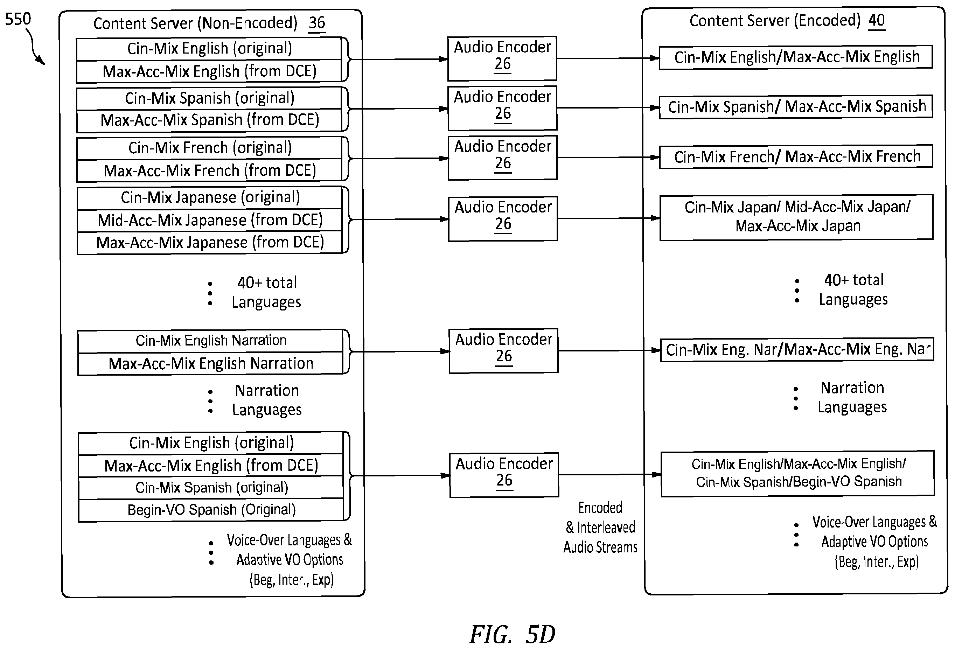

Referring to Fig 5D, a block diagram 550 is shown of the Non-Encoded Content Server 36 having separately-saved non-encoded Cin-Mix and Max-Acc-Mix audio content streams as an input to the Audio Encoder 26 and the Encoded Content Server 40 having the encoded and interleaved Cin-Mix/Max-Acc-Mix audio content files as an output from the Audio Encoder 26, in accordance with embodiments of the present disclosure. In particular, the Cin-Mix (original) files may be from the studio that created the cinematic mix, and the Max-Acc-Mix (from DCE) may be from the DCE Logic 62, as described herein. In somew embodiments, the studio or content provider may provide the Cin-Mix and the Max-Acc-Mix (i.e., two files, Cin-Mix-English (original) and Max-Acc-Mix English (from DCE)) in multiple languages to appeal to a large listening audience, as shown in the table 550, e.g., 40+ languages. In addition, in some embodiments, for certain content, the studio or content provider may provide Cin-Mix, Mid-Acc-Mix and the Max-Acc-Mix (i.e., three files, Cin-Mix-Japanese (original), Mid-Acc-Mix Japanese (from DCE) and Max-Acc-Mix Japanese (from DCE)) in certain desired languages as needed, shown here as a Japanese language example.

Also, in some embodiments, the voiceover options to include in the encoded mix may include various desired combinations of desired audio files, such as: Cin-Mix English (Original Version OV), Max-Acc-Mix English (from DCE) + Max-Acc-Mix Spanish (from DCE), Max-Acc-Mix English (from DCE) + Max-Acc-Mix Spanish (from DCE) + Separate-AD Spanish (audio description (AD) in the same language as the voice over since that is the language that is making the content more accessible for people that are not native in English OV for this particular use case). Other combinations may be used if desired. The "+" sign used above means sum/addition/overlay of the underlying 2 or 3 audio signals. The audio description (AD) track here is carrying solely the audio description alone and not the entire mix (different from approach below).

In some embodiments, in addition to that shown in Fig. 5D, the narration or audio description (AD) mix may include: Cin-Mix English / Cin-Mix English AD/Narration, Cin-Mix Spanish /Cin-Mix Spanish AD/Nar, and the like. In that case, the low end of the X-Fade slider may have just the language of choice without any narration, and as the slider is increased, the volume of the selected voiceover language increases. Also, in some embodiments, in addition to that shown in Fig. 5D, the adaptive voice-over (VO) mix may include: Cin-Mix English / Cin-Mix Spanish, or Cin-Mix English / Cin-Mix Spanish VO-beginner, or Cin-Mix English / Cin-Mix Spanish VO-intermediate, or Cin-Mix English / Cin-Mix Spanish VO-expert.

Referring to Fig. 5E, a table 580 is shown having various encoding and decoding options for a given stream type and user desired configuration, in accordance with embodiments of the present disclosure. In particular, the present disclosure provides for embodiments which include a Single Multi-channel Audio Encoder/Decoder. MPEG AAC-LC and Dolby E-AC3 support "dual stereo" encoding mode, e.g., 2x 2.0/stereo independently encoded. MPEG AAC-LC and Dolby E-AC3 support "quad mono" encoding mode, e.g. 4x 1.0/mono independently encoded. For example, Dolby Digital Plus with Joint Object Coding (JOC), often referred to as Dolby Digital Plus with Dolby Atmos, allows main and associated audio, including object-based audio for Atmos, to be carried within a single bitstream, as is known. In the table 580, 2.0 and 4.0 means 2 channels and 4 channels, respectively. Also, 100% of Dolby devices can decode AAC-LC. The same applies to the other audio compression technology codecs, such as DTS, Opus, ITU codec, and the like. AC3 (or AC-3) is commonly referred to as Dolby Digital, and EC3 (or Enhanced AC-3) is commonly referred to as Dolby Digital Plus, having enhanced sound quality, as is known. In some embodiments, open-source software tools such as FFmpeg® or Gstreamer® may also be used with the present disclosure for processing the audio files. In addition, in some embodiments, for Dolby Atmos 5.1.4 (cinematic immersive), the Encoder may be a Dolby EC3 + JOC Encoder with 5.1 core main + JOC metadata and 1.0 associated per bsmod in ETSI TS 102 366 V1.4.1. Also, in some embodiments, for Dolby Surround 5.1, the Encoder may be a Dolby EC3, 7 channel encoder, e.g., 5.1 main + 1.0 associated per bsmod in ETSI TS 102 366 V1.4.1. Also, in some embodiments, for stereo sound or audio, there may be 2 x enc/dec for 2.0 dual stereo sound, or 4 x enc/dec for 1.0 for quad mono sound or 1 x enc/dec for 4.0 for multi-channel sound. Also, in some embodiments, for surround sound, 1 x enc/dec for 6.1 = 5.1 +1 (center channel). Also, in some embodiments, for immersive sound, 1 x enc/dec for 6.1.4 = 5.1.4 +1 (center channel).

Also, as described herein, in some embodiments, where Dolby/DTS (proprietary codecs) are used, there may be a 2.0 downmix prior to running the DCE. Also, in some embodiments, the system may receive (or create) Cin-Mix 2.0 and then create Max-Acc-Mix 2.0 which is encoded and then decoded (at the user/listener side) and provided to the X-Fade renderer to provide a X-Fade mix in 2.0 format.

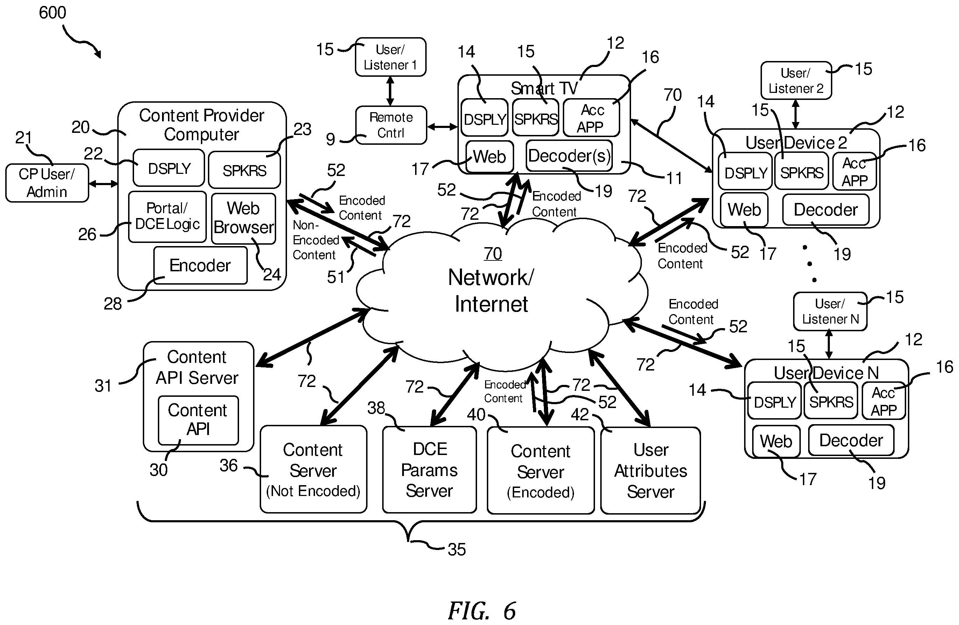

Referring to Fig. 6, the system of the present disclosure shown in Figs. 1, and Figs. 2A-2D, may be implemented in a network environment 600. The system includes the content provider computer 20, one or more user devices 12, and various servers 35 that interact with the computer 20 or the user devices 12 to perform the functions described herein.

In particular, various components of an embodiment of the system of the present disclosure include a plurality of the computer-based user devices 12 (e.g., a Smart TV and Device 2 to Device N), which may interact with the respective users (User/Listener 1 to User/Listener N). A given user 15 may be associated with one or more of the devices 12. In some embodiments, the Acc App 19 may reside on the user device 12 or on a remote server and communicate with the user device(s) 12 via the network. In the case of the user device 12 being a Smart TV 12, the user 15 may communicate with the Smart TV via the Remote control 220 using a known remote-control interface or receiver 216 (Figs. 2A-2D) within the Smart TV 20, as described herein above. In some embodiments, the User Device 12 may communicate directly with the Smart TV using a wired or wireless connection (e.g., Bluetooth, wifi, NFC, or other wireless connection) as shown by a line 71.

In some embodiments, one or more of the user devices 12, may be connected to or communicate with each other through a communications network 70, such as a local area network (LAN), wide area network (WAN), virtual private network (VPN), peer-to-peer network, or the internet, wired or wireless, as indicated by lines 72, by sending and receiving digital data over the communications network 70. If the user devices 12 are connected via a local or private or secured network, the user devices 12 may have a separate network connection to the internet (or other network) for use by web browsers running on the devices 12. The user devices 12 may also each have a web browser 17 to connect to or communicate with the internet to obtain desired video/audio content in a standard client-server-based configuration to obtain the Acc App 19 or other files needed to execute the logic of the present disclosure. The user devices 12 may also have local digital storage located in the device itself (or connected directly thereto, such as an external USB connected hard drive, thumb drive or the like) for storing data, images, audio/video, documents, and the like, which may be accessed by the Acc App 16 running on the user devices 12.

Also, the user devices 12 may also communicate with the separate computer servers 35 via the network 70 such as the Content AP Server 31 (which has the Content Selection API 30), Non-Encoded Content Server 36, DCE Parameters Server 38, Encoded Content Server 40, and User Attributes Servers 42. The servers 35 may be any type of computer server with the necessary software or hardware (including storage capability) for performing the functions described herein. Also, the servers 35 (or the functions performed thereby) may be located, individually or collectively, in one or more separate server(s) on the network 70, or may be located, in whole or in part, within one (or more) of the user devices 12 on the network 70.

The content provider computer 20 may, as discussed herein, be a smart phone, computer, laptop, tablet, or other computer-based device, which may receive instructions from a content provider User/Admin 21 and may have Portal/DCE Logic 28, running on the computer 20, which receives non-encoded (or unencoded) content from the Non-Encoded Server 36, as indicated by a line 51, and creates and delivers the encoded content, as indicated by a line 52 (e.g., streaming content or VOD content of a movie or show or other content) using the web browser 24 (or web server or equivalent interface), via the communications network 70, to the Encoded Content Server 40 for use by the user devices 12, by the Users/Listeners 15 (User/Listener1 to User/ ListenerN). Similarly, as discussed herein, the user devices 12 may be a smart phone, computer, laptop, tablet, smart TV, or other computer-based device, which may receive digital content (e.g., a streaming or VOD show) including the encoded content from the content provider, either directly or from content stored on the Encoded Content Server 40 to the device 12 for viewing and listening by the user/listener 15, e.g., using a web browser 24 (or web server or equivalent interface), via the communications network 70.

The Portal/DCE Logic 28, running on the computer 20, may also provide audio/video to the CP User/Administrator to obtain, update and save DCE parameters to and from the DCE Params Server 38. The computer 20 may also have the known Audio Encoder 26, discussed herein, which encodes the audio content into the desired format (e.g., stereo, Dolby, Dolby ATMOS, and the like), for use by the users 15, as discussed herein.

The CP Computer 20 has a Portal UI which provides model performance X-Fade control, waveform windows, DCE Gains/Model/Noise Floor selection data, audio output, and Accessible Audio approval selection capability to the user/administrator 21 for the content provider, as discussed herein. Also, the Portal/DCE logic 26 may obtain DCE parameters for the DCE and may display it on the display the Portal UI as discussed herein with Fig. 1.

In addition, the Content Selection API 30 may reside on a Content Selection API Server 31 which may communicate via the network 70 with the user devices 12 and with the CP Computer 20, and the other servers, and with each other or any other network-enabled devices or logics as needed, to provide the functions described herein.

Similarly, the user devices 12 may each also communicate via the network 70 with the logics or software applications described herein, and any other network-enabled devices or logics necessary to perform the functions described herein.

Portions of the present disclosure shown herein as being implemented outside the user device 12, may be implemented within the user device 12 by adding software or logic to the user devices 12, such as adding logic to the Hub Acc App or Acc App software or installing a new/additional application software, firmware or hardware to perform some of the functions described herein, or other functions, logics, or processes described herein.

Referring to Fig. 11, a block diagram is shown of components of a personalized equalizer (Pers. EQ) Logic 208 (Figs. 2A-2D), in accordance with embodiments of the present disclosure. In particular, the Pers. EQ Logic 208 receives the X-Fade Mix on a line 1103 and performs digital frequency signal processing on the X-Fade Mix by known Digital Frequency Signal Processing Logic 1102, which amplifies certain frequency ranges based on Freq. Range Factors on a line 1105 from the User Attributes Server 42. The Digital Frequency Signal Processing Logic 1102 may use similar logic to that of known hearing aid logic or other audio frequency range boosting devices. The Freq. Range Factors may be pre-stored in the User Attributed Server 42 based on a previously obtained hearing test via a third-party audiogram or a user device hearing test run by the user.

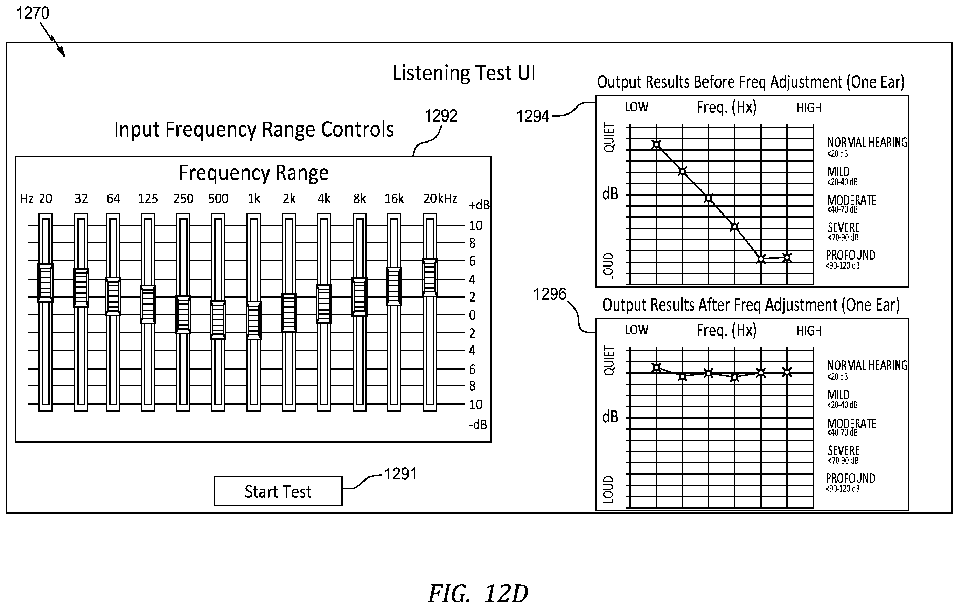

In some embodiments, the Freq. Range Factors may be provided by the system of the present disclosure based on a user listening test. In that case, the content provider may provide a CP App Listening test, which provides a series of sounds to the user/listener 15 at various frequencies to test hearing and allows the user/listener 15 to selectively adjust the frequency boost for each frequency range being tested shown by a Frequency Range Adjustment box 1106 (which may be a UI) and provide Freq. Range Factors for the given user/listener 15 on a line 1107 to the Digital Frequency Signal Processing Logic 1102. The Pers. EQ Logic 208 may also save the Freq. Range Factors for the given user/listener 15 on the User Attributes Server 42 for future use with the same user/listener 15. The UI for a Listening Test UI 1290 is shown in Fig. 12D, discussed hereinafter, and provides frequency range adjustment sliders for the user/listener to adjust.

Referring to Fig. 12A, a screen illustration 1200 is shown of a graphical user interface (UI) or Portal UI for DCE parameter adjustment & Max-Acc-Mix monitoring which may be used by the content provider (CP) user/administrator with the ability to set/adjust the DCE parameters, and listen to the result across the cross-fade range, in accordance with embodiments of the present disclosure. In particular, the Portal UI 1200 may contain a field 1206 for entering an audio/video file of interest, which may be selected from a Content Audio Files listing shown in a window 1204, which lists the available files and allows the user to select a file of interest for creating an accessible track. Once an audio file has been selected, the system displays the file in the field 1206. The Portal UI 1200 will also display an Accessibility Fader (or X-Fade and Volume Control) window 1202 (or screen portion). The X-Fade Mix and Volume may be controlled by X-Fade and Volume sliders 1210,1212, respectively. One end (upper or top) of the X-Fade slider 1210 provides solely the enhanced dialogue (or Max-Acc-Mix) and the other end (lower or bottom) of the X-Fade slider 1210 provides solely the original dialogue or original cinematic mix (Cin-Mix), and between the two ends of the slider, the X-Fade renderer provides a blend of the Cin-Mix and Max-Acc-Mix, as discussed herein. The sliders 1210, 1212, may be moved manually by the user/listener by using the Smart TV remote control (as discussed herein) or by tapping on (or clicking on) the slider 1210 or touching the slider 1210 when used on a smart phone or laptop or desktop or tablet computer. In some embodiments, a voice command may also be used to adjust the slider, e.g., if the smart TV or user device is connected to a voice responsive app. The present application supports discussions with most voice receptive products, such as Siri®, Google assistant®, Alexa®, and the like. In addition, there may be a waveform window 1808 displayed on the UI screen. The waveform window 1208 provides a display of the Cin-Mix and the Max-Acc-Mix with a view of the cross-fader and the X-Fade gain curves, discussed herein. In particular, the waveform window 1208 shows an example of audio signal monitoring using a known Pure Data utility on a macOS for a Stereo 2.0 use case showing original mix (Cin-Mix) and dialogue enhanced mix (Max-Acc-Mix). The window 1208 shows how the Content Provider (CP) user/admin 21 can experience real-time cross-fade between Cin-Mix (original mix)(Left/Right) (on the left) and Max-Acc-Mix (Left/Right) (Dialogue-Enhanced Mix) (on the right), which allows the user/admin 21 to see and hear the audio effects of the DCE for creation of the accessible mix (or Max-Acc-Mix).

Also, the Portal UI 1200 provides a window or screen section 1220 which provides the ability for the CP user/admin to selects various DCE parameters (or DCE Params), such as: DCE Model type, DRC Gain Profile, Gmne, MNE Gain Factor, Gdx, Dx Gain Factor, Noise Floor, ALN Gain value entry or auto calculate. The DCE Params window 1220 may also include the ability to set or adjust the Dialogue-to-Program Loudness or the Dialogue-to-Residual Loudness (DPL or DRL), e.g., the clearance in dB between the Dialogue and the Residual/MNE (not shown). Other parameters may be included in the DCE Params window 1220 if desired. In addition, the Portal UI also has a button 1222 that can be selected when the Max-Acc-Mix is at an acceptable level (Max-Acc-Mix OK). The DCE parameters window 1220 allows ALN Gain to set to a desired value, or if the user selects (or clicks on) the Auto box, the system will automatically select an ALN gain that maximizes the accessible audio mix (Max-Acc-Mix) dynamic range (or loudness range) above the set noise floor (NF) while not exceeding the requirements described herein for Max Audio level, as described with Eq. 1. The Content Owner may set a given noise floor, e.g., based on a pre-set audio standard noise floor or based on the target audience or user preferences.

Also, the DCE parameters window 1220 allows the DRC Gain Profile (or DRC Gain Curve) to be set based on the desired gain profile provided in a file which the user may select. As discussed herein, different profiles may provide different compression levels or amounts on the M&E mix, as shown by the DRC Gain Curve 900 in Fig. 9, including boost range, null band range (or unity gain region), early cut range, and cut range. Other ranges and labels may be used to describe the DRC Gain Curve if desired.

Referring to Fig. 12B, a screen illustration 1260 is shown of a Smart TV display 14 of a graphical user interface (UI) for a remote control 220 for manually adjusting the cross-fade (X-fade) renderer (or accessibility fader) window 1202 of Figs. 2A, 2C and 2D, in accordance with embodiments of the present disclosure. In particular, when the user holds down the up or down arrow for a "long press", e.g., greater than 2 seconds, the Smart TV knows that this a specialized command and the Acc App 210 (Fig. 2A) within the Smart TV 12 will display the accessibility fader (X-Fade and Volume control) window 1202 on the TV display screen 14. In addition, if the plus (+) volume arrow 1264 is long pressed (e.g., more than 2 seconds) on the remote 220, a signal will be sent to the Smart TV shown as a dashed line 1262, which will be interpreted by the Acc App 210 as a command to increase the X-Fade slider 1210 position. Conversely, if the plus (+) volume arrow 1264 is pressed for a short time (e.g., less than 2 seconds) on the remote 220, a signal will be sent to the Smart TV and it will be interpreted as an increase volume 1212 command. A similar result occurs, if the minus (-) arrow 1266 is long pressed on the remote control 220, a signal will be sent to the Smart TV shown as a dashed line 1262, which will be interpreted by the Acc App 210 as a command to increase the X-Fade slider 1210 position. Conversely, if the minus (-) volume arrow 1266 is pressed for a short time (e.g., less than 2 seconds) on the remote 220, a signal will be sent to the Smart TV and it will be interpreted as a decrease volume 1212 command. As discussed herein, the X-Fade slider 1210 transitions between the original dialogue or original cinematic mix (Cin-Mix) and the enhanced dialogue or maximum accessible mix (Max-Acc-Mix).

Referring to Fig. 12C, a screen illustration 1270 is shown of a graphical user interface (UI) for an Acc App used by a user with the ability to set/adjust the cross-fade and enable certain features, in accordance with embodiments of the present disclosure. In particular, the UI 1270 may contain the field 1206 for entering an audio/video file of interest, which may be selected from a Content Audio Files listing shown in a window 1204, which lists the available files and allows the user to select a file of interest, similar to that shown in Fig. 12A. Once an audio file has been selected, the system displays the file in the field 1206. The UI 1270 will also display the Accessibility Fader (or X-Fade and Volume Control) window 1202 (or screen portion). The X-Fade Mix and Volume may be controlled by sliders 1210,1212, respectively similar to that shown in Fig. 12A. One end of the slider 1210 provides totally the enhanced dialogue (or Max-Acc-Mix) and the other end of the slider 1210 provides the original cinematic mix (Cin-Mix). When the slider 1210 is in between the two ends, the output audio is a blended combination of the Cin-Mix and Max-Acc-Mix, using the power preserving curves shown in Figs. 10A-10C and discussed hereinbefore with for the X-Fade logic in Fig. 1 and Figs. 2A-2D.

In addition, the user/listener UI 1270 may also display several other fader displays, such as: Video Voice-Over 1280, Live Sports Fader1 1282, Live Sports Fader2 1284. In addition, the user/listener UI 1270 may also display a an Acc Features window 1288, which allows the user 15 to select various features of the Acc App, such as: Remote, Hub Mode, Single Device Mode, Synch Smart TV, Microphone (present or not), Live Sports, Personalized EQ, Adaptive Voice-Over (VO), and Audio Description (or narration), as discussed herein. The user/listener UI 1270 may also display a X-Fade Mix OK button 1294, which allows the user to select or click on when the settings for a given selected content are acceptable to the user/listener 15.

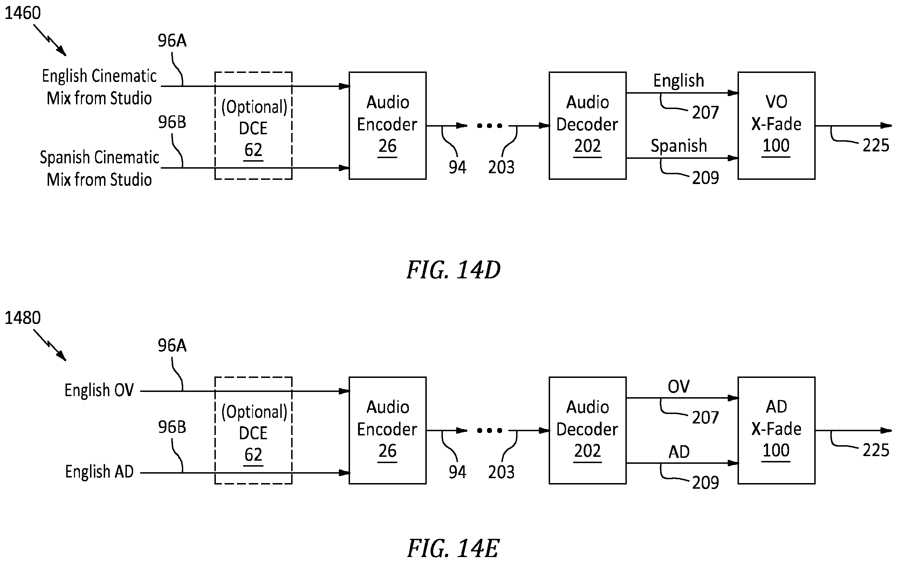

In particular, when the Mic button is selected, the X-Fade logic will automatically adjust the X-Fade slider 1210 to a level that is above the measured noise floor (NF). The user may then further adjust the slider 1210, if needed, to provide an optimal listening experience for the user 15. Also, when the Live Sports button is selected, the Live Sports Fader 1 and Fader 2 windows 1282, 1282 will appear on the UI. Also, when the Audio Description button is selected, the Accessibility Fader window 1202 may display a range from original version (OV or English OV) mix at a bottom X-Fade slider range limit and Audio Description (OD or English AD) mix at a top X-Fade slider range limit, like that described in Fig. 14E. Also, when Hub Mode is selected, the device 12 knows to communicate with the Hub device, e.g., the Smart TV, which will provide the content directly to the user device. Also, when Single Device (or standalone) Mode is selected, the device 12 knows that it must obtain the audio content directly from the video/audio source, not through the Smart TV. Also, when Remote Mode is selected, the device 12 knows to communicate that it can control the UI on the Smart TV using the user device UI.

When Synch with Smart TV Mode is selected, the device 12 will synch up the individual user device with the Smart TV while playing content, such that the user device and the Smart TV are playing the same content in synch with each other. This may be done even when there are multiple different streams for the same content being provided to different devices from the Smart TV, e.g., original, alternate language, voice-over, adaptive voice-over, audio description, as shown in Fig. 2D (with multiple decoders). The Synch Request may be part of the communications with the Hub Acc App 16 on the Smart TV. The status of each of the Acc Features 1288, as needed, may also be included in the communication with the Hub Acc App (e.g., Figs 2C, 2D on lines 231B, 233B, 231A, 231B).

Also, when the Personalize EQ button is selected, the Pers. EQ window 1286 appears and allows the user to select where the frequency range factors or weighting factors (Fig. 11) are coming from, as described further with Fig. 11, including allowing the user to run a hearing test to determine the frequency range factors. Thus, the present disclosure may be tailored to the hearing abilities of the user/listener 15 to provide a personalized audio experience. Also, when the Adaptive Voice-Over button is selected, language level selection window 1289 appears and allows the user to select the level for the voiceover language level, e.g., beginner, intermediate, expert. Other levels may be provided if desired. As discussed herein, the content provider may provide additional mixes for certain levels of translation based on the level desired by the user. In that case, the system will filter the content list based on the level desired by the user. The language window 1290 may also be used as a language filter at any time to provide only content in a given language in the content list 1204, if desired.

The user/listener UI 1270 may also display a personalized EQ window 1286 which allows the user to selected between types of personalized equalizer sources, including 3rd party audiogram, device app or OS (e.g., IOS or Android), or content provider (CP) app listening test mode, as discussed herein. The user/listener UI 1270 may also display a language selection window 1290 which allows the user to select content of a particular language, as discussed herein. The user/listener UI 1270 may also display a language understanding window 1290 which allows the user to select the level of understanding of the voice-over (VO) language, for selection of VO content of a particular language, as discussed herein.

Referring to Fig. 12D, a screen illustration 1290 is shown of a graphical user interface (UI) for a listening test to determine parameters for a personal equalizer, in accordance with embodiments of the present disclosure. In particular, the UI 1290 may display an Input Frequency Range Controls window 1292, which allows the user to adjust the volume (or gain) of different frequency ranges based on the position of sliders associated with each range. The user/listener UI 1270 may also display a pre-adjustment hearing results window 1294 which shows output results before frequency adjustment has been made for a given ear of the user/listener. Also, the user/listener UI 1270 may also display a post-adjustment hearing results window 1296 which shows output results after frequency adjustment has been made for a given ear of the user/listener. Also, the user/listener UI 1270 may also display a button 1291 which may be selected or clicked on to begin the test. The user/listener UI 1270 may be launched when the user selects the CP App Listening test mode option in the Acc App UI 1270, as discussed herein.

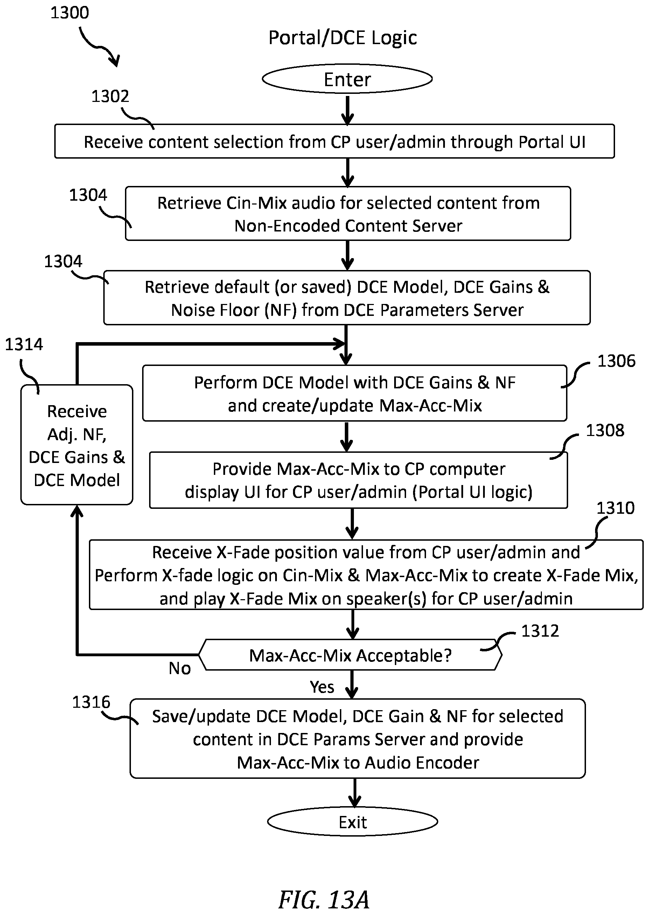

Referring to Fig. 13A, a flow diagram 1300 illustrates one embodiment of a process or logic for performing Portal/DCE Logic 28 (Fig. 1), in accordance with embodiments of the present disclosure. The process 1300 begins at block 1302 which receives content from the CP user/admin through the Portal UI (Fig. 12A). Next, block 1304 retrieves Cin-Mix audio for selected content from Non-Encoded Content Server. Next, block 1305 retrieves the default (or saved) DCE Model, DCE Gains & Noise Floor (NF) from DCE Parameters Server. Next, block 1306 performs the DCE Model with DCE Gains and NF and creates or updates the Max-Acc-Mix. This block 1305 may also receive adjusted NF, DCE Gains & DCE Model, as shown in block 1314, depending on the determination of whether Max-Acc-Mix is acceptable, occurring in block 1312. Following block 1306, block 1308 provides Max-Acc-Mix to CP computer display UI for CP user/admin (Portal UI logic). Next, block 1310 performs X-Fade (cross-fade) logic using X-Fade position gains on Cin-Mix & Max-Acc-Mix to create X-Fade Mix, and plays X-Fade Mix on speaker(s) for CP user or admin. Next, block 1312 determines whether Max-Acc-Mix is acceptable. If not acceptable, then block 1314 receives adjusted NF, DCE Gains and DCE Model and this is delivered to block 1306, which performs the DCE Model with DCE Gains & NF and creates or updates the Max-Acc-Mix. Next, if Yes, the Max-Acc-Min is acceptable, then block 1316 will save or update the DCE Model, DCE Gain and NF for selected content in DCE Params Server and provide Max-Acc-Mix to the Audio Encoder. After block 1316 is completed, the process exits.

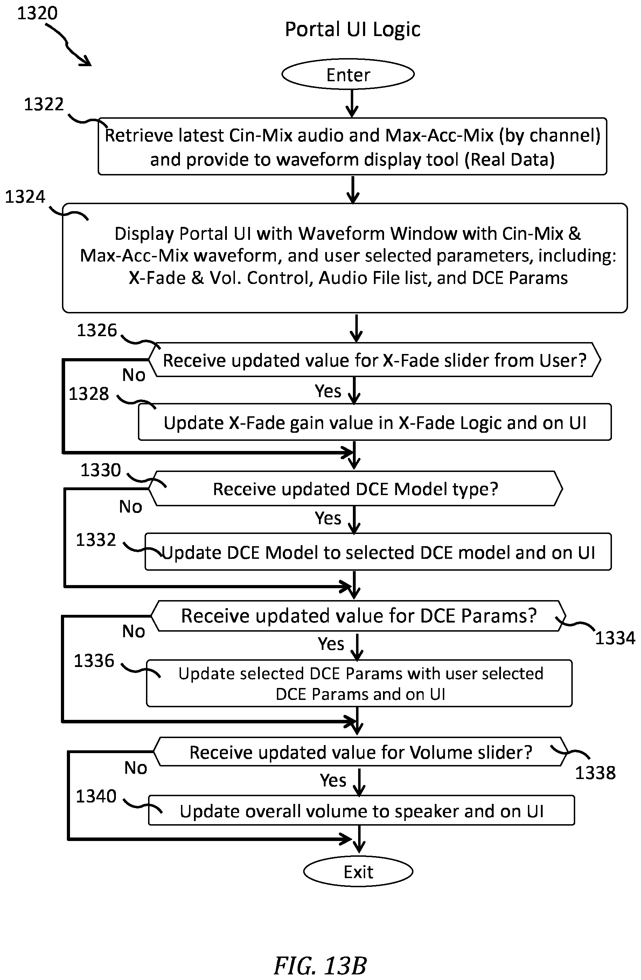

Referring to Fig. 13B, a flow diagram 1320 illustrates one embodiment of a process or logic for performing Portal UI Logic 60 (Fig. 1), in accordance with embodiments of the present disclosure. The process 1320 begins at block 1322 which retrieves the latest Cin-Mix audio and Max-Acc-Mix (by channel) and provides these to the waveform display tool (Real Data). Next, block 1324 displays the Portal UI with Waveform window with Cin-Mix Cin-Mix & Max-Ace-Mix waveform, and user selected parameters on Content Provider Computer Display, including: X-Fade & Volume Control, Audio File list, and DCE Parameters, such as: DCE Model type, DRC Gain Profile, Gmne, MNE Gain Factor, Gdx, Dx Gain Factor, Noise Floor, ALN Gain value entry or auto calculate. Next, block 1326 determines whether the updated value for X-Fade slider from the user has been received. If Yes, then block 1328 updates the X-Fade gain value in X-Fade logic and on the User Interface (UI). Next, or if the result of block 1326 is NO, block 1330 determines whether the DCE Model type has been received. If Yes, then block 1332 updates the DCE Model to the selected DCE Model and on the UI. Next, or if the result of block 1330 is NO, block 1334 determines whether the updated value for any of the DCE Parameters have been received. If Yes, then block 1336 updates the user-selected values for the DCE Parameters in the appropriate equations and models and on the UI. Next, or if the result of block 1334 is NO, block 1338 determines whether an updated value for Volume slider has been received. If Yes, then block 1340 will update the overall volume to the speaker and on the US. Next, or if the result of block 1338 is NO, the process 1320 exits.

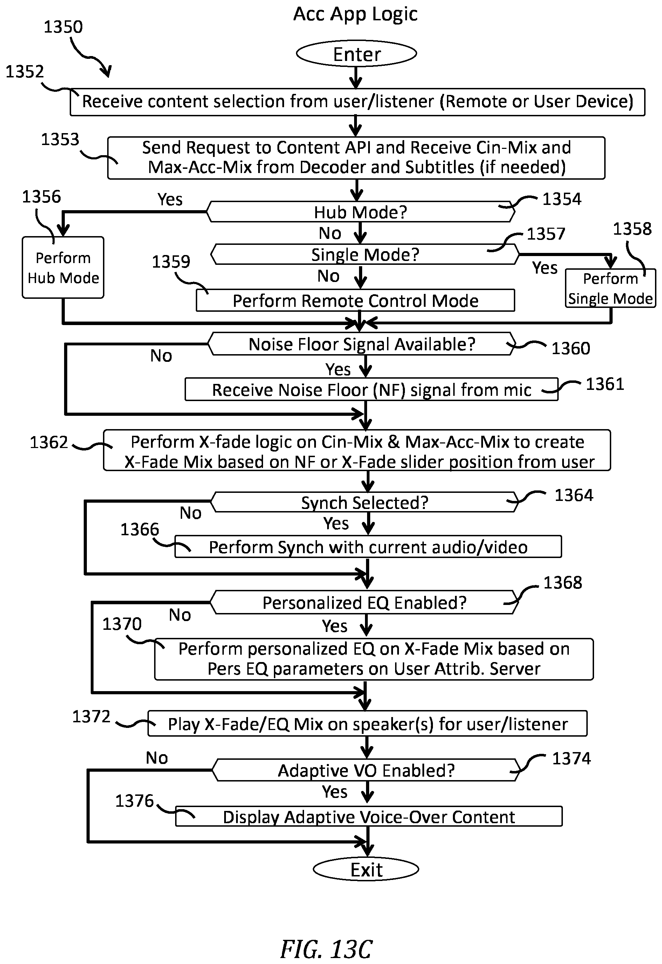

Referring to Fig. 13C, a flow diagram 1300 illustrates one embodiment of a process or logic for performing Accessibility (Acc) App Logic 16 (Figs. 2A,2C,2D), in accordance with embodiments of the present disclosure. The process 1350 begins at block 1352 which receives content selection from the user/listener, which may be from a remote or user device. Next, block 1353 sends a request to the Content API and receives a Cin-Mix and Max-Acc-Mix from the Decoder and Subtitles (if needed). Next, block 1354 determines whether Hub Mode should be performed. If Yes, then block 1356 performs Hub Mode. Next, or if the result of block 1354 is NO, block 1357 determines whether Single Mode should be performed. If yes, then block 1358 performs Single Mode. Next, or if the result of block 1357 is NO, block 1359 performs Remote Control Mode. Next, block 1360 determines whether a Noise Floor Signal is available. If yes, block 1361 receives the Noise Floor (NF) audio signal from the microphone 206 (Figs. 2A-2D) connected to the user device 12 (or Smart TV). Next, or if the result of block 1360 is NO, block 1362 performs X-fade logic 100 on Cin-Mix and Max-Acc-Mix to create a X-Fade Mix value based on measured NF or based on the position of the X-Fade slider as set by the user. In particular, if NF is measured or sensed, X-Fade logic 100 may set the value of the slider such that the integrated loudness IL or, if desired, the entire dynamic range (or audio loudness range), of the output audio (X-Fade mix) is above the noise floor NF or at the maximum value of the X-Fade slider. In some embodiments, the logic may also check to make sure the dynamic range (or audio loudness range) of the content does not exceed the maximum loudness permitted by the content provider or any required max loudness standard (Max Audio), e.g., -2dB (true peak).

Next, block 1364 determines whether Synch is selected. If Yes, block 1366 performs Synch with current audio and video. Next, or if the result of block 1364 is NO, block 1368 determines whether Personalized EQ is enabled. If Yes, then block 1370 performs Personalized EQ on X-Fade Mic based on Personalized EQ parameters on the User Attribution Server. Next, or if the result of block 1370 is NO, block 1372 plays the X-Fade/EQ Mix on speaker(s) for the user or listener. Next, block 1374 determines whether the Adaptive Voice-Over (VO) is enabled. If Yes, then block 1376 displays Adaptive Voice-Over content. Next, or if the result of block 1374 is NO, the process 1350 exits.

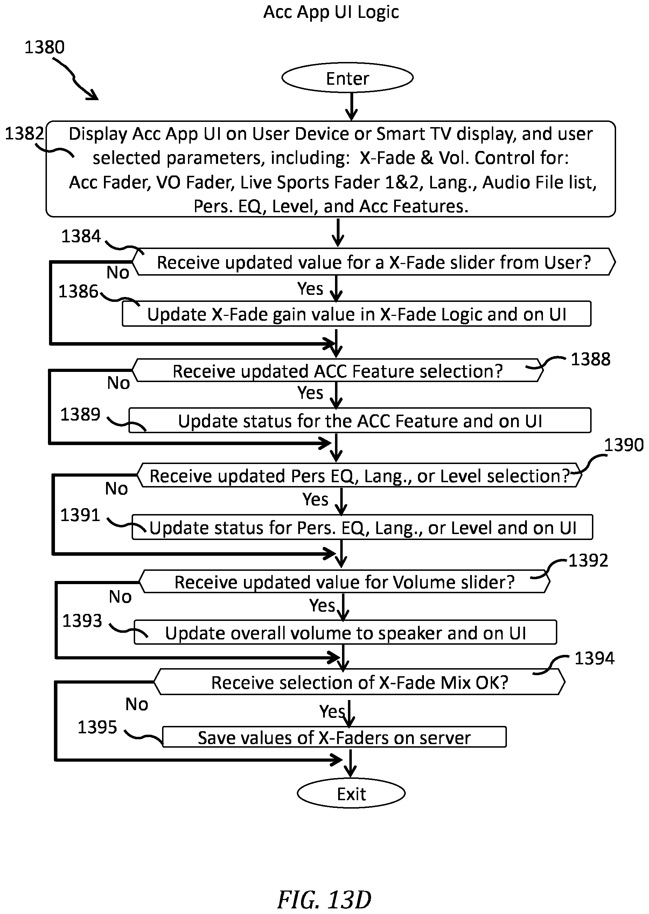

Referring to Fig. 13D, a flow diagram 1300 illustrates one embodiment of a process or logic for performing Acc App UI Logic 210 (Figs. 2A,2C,2D), in accordance with embodiments of the present disclosure. The process 1380 begins at block 1382 which displays the Acc App UI on the User Device or Smart TV display, and user selected parameters, including: (X-Fade & Vol. Control for: Acc Fader, VO Fader, Live Sports Fader 1&2, Lang., Audio File list, Pers. EQ, Level, and Acc Features. Next, block 1384 determines whether an updated value for a X-Fade slider has been received from the user. If Yes, block 1386 updates the X-Fade gain value in the X-Fade Logic on the UI. Next, or if the result of block 1384 is NO, block 1388 determines whether an updated Acc App feature selection has been received from the user. If Yes, block 1389 updates the status for the ACC Feature and on the UI. Next, or if the result of block 1389 is NO, block 1390 determines whether an updated Personalized EQ, Language, or Level selection has been received. If Yes, then block 1391 updates the status for Personalized EQ, Language, or Level and on the UI. Next, or if the result of block 1390 is NO, block 1392 determines whether an updated value for Volume slider has been received. If Yes, then block 1393 updates the overall volume to the speaker and on the UI. Next, or if the result of block 1392 is NO, block 1394 determines whether a selection of X-Fade Mix is OK. If Yes, then block 1395 saves the values of the X-Faders on the server. Next, or if the result of block 1394 is NO, the process 1380 exits.

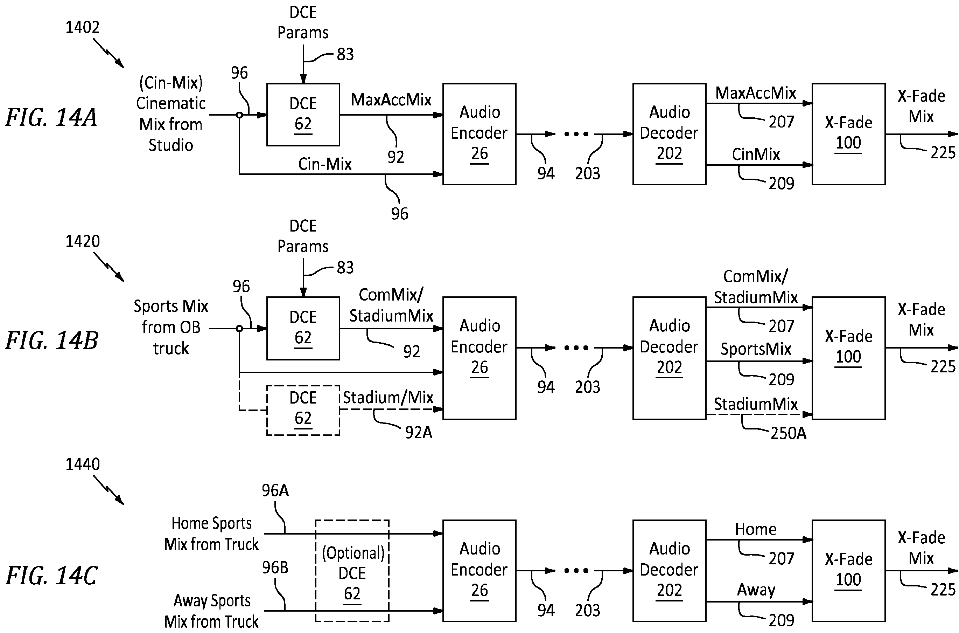

Referring to Figs. 14A, 14B, 14C, 14D, and 14E, block diagrams are shown of various embodiments for different audio inputs to be streamed and adjustably rendered by the cross-fade renderer, in accordance with embodiments of the present disclosure.

In particular, referring to Fig. 14A, a block diagram 1402 for video on demand (VOD) applications shows an embodiment of the present disclosure similar to that discussed with Figs. 2A-2D, where the Cin-Mix from the studio is provided to the content provider (CP) system on the line 96 as discussed herein. The Cin-Mix track is provided to the DCE 62, which may be tuned (using the DCE gains or parameters, as discussed herein) to provide a dialogue (Dx) enhanced and M&E compressed Max-Acc-Mix on the line 92, as discussed herein. The Max-Acc-Mix is provided on the line 92 to the Encoder 26, which also received the Cin-Mix on the line 96. The Encoder 26 provides an interleaved and encoded track having the Cin-Mix and the Max-Acc-Mix on the line 94 as discussed herein.

On the receiver or user/listener (right) side of the diagram 1402, the Cin-Mix/ Max-Acc-Mix interleaved encoded track is received on the line 203 by the Decoder 202, which separates the interleaved tracks into the Cin-Mix track and the Max-Acc-Mix track, on the lines 209,207, respectively, which are provided to the X-Fade renderer logic 100. The output of the X-Fade renderer logic 100 is a power preserving X-Fade mix of the Cin-Mix track and the Max-Acc-Mix track, as described herein, where the fade amount is based on the position (or location) of the user selected X-Fade slider 1282 (Fig. 12C), as discussed herein, provided on the line 225.

Also, in some embodiments, the DCE 62 may provide a second output mix, e.g., Mid-Acc-Mix (Fig. 1, on the line 93), to the Encoder 26. In that case, the Decoder 202 would provide three audio tracks, Cin-Mix, Mid-Acc-Mix, and Max-Acc-Mix to the three input X-Fade logic 100 within the Acc App Logic 16 (Figs. 2A-2D), as described herein above.

Referring to Fig. 14B, a block diagram 1420 for live sports shows an embodiment of the present disclosure similar to that discussed with Fig. 2A-2D, where the input signal is a live (or pre-recorded) video feed (e.g., Sports Mix or Live Mix), from a sporting event or other live event, provided from an outside broadcast (OB) truck to the content provider (CP) system on the line 96. The Sports Mix is provided to the DCE 62, which may be tuned (using the DCE gains or parameters, as discussed herein) to provide a dialogue enhanced commentator mix (or Com Mix) on the line 92, which has the commentator dialogue enhanced over the background stadium audio sounds or M&E (e.g., crowd and other general stadium noise or audio), or has solely commentator dialogue audio with no stadium audio or M&E. In some embodiments, the DCE 62 may be tuned to provide a stadium mix (or Stadium-Mix) on the line 92, which has the background stadium audio sounds or M&E (e.g., crowd and other general stadium noise or audio), enhanced over the commentator dialogue, or has solely stadium audio with no commentator dialogue audio.

The Com-Mix or Stadium-Mix is provided on the line 92 to the Audio Encoded 26, which also received the Sports Mix, which includes Com-Mix and M&E (Stadium-Mix), on the line 96. The Encoder 26 provides an interleaved and encoded track having the Sports Mix together with either the Com-Mix or the Stadium-Mix on the line 94 (Sports-Mix/Com-Mix or Sports-Mix/Stadium-Mix).

In this embodiment, on the receiver or user/listener (right) side of the diagram 1420, the Sports-Mix/Com-Mix or Sports-Mix/Stadium-Mix interleaved encoded track is received on the line 203 by the Decoder 202, which separates the interleaved tracks into the Sports-Mix track on the line 209 and the Com-Mix or Stadium-Mix track on the line 207 (depending on which was selected by the content provider when tuning the DCE 62, as discussed herein), which are provided to the X-Fade renderer logic 100. The output of the X-Fade renderer logic 100 is a power preserving X-Fade mix as discussed herein of the Sports-Mix and Com-Mix or of the Sports-Mix and Stadium-Mix (depending on which pair is provided in the stream received), where the fade amount is based on the user selected X-Fade slider 1282 (Fig. 12C), as discussed herein, provided on the line 225.

Referring again to Fig. 14B, in some embodiments, there may be a second (lower) DCE 62A provided which may provide the mix (Com-Mix or Stadium-Mix) not provided by the upper DCE 62. For example, the upper DCE 62 may provide the Com-Mix on the line 92 and the lower DCE 62A may provide the Stadium-Mix on the line 92A. In that case, the Encoder 26 would receive the Sports-Mix, Com-Mix and Stadium-Mix and provide an interleaved and encoded track having Sports Mix, Com-Mix and Stadium-Mix tracks on the line 94 (Sports-Mix/Com-Mix/Stadium-Mix), similar to that shown in Fig. 5B, which illustrates an example of three-track interleaving by the Audio Encoder 26.

On the receiver or user/listener (right) side of the diagram 1420, the Sports-Mix/Com-Mix/Stadium-Mix interleaved encoded track is received on the line 203 by the Decoder 202, which separates the interleaved tracks into the Com-Mix on the line 207, Sports-Mix track on the line 209, and the Stadium-Mix on the line 250A, which are provided to the three input X-Fade renderer logic 100 (Fig. 10C). The output of the three-input X-Fade renderer logic 100 is a power preserving X-Fade mix of the Com-Mix, Sports-Mix, and Stadium-Mix tracks, as described in Fig. 10C, based on the user selected on the position of the X-Fade slider 1282 (Fig. 12C), as discussed herein, provided on the line 225. In that case, one end of the X-Fade slider 1282 provides solely the Stadium-Mix (for those who do not want to hear the commentator dialogue audio), the middle position of the X-Fade slider 1282 provides the Sports Mix (having both stadium and commentator as originally delivered from the broadcast truck), and the other end of the X-Fade slider 1282 provides solely the Com-Mix (for those who do not want to hear the stadium background noise/ non-commentary audio).

The three-input X-Fade renderer may be used with any audio inputs where the content provider desires to provide a controlled selectable transition between two audio components in a given audio mix (e.g., Con-Mix/Stadium-Mix, Cin-Mix-Dx/Cin-Mix-AD, and the like). In that case, one end of the X-Fade slider provides solely a first audio component, the opposite end of the X-Fade slider provides solely the second audio component, and the middle of the X-Fade slider provides a portion both audio components. Other cross-fade renderer configurations and equations for the three input and two input X-Fade renderers described herein may be used if desired, provided they provide the same function and performance as that described herein. Also, where possible it is typically desirable to use the same M&E track for each input to the X-Fade renderer, to minimize the risk of holes in the M&E caused by studio or other processing of a given mix or track. In particular, when a translation to an alternate language (AL) is created from an English original video, there may be blank spots (or holes or voids) left in the audio due to the difference in time or number of words from English to the alternate language (AL). This is also true for non-English original content.

Referring to Fig. 14C, a block diagram 1440 for live sports applications shows an embodiment of the present disclosure similar to that discussed with Fig. 2A-2D, where a first input signal on a line 96A has the live (or pre-recorded) Sports Mix described above with Fig. 14B where the commentator dialogue audio portion is that of the Home sports team (Sports-Home-Mix), and a second input signal on a line 96B having the live (or pre-recorded) Sports Mix described above with Fig. 14B where the commentator dialogue audio portion is that of the Away sports team (Sports-Away-Mix). The Sports-Home-Mix and Sports-Away-Mix inputs on lines 96A, 96B, respectively, are provided to the Audio Encoded 26, which provides an interleaved and encoded track having the Sports-Home-Mix and the Sports-Away-Mix on the line 94 (Sports-Home-Mix/Sports-Away-Mix).

On the receiver or user/listener (right) side of the diagram 1440, the Sports-Home-Mix/Sports-Away-Mix interleaved encoded track is received on the line 203 by the Decoder 202, which separates the interleaved tracks into the Sports-Home-Mix and Sports-Away-Mix on the lines 207,209, respectively, which are provided to the X-Fade renderer logic 100.

The output of the X-Fade renderer logic 100 is a power preserving X-Fade mix as described herein of the Sports-Home-Mix and the Sports-Away-Mix tracks, where the fade amount is based on the position of the user selected X-Fade slider 1284 (Fig. 12C), as discussed herein, provided on the line 225. In that case, one end of the X-Fade slider 1284 provides solely the Sports-Home-Mix (for those who want to hear solely the home team commentator dialogue audio), the middle position of the X-Fade slider 1282 provides a blend the Sports-Home-Mix and the Sports-Away-Mix (having both home and away commentators dialogue audio), and the other end of the X-Fade slider 1284 provides solely the Sports-Away-Mix (for those who want to hear solely the away or visiting team commentator dialogue audio).

In some embodiments, the DCE 62 may be used on the Sports-Home-Mix and the Sports-Away-Mix input signals on the lines 96A,96B, to enhance the dialogue of the audio over the background noise or M&E, as shown by dashed boxes 62. In that case, the DCE parameters for the DCEs 62 may be set based on the desired dialogue audio, e.g., enhanced dialogue over the M&E or solely dialogue with no M&E, as discussed herein.

Referring to Fig. 14D, a block diagram 1460 for voice-over applications shows an embodiment of the present disclosure similar to that discussed with Fig. 2A-2D, where a first input signal on the line 96A has the original version (OV) cinematic mix in English (Cin-Mix-English or OV) from the studio, as discussed hereinabove, and a second input signal on the line 96B having an alternate language (AL) cinematic mix in English (Cin-Mix-Spanish or AL) from the studio. The Cin-Mix-English (OV) and Cin-Mix-Spanish (AL) inputs on lines 96A, 96B, respectively, are provided to the Audio Encoded 26, which provides an interleaved and encoded track having the Cin-Mix-English and the Cin-Mix-Spanish on the line 94 (Cin-Mix-English/ Cin-Mix-Spanish).

On the receiver or user/listener (right) side of the diagram 1460, the Cin-Mix-English/Cin-Mix-Spanish interleaved encoded track is received on the line 203 by the Decoder 202, which separates the interleaved tracks into the Cin-Mix-English and Cin-Mix-Spanish on the lines 207,209, respectively, which are provided to the X-Fade renderer logic 100.

The output of the X-Fade renderer logic 100 is a power preserving X-Fade mix of the Cin-Mix-English and Cin-Mix-Spanish tracks, as described herein, where the fade amount is based on the position of the user selected X-Fade slider 1280 (Fig. 12C), as discussed herein, provided on the line 225. In that case, one end of the X-Fade slider 1280 provides solely the Cin-Mix-English (OV) (for those who want to hear solely the original version language dialogue audio), the middle position of the X-Fade slider 1280 provides a blend the Cin-Mix-English and Cin-Mix-Spanish (having both original version OV language dialogue and the alternate language AL dialogue audio), and the other end of the X-Fade slider 1280 provides solely the Cin-Mix-Spanish (AL) (for those who want to hear solely the AL dialogue audio).

In some embodiments, the DCE 62 may be used on the Cin-Mix-English and Cin-Mix-Spanish input signals on the lines 96A,96B, to enhance the dialogue of the audio over the M&E, as shown by dashed boxes 62. In that case, the DCE parameters for the DCEs 62 may be set based on the desired dialogue audio, e.g., enhanced dialogue over the M&E or solely dialogue with no M&E, as discussed herein.

Referring to Fig. 14E, a block diagram 1480 for audio description (AD) or narration shows an embodiment of the present disclosure similar to that discussed with Fig. 2A-2D, where a first input signal on the line 96A has the original version (OV) cinematic mix in English from the studio (Cin-Mix-English or OV or Cin-Mix), as discussed hereinabove, and a second input signal on the line 96B having an audio description from the studio (AD or Cin-Mix-AD). The Cin-Mix (OV) and Cin-Mix-AD (AD) inputs on lines 96A, 96B, respectively, are provided to the Audio Encoded 26, which provides an interleaved and encoded track having the Cin-Mix and the Cin-Mix-AD on the line 94 (Cin-Mix/Cin-Mix-AD).

On the receiver or user/listener (right) side of the diagram 1480, the Cin-Mix/Cin-Mix-AD interleaved encoded track is received on the line 203 by the Decoder 202, which separates the interleaved tracks into the Cin-Mix (OV) and the Cin-Mix-AD on the lines 207,209, respectively, which are provided to the X-Fade renderer logic 100 described herein.

The output of the X-Fade renderer logic 100 is a power preserving X-Fade mix of the Cin-Mix (OV) and the Cin-Mix-AD tracks provided on the line 225, as described herein, where the fade amount is based on the position of the user selected X-Fade slider, which is similar to the slider 1280 (Fig. 12C), except the upper end of the slider may say Aud. Desc. Only (or AD Only). In that case, one end of the X-Fade slider 1280 provides solely the Cin-Mix (OV) (for those who want to hear solely the original version language dialogue audio), the middle position of the X-Fade slider 1280 provides a blend the Cin-Mix (OV) and the Cin-Mix-AD (having both original version OV dialogue and the audio description or narration (AD) dialogue audio), and the other end of the X-Fade slider 1280 provides solely the Cin-Mix-AD (for those who want to hear solely the audio description or narration dialogue (AD) audio).

In some embodiments, the DCE 62 may be used on the Cin-Mix (OV) and the Cin-Mix-AD input signals on the lines 96A,96B, to enhance the dialogue of the audio over the M&E, as shown by dashed boxes 62. In that case, the DCE parameters for the DCEs 62 may be set based on the desired dialogue audio, e.g., enhanced dialogue over the M&E or solely dialogue with no M&E, as discussed herein.

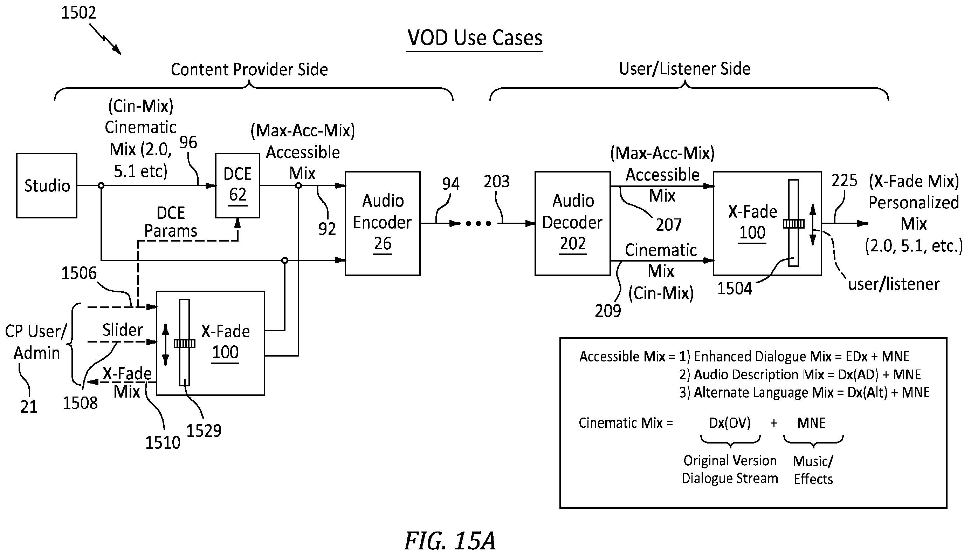

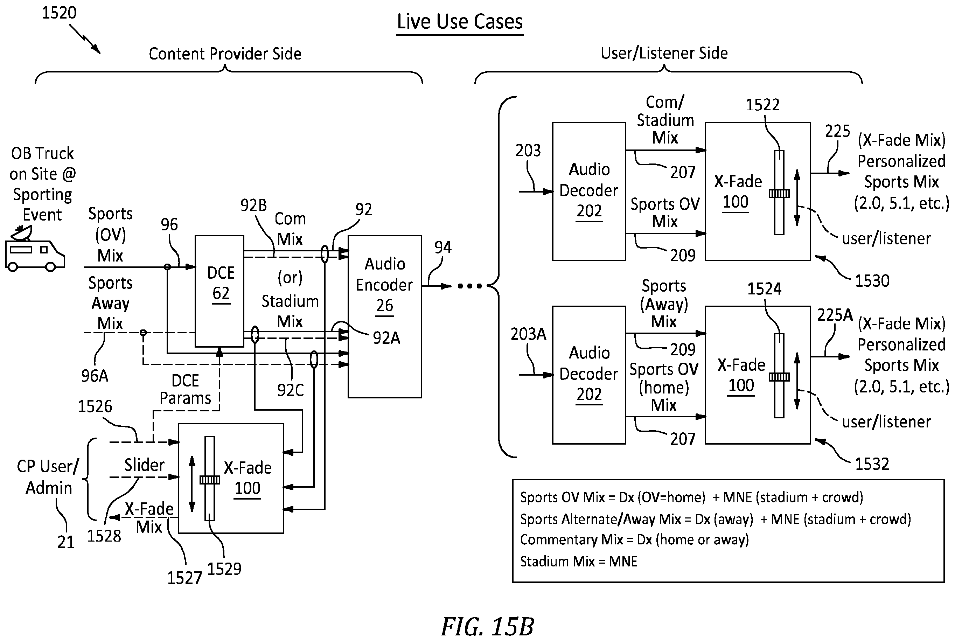

Referring to Figs. 15A and 15B, block diagrams are shown of various embodiments for different types of audio inputs to be streamed and adjustably rendered by the cross-fade renderer for video on demand (VOD) and live sports/events (Live) applications, respectively, in accordance with embodiments of the present disclosure.

Referring to Fig. 15A, a block diagram 1502 for video on demand (VOD) applications shows an embodiment of the present disclosure similar to that discussed with Fig. 14A, 14D and 14E, where the cinematic mix (Cin-Mix) from the studio is provided to the content provider (CP) system 10 (Fig. 1) on the line 96 as discussed herein. The Cin-Mix track on the line 96 is provided to the DCE 62, which may be tuned (using the DCE gains or parameters, as discussed herein) to provide a dialogue (Dx) enhanced mix, e.g., Max-Acc-Mix on the line 92, as discussed herein, which may also be generally referred to herein as an Accessible Mix. The Max-Acc-Mix is provided on the line 92 to the Encoder 26, which also received the Cin-Mix on the line 96. The Encoder 26 provides an interleaved and encoded track having the Cin-Mix and the Max-Acc-Mix on the line 94 as discussed herein. The Accessible Mix output of the DCE 62 (or Mac-Acc-Mix or Acc-Mix) may be an Enhanced Dialogue Mix (EDx-Mix) = Enhanced Dialogue (Dx or EDx) + M&E, or an Audio Description Mix (AD-Mix or Narration Mix) = Audio Description Dialogue (Dx(AD) or EADDx or ENDx) + M&E, or an Alternate Language Mix (AL-Mix or VO-Mix or Voice-Over-Mix) = Alternate Language Dialogue (Dx(AL) or ALDx or VODx). The Cinematic Mix, as discussed herein is Cinematic Mix (Cin-Mix) = Dialogue (original version or OV) + M&E.

More specifically, for the Audio Description Mix (AD-Mix) output from the DCE 62 on the line 92, the DCE 62 may be configured or tuned to provide solely the Audio Description Dialogue (Dx(AD)) and M&E and no primary or talent dialogue. Also, for the Alternate Language Mix output from the DCE 62 on the line 92, the DCE 62 may be configured or tuned to provide solely the Alternate Language Dialogue (Dx(AL) or Dx(ALT)) and M&E and no primary original version (OV) language dialogue.

In some embodiments, the CP user/admin 21 may be able to adjust the DCE Params (as discussed herein) to optimize the Max-Acc-Mix as shown by a dashed line 1506. In that case, the Max-Acc-Mix and the Cin-Mix are provided to the X-Fade logic 100 and the user/admin 21 controls the slider (as described herein), as shown by the dashed line 1508, and the X-Fade Logic 100 provides the X-Fade Mix to the user/admin on a dashed line 1510 to determine if the DCE Params are providing the desired audio experience.

The Accessible Mix or Acc-Mix is provided on the line 92 to the Audio Encoded 26, which also receives the Cin-Mix on the line 96. The Encoder 26 provides an interleaved and encoded track having the Acc-Mix and Cin-Mix on the line 94 (Acc-Mix/Cin-Mix).

On the receiver or user/listener (right) side of the diagram 1502, the Acc-Mix/Cin-Mix interleaved encoded track is received on the line 203 by the Decoder 202, which separates the interleaved tracks into the Acc-Mix (EDx + M&E or Dx(AD) + M&E or Dx(ALT) + M&E) depending on the application, e.g., Enhanced Dialogue, Audio Dialogue, or Alternative Language, on the line 207 and Cin-Mix (Dx(OV) + M&E) on the lines 209, which are provided to the X-Fade renderer logic 100 described herein.

The output of the X-Fade renderer logic 100 is a power preserving X-Fade mix of the Acc-Mix and the Cin-Mix tracks provided on the line 225, as described herein, where the fade amount is based on the position of the user selected X-Fade slider 1504, which is similar to the slider as described herein with Fig. 12C. In that case, one end of the X-Fade slider provides solely the Cin-Mix (OV) (for those who want to hear solely the original version dialogue audio) and the opposite end of the X-Fade provides solely the Acc-Mix (EDx + M&E or Dx(AD) + M&E or Dx(ALT) + M&E) depending on the application (for those who want to hear solely the accessible mix (Acc-Mix) for the given application) and the middle position of the X-Fade slider provides a blend the Cin-Mix (OV) and the Acc-Mix (EDx + M&E or Dx(AD) + M&E or Dx(ALT) + M&E) depending on the application.

Referring to Fig. 15B, a block diagram 1520 for live sports/events (Live) applications shows an embodiment of the present disclosure similar to that discussed with Fig. 14B and 14C, where the Sports Home Mix from the OB truck is provided to the content provider (CP) system 10 (Fig. 1) on the line 96 as discussed herein.

The Sports Home Mix track on the line 96 is provided to the DCE 62, which may be tuned (using the DCE gains or parameters, as discussed herein) to provide the home commentary mix (Com-Home-Mix) on the line 92 or a stadium mix (Stadium-Mix) on a line 92A, as discussed herein above.

The Comm-Home-Mix or the Stadium-Mix are provided on the lines 92, 92A, respectively, (depending on which was selected by the content provider when tuning the DCE 62, as discussed herein) to the Audio Encoder 26, which also receives the Sports-Mix on the line 96. The Encoder 26 provides an interleaved and encoded track having the Comm-Home-Mix or Stadium-Mix and Sports-Home-Mix on the line 94 (Sports- Home-Mix/Com-Home-Mix or Sports-Home-Mix/Stadium-Mix).

Alternatively, the Away Sports Mix track on the line 96A is provided to the DCE 62, which may be tuned (using the DCE gains or parameters, as discussed herein) to provide the away commentary mix (Com-Away-Mix) on a line 92B or a stadium mix (Stadium-Mix) on the line 92C, as discussed herein above.

In that case, the Comm- Away-Mix or the Stadium-Mix are provided on the lines 92B, 92C, respectively, (depending on which was selected by the content provider when tuning the DCE 62, as discussed herein) to the Audio Encoder 26, which also receives the Sports-Mix on the line 96. The Encoder 26 provides an interleaved and encoded track having the Comm-Away-Mix or Stadium-Mix and Sports- Away-Mix on the line 94 (Sports-Away-Mix/Com-Away-Mix or Sports-Away-Mix/Stadium-Mix).

Alternatively, the Sports-Home-Mix and Sports-Away-Mix inputs on lines 96, 96A, respectively, are provided to the Audio Encoded 26, which provides an interleaved and encoded track having the Sports-Home-Mix and the Sports-Away-Mix on the line 94 (Sports-Home-Mix/Sports-Away-Mix).

In some embodiments, the CP user/admin 21 may be able to adjust the DCE Params (as discussed herein) to provide the desired live sports/event mixes described above, as shown by a dashed line 1526. In that case, the mixes on the lines 92, 92A, 92B, 92C, 96, 96A may be provided to the X-Fade logic 100 and the user/admin 21 controls the X-Fade slider 1529 (as described herein), as shown by the dashed line 1528, and the X-Fade Logic 100 provides the X-Fade Mix to the user/admin 21 on a dashed line 1527 to determine if the DCE Params are providing the desired audio experience.

On the receiver or user/listener (right) side of the diagram 1520, in an upper portion 1530, the Sports-Home-Mix/Com-Home-Mix or Sports-Home-Mix/Stadium-Mix interleaved encoded track is received on the line 203 by the Decoder 202, which separates the interleaved tracks into the Com-Home-Mix or the Stadium-Mix (depending on which was selected) on the line 207 and Sports-Home-Mix on the line 209, which are provided to the X-Fade renderer logic 100 described herein, having a X-Fade slider 1522 which fades between Sports-Home-Mix and the Com-Home-Mix or the Stadium-Mix (depending on selection) based on the position of the X-Fade slider 1522, similar to that described with Fig. 14B. A similar X-Fade may be done for the Sports-Away-Mix/Com-Away-Mix or Sports-Away-Mix/Stadium-Mix.

On the receiver or user/listener (right) side of the diagram 1520, in a lower portion 1532, the Sports-Home-Mix/Sports-Away-Mix interleaved encoded track is received on the line 203 by the Decoder 202, which separates the interleaved tracks into the Sports-Home-Mix on the line 207 and Sports-Away-Mix on the line 209, which are provided to the X-Fade renderer logic 100 described herein, having a X-Fade slider 1524 which fades between Sports-Home-Mix and the Sports-Away-Mix based on the position of the X-Fade slider 1524, similar to that described with Fig. 14C.

As discussed herein, the present disclosure uses the crossfade renderer or X-Fade 100 (Figs. 1, 2A-2D and Figs. 14A-14E and Figs.15A-15B), to blend two (or more) input audio signals, which may be generally referred to as audio MixA and audio MixB. The X-Fade renderer has a X-Fade slider which can be moved (automatically or manually) from an initial position (initial end or first end) of the X-Fade slider which provides an audio output that is solely "Mix-A" to a final position (opposite end or second end) of the slider of the cross-fade is solely audio "Mix-B", and the X-Fade slider provides an unlimited number of positions between the initial (first end) and final (second end) positions, each position corresponding to a power preserving blending of audio MixA and audio MixB.

As discussed herein, audio MixA and audio MixB may be any two audio signals that are desired to be blended or faded from a first signal (MixA) to a second signal (MixB), for example MixA and MixB may be as follows: MixA = English original version (or Cin-Mix) and MixB = enhanced dialogue English (Max-Acc-Mix); MixA = English original version; MixB = English audio description; MixA = English original version and MixB = Spanish audio voice-over; MixA = English original version and MixB = Spanish audio description; MixA = home team commentary mix and MixB = away team commentary mix; MixA = home team commentary mix and MixB = stadium sounds (no commentary) mix. Other audio mixes may be used if desired as inputs to the X-Fade logic 100, provided, however, it may be desirable for the M&E portion of both the audio for MixA and MixB are similar or substantially the same to optimize the listening experience.

The label Max-Acc-Mix may be used herein for the Maximum Accessible Mix for the dialogue enhanced output of the DCE when the input is Cin-Mix (Studio VOD content application). However, it may also be used herein for the end point of the X-Fade slider for any of the other embodiments or applications discussed herein. Also, the term Max Personalized Mix (or Max-Pers-Mix) may also be used. However, other labels for the maximum or upper end point of the X-Fade slider may be used for the other applications, such as those shown in Figs. 14B-14E and 15B, such as: Max-Com-Mix for Maximum Commentary Mix for Live Sports content, Alt-Com-Mix for Alternate Commentary Mix for Live Sports content, Max-AD-Mix for Maximum Audio Description Mix for Audio Description of either Live/VOD content, and Max-VO-Mix for Maximum Voice-Over Mix of either Live or VOD content. Other labels may be used if desired depending on the application. In some embodiments, the terms MixA and MixB may be used to generically describe two audio mixes or tracks that define a lower boundary (or first end) and an opposite upper boundary (or second end) of a X-Fade slider for a two-input X-Fade renderer, as described herein. Also, for the above voice-over examples for MixA and MixB, English may be replaced by any Main (or Primary) language that the user desires, and Spanish may be replaced by any Alternate language (different from the Main language) that the user desires, provided the content owner or content provider provides the mix.

Also, while the X-Fade has been described as using a sine and cosine function to blend the two (or three) input signals to produce a power preserved output mix or X-fade mix, it should be understood by those skilled in the art that other crossfade approaches may be used if desired, such as the ones described below.

In some embodiments, the X-Fade logic 100 may comprise stepwise switching and smoothing. This approach uses stepwise switching with smoothing transitions from Mix A to Mix B in distinct steps rather than a continuous fade. It applies a short smoothing ramp (e.g., 200ms-500ms) to avoid sudden jumps in volume, making transitions feel more natural. More specifically, with this approach, when a transition is triggered, Mix A quickly fades out while Mix B fades in over a short period (e.g., 200ms-500ms). The fade curve can be linear, logarithmic, or sigmoid to optimize perceived smoothness. Also, the transition may be applied at natural switching points, such as sentence boundaries in dialogue, scene cuts, or pauses in background music. In some embodiments, a delay or hold function may be used which can prevent rapid, repetitive switching, ensuring a more fluid experience. When compared to a traditional crossfade, such as that shown herein with Figs. 10A-10D, there are certain advantages and disadvantages associated with this approach. For advantages, this approach reduces the "blended audio" period, minimizing moments where both mixes overlap unnaturally. Also, it works well for distinct audio streams (e.g., original vs. dubbed audio, commentary vs. stadium sounds) and prevents speech intelligibility issues that occur when two voices are simultaneously heard during a slow fade. For disadvantages, this approach is less smooth than a gradual crossfade when the two mixes contain similar elements (e.g., different language versions of the same dialogue) and requires careful selection of transition timing to avoid jarring switches.

In some embodiments, the X-Fade logic 100 may comprise smart gain-based blending (not shown). This approach applies frequency-dependent gain interpolation rather than a uniform fade across the entire spectrum. It prioritizes certain frequency bands based on audio content, making the transition more perceptually natural. More specifically, with this approach, instead of fading all frequencies equally, this method applies different gain curves to different frequency bands. In particular, for dialogue-heavy content, frequencies between 1 kHz and 4 kHz (speech intelligibility range) fade more smoothly, and low-frequency elements (background music, effects) fade faster or remain temporarily to avoid gaps. For music or environmental sounds, the low and mid frequencies transition first, while high frequencies fade in more gradually to maintain clarity. When compared to a traditional crossfade, such as that shown herein with Figs. 10A-10D, there are certain advantages and disadvantages associated with this approach. For advantages, this approach prevents mid-transition "muddiness" caused by overlapping full-spectrum audio. Also, it improves speech intelligibility by prioritizing dialogue clarity over background noise. In addition, it can create more natural transitions between different types of content. For disadvantages, this approach requires real-time frequency analysis, making it computationally more expensive. Also, it may introduce unintended artifacts if not carefully tuned.

In some embodiments, the X-Fade logic 100 may comprise adaptive crossfade with content awareness (not shown). This approach uses real-time audio analysis to determine the best fade shape and duration based on the similarity of Mix A and Mix B. More specifically, with this approach, the system analyzes audio characteristics (e.g., spectral content, loudness, speech presence). If Mix A and Mix B contain similar elements (e.g., both are dialogue-heavy), a longer, more gradual fade is used. If Mix B introduces a drastically different element (e.g., moving from a spoken commentary to crowd noise), a faster fade is applied to avoid confusion. In some embodiments, machine learning models may be used to classify audio types and dynamically adjust fade parameters based on past data. When compared to a traditional crossfade, such as that shown herein with Figs. 10A-10D, there are certain advantages and disadvantages associated with this approach. For advantages, this approach reduces perceptual distractions by adapting the transition to the content. Also, it avoids awkward overlaps between similar content types. In addition, it can be optimized for accessibility use cases (e.g., ensuring clear speech during transitions). For disadvantages, this approach requires real-time analysis and adaptive decision-making, making it computationally heavier. Also, it is harder to predict or manually control compared to a fixed crossfade.

In some embodiments, the X-Fade logic 100 may comprise multi-channel matrix mixing with dynamic weighting (not shown). In this approach, instead of crossfading between two stereo streams, this method keeps all potential audio mixes available in a multi-channel format (e.g., 4.0, 5.1) and dynamically adjusts their levels based on user preference. More specifically, with this approach all audio options (e.g., original mix, enhanced dialogue mix, Spanish mix) are kept in a multi-channel format. Also, a matrix mixer dynamically adjusts the gain of each mix, smoothly blending between them without actually fading one in and out. In addition, it may be controlled using a fader UI, automation, or an AI-driven recommendation system. When compared to a traditional crossfade, such as that shown herein with Figs. 10A-10D, there are certain advantages and disadvantages associated with this approach. For advantages, this approach allows instantaneous and seamless transitions without noticeable fade artifacts. Also, it reduces the need for destructive crossfading, preserving audio quality, and is more flexible for users who want to fine-tune their experience (e.g., 75% original mix + 25% enhanced dialogue). For disadvantages, this approach requires a playback system capable of handling multi-channel audio and can be more complex to implement in traditional stereo playback environments.

In some embodiments, the X-Fade logic 100 may comprise spectral cross-adaptive mixing with dynamic weighting (not shown). This is an approach that analyzes the spectral components of Mix A and Mix B and cross-adapts them to create a smooth transition with phase coherence. More specifically, with this approach a real-time frequency analysis of both mixes is performed. Instead of applying a simple volume-based fade, overlapping spectral components are blended intelligently. Also, uses phase-coherent morphing techniques to prevent phase cancellation artifacts. In addition, it may use machine learning to predict optimal spectral adjustments for seamless blending. When compared to a traditional crossfade, such as that shown herein with Figs. 10A-10D, there are certain advantages and disadvantages associated with this approach. For advantages, this approach prevents phase issues that can occur when blending similar content, creates a seamless and transparent transition without noticeable overlap, and works well for complex audio environments where different layers need to be preserved. For disadvantages, this approach is computationally expensive and requires high-performance processing. Also, it is more difficult to implement in real-time streaming applications.

Other techniques or methods may be used for the X-fade logic 100 if desired, provided they provide the function and performance of those described herein.

The present disclosure describes an accessible audio streaming system having an automatic personalized cross-fade (per language) renderer on a user device. In some embodiment, as described herein, if no measurement (or sensing or recording) of environmental noise floor (NF) is available (e.g., no microphone), the accessibility X-fade renderer (or accessibility fader or cross-fader or cross-fade slider) may become available to the user through the UI user device, as described herein. In some embodiments, the X-fade renderer may be available to the user independent of the sensing of the noise floor NF. In that case, the system may provide an initial X-fade setting based on the measured NF (or NF capture), and the user may further adjust the setting if desired for optimal listening experience for the user.

In addition, the present disclosure provides for personalized audio streaming. In some embodiments, there may be crossfade between Cin-Mix and Max-Acc-Mix audio tracks, which equalizes non-dialogue (or M&E) and also may, in some embodiments, provide high-fidelity voice-over ((VO), e.g., two languages simultaneously rendered) or narration ((AD) e.g., Audio Description dialogue added to the primary dialog), either using automatically using NF-capture or manually using the X-fade slider by the user/listener, as discussed herein.

In some embodiments, dialogue isolation (DI) from the rest of the audio mix is performed, and perceived loudness of the mix is preserved. Also, various known AI machine learning (ML) models (open-source and commercial) may be used for extracting dialogue from video stream (e.g., Spleeter® (by Deezer Research), demucs (by Meta), AudioShake® (by AudioShake), or the like), as discussed herein. In that case, the known ML models would be trained using existing data sets for extracting dialogue from video across a broad range of content.

For the ALN logic, a target loudness normalization gain (ALN gain) is applied to the accessible mix to make sure all the elements of the accessible mix are above the noise floor, e.g., -16 LKFS is industry standard for mobile noisy environment. Also, the ALN gain may be a function of the content type, e.g., soft/quiet scenes, action/loud scenes, and the like. Also, the same processing would apply to Dolby ATMOS (having more channels, which do not need to be modified).

In some embodiments, the input audio signal may be in 5.1 or 5.1.4 immersive sound, including Dolby Atmos. In that case, the Dialogue Clarity Engine (DCE) which includes Dialogue Enhancement (DE) and Dynamic Range Control (DRC), can handle these formats as well. In some embodiments, the dialogue clarity engine (DCE) includes dialog-aware remixing engine (or Enhanced Dialogue Insertion (EDI)) for better dialogue clarity surround audio 5.1 delivery together with a combination of Dialogue Enhancement (DE),Dynamic Range Control or Compression (DRC), or Audio Loudness Normalization (ALN), as discussed herein.

In some embodiments, e.g., when the input audio is 5.1 surround sound or immersive 5.1.4 and all speaker layouts, the story-telling dialogue (or Dx) (from the script read by the actors or talent) may already be separated out from the video on its own channel (e.g., the center channel), in which case Dialogue Isolation (DI) Logic is optional, and DCE gains (or DCE Params or compensation gains) may be applied directly to the center channel (C) of the audio input signal. In addition, the DCE gains are also applied to all the remaining channels (other than C channel) during the final normalization (ALN) step to preserve overall loudness (surround normalization). In addition, the DCE gains (or DCE Parms) may be a function of the content type, e.g., soft/quiet scenes, action/loud scenes, and the like. The same processing as the one described above for surround sound 5.1 or the like would apply to immersive sound such as Dolby ATMOS or the like (i.e., sound set-ups having more channels and self-contained separate dialogue objects(s),).

Technology of the present disclosure is device agnostic. Also, for embodiments that require it, dual or multi audio decoding and audio capture are all natively supported by Apple®, Amazon®, and Roku® operating systems (OS), which significantly facilitates integration & testing of the present disclosure and may also be provided in a streaming service app software or API, which may include or be part of the App Logic 16 discussed herein. Also, the present disclosure supports HLS/DASH streaming protocols which support multi-media streaming and the associated bit rate for 2 stereo streams which is equivalent to surround audio bit rate and is already proven from a CDN delivery standpoint for over a decade, which has shown no negative impact on streaming quality of experience (QoE). Surround and Immersive payload delivery would require 5.1 +1 (surround + enhanced center channel (Max-Acc-Mix)) or 5.1.4 +1 (immersive/Atmos + enhanced center channel (Max-Acc-Mix)). Alternative Personalized Dolby Audio deliveries ay simply apply to the stereo creative mix or the automated stereo downmix from the Immersive/Surround creative (near-field) mixes e.g., Dolby dual stereo encoding of (2.0 Cin-Mix + 2.0 Max-Acc-Mix (or Max-Pers-Mix)).

As discussed herein, in some embodiments, the system of the present disclosure uses the measured (or captured) Noise Floor (NF or Accessibility Fader) level to tune the X-Fade rendering to the environment (e.g., plane, car, bedroom, etc.) in real time using both the Original Cinematic and an Accessible Audio track (or Max-Acc-Mix) also called max personalized audio track (Max-Pers-Mix).

In some embodiments, as discussed herein, the present disclosure provides that an Environmental Noise Floor (NF) may be estimated while filtering out human voice frequency range, crossfade (Left and Right) may be power preserving so that loudness and stereo/spatial image are not affected, DRC may be applied pre-encode and affects M&E loudest and softest parts (not dialogue).

Also, as discussed herein, PL stands for Program Loudness as specified in ITU-R BS.1770-1. LRA or Loudness Range is a measure of the range between loudest and softest part across all channels of an audio track. DPL or Dialogue to Program Loudness; LKFS = Loudness K-weighted Full Scale. M&E stands for Music and Effects (i.e., sound effects or special effects, etc.; everything except for dialogue/storytelling). In some embodiments, once DRC is applied, a target loudness normalization gain is applied to the accessible mix to make sure all the elements of the accessible mix are above the noise floor e.g. -16 LKFS is industry standard for mobile noisy environment, as discussed herein.

In some embodiments, accessible stereo mix (or Mac-Acc-Mix) may be produced directly by video recording studios and/or generated by the content provider or streaming service performing the media processing DCE, which may be scaled to an entire video on demand (VOD) catalog securely on premises of the content holder. Accessibility rendering (Cinematic crossfade to DE+DRC or Max-Acc-Mix) may be scaled to all streaming environments & devices.

As discussed herein, the X-Fade renderer may be driven either by the measured (or captured) noise floor (NF) or manually controlled by the user/listener within the streaming service app with an accessibility fader or X-fade renderer or X-fade Logic, as discussed herein. For example, in a noisy environment, the X-Fade slider may be set such that the effect of DRC in the DCE may be high and the effect of DE is present or on. In another example, a user may be watching through a streaming device at home and select a X-Fade slider position where the DRC may be low and DE is on. Additionally, when a user is watching in their home in an optimal environment, the user may set a X-Fade slider position where the effect of DRC is low (may be off or not as effective) and a user could choose to select a slider position where the effect of DE is only an amount needed by the user to understand the dialogue (i.e., accessible audio), based on preference.

The present disclosure may also be used with accessible DOLBY® stereo/ downmix. In that case, crossfade (or X-Fade) may be applied per L/R channel of 2.0 downmix. DE is applied to the active dialogue of the 2.0 downmix. All channels of the mix shall have the same DRC applied. A Single Dual-Stereo EC3 encoder/decoder may be used, e.g., 2x 2.0 independently encoded mixes.

The present disclosure provides for embodiments which include an accessible Dolby® audio delivery for all Dolby capable devices. Smart TV or device manufacturers (OEMs) that downmix from Atmos 5.1.4 (having five speakers at ear level (left front, center, right front, left surround, right surround), a subwoofer, and four speakers for overhead audio (two front and two rear height channels), to 3.0 (having three channels, left, right, and center) or 2.0 (having two channels, left and right) will work with the present disclosure but may reduce dialogue intelligibility. Also, OEMs virtualizing Atmos 5.1.4 over limited number of speakers will also work with the present disclosure but may reduce intelligibility (e.g. Dolby certification does measure intelligibility). Streaming Dolby-encoded accessible streams that may be used with the present disclosure for "consumer grade" Dolby systems in the home may include the following options: Atmos/5.1 <> 2.0 Downmixes, e.g., Cinematic<>Accessible; Stereo 2.0 Native Mixes, e.g., Cinematic<>Accessible; Surround 5.1 Native Mixes, e.g., Center channel Cinematic<>Accessible; Atmos 5.1.4 Native Mixes, e.g., Center channel Cinematic<>Accessible.

The present disclosure also provides for embodiments which include a Single Multi-channel Audio Encoder/-Decoder. MPEG AAC-LC and Dolby E-AC3 support "dual stereo" encoding mode, e.g. 2x 2.0/stereo independently encoded. MPEG AAC-LC and Dolby E-AC3 support "quad mono" encoding mode, e.g. 4x 1.0/mono independently encoded. Dolby (E-AC3 + Joint-Object Coding) = Atmos encoder supports main and associated audio in a single bitstream. In some embodiments, the present disclosure may use known source FFmpeg® or Gstreamer® software tools for audio signal processing.

As discussed herein, the present disclosure includes some embodiments which provide for personalized accessibility which is adaptive to hearing abilities. In that case, the Accessible Audio (or Max-Acc-Mix) is decoded and further equalized to compensate for hearing loss frequency response per user. For example, the hearing loss function (e.g. Audiogram) may be provided by a 3rd party audiogram API such as Knisper®, a device operating system (e.g. iOS® etc.), or a streaming Service app listening test mode.

In some embodiments, as discussed herein, the present disclosure includes some embodiments which include a system for providing personalized voice-over which is adaptive to a user's language skills (beginner, intermediate, expert), where a user can select the loudness level of the voice over dialogue. For example, an inexperienced English speaker may select to hear both languages with their mother tongue in the background for assistance e.g. voice-over mode. Similarly, an intermediate English speaker may select to hear their primary language (or mother tongue) in the background only for difficult sentences detected. The user language ability-based content may be provided by the content provider have specific mixes for each desired level of voice-over, providing an adaptive experience for the user/listener.

As discussed herein, in some embodiments, the present disclosure includes the dialogue clarity engine (DCE) 62 for use with Stereo 2.0 audio delivery (Fig. 3A). In this embodiment, the Dialogue Isolation (DI) logic extracts active storytelling dialogue from the rest of the mix (e.g. M&E) in both left and right channels of the mix using a 2-stem separation (ML) model. The Dialogue Enhancement (DE) logic applies amplification to the separated storytelling dialogue L/R channels and attenuation to the residual L/R channels so that the original program loudness is maintained. In that case, the Dynamic Range Compression (DRC) logic may be only applied to the residual channels. The Stereo Remix (or Enhanced Dialogue Insertion - EDI) logic combines the left dialogue (or vocal) and M&E (or residual) channel to generate the dialogue enhanced L/R channels. Lastly, the accessibility target loudness (ATL) logic may drive the attenuated residual DRC and the final Audio Loudness Normalization (ALN) step, in some embodiments.

As discussed herein, the present disclosure also includes some embodiments which provide a dialogue clarity engine for receiving audio in Surround 5.1 audio delivery. In that case, the Dialogue Isolation (DI) may extract active storytelling dialogue from the rest of the mix (e.g. M&E) in the Center channel of the mix using a 2-stem separation (ML) model. Dialogue in other audio channels may be considered as sound effects and not storytelling. The Dialogue Enhancement (DE) logic may apply amplification to the separated storytelling dialogue channel (vocals) and attenuation to the residual channel so that the original program loudness is maintained. The Dynamic Range Compression (DRC) logic may be only applied to the attenuated residual channel. The Mono Remix (or Enhanced Dialogue Insertion - EDI) logic step combines the vocal and residual channels into the dialogue enhanced audio channel.

The present disclosure will also work with input audio having Immersive 5.1.4 audio delivery and DOLBY Atmos 5.1.4 and DOLBY Surround 5.1. In that case, Crossfade (X-Fade) is applied to the Center channel of the mix where the active storytelling dialogue is present (other channel dialogue are assumed to be sound M&E or FX exclusively). In that case, the DE Logic is applied to the active dialogue of the Cinematic Center Channel and, in some embodiments, an additional Single Mono Channel EC3 encoder/decoder may be used. The associated audio encoding bs mode of the EC3 encoder may be used to deliver an "Accessible Center Channel."

As discussed herein, the present disclosure, provides for an embodiment of the Dialogue Clarity Engine (DCE) 62 which may have as an input audio signal 2.0 Stereo Audio and may provide Dynamic Range Control of "Dialogue Enhanced" Cinematic Stereo (as shown in Fig. 3E, DCE Model #3). In such an embodiment, the Dialogue Isolation (DI) logic extracts active storytelling dialogue from the rest of the mix (e.g. M&E). The Dialogue Enhancement (DE) logic applies amplification to the separated storytelling dialogue L&R channels and attenuation to the residual L&R channels. The amplified dialogue and attenuated residuals may be remixed after the DE logic. Next, the Dynamic Range Compression (DRC) logic may be applied to the Dialogue Enhanced stereo audio, e.g., to the M&E to compress the M&E loudness range. The Audio Loudness Normalization (ALN) logic may be applied to normalize the output stereo to the desired target loudness, e.g., -16 LKFS or same LKFS as the source measured integrated loudness. The system may use a 2-stem separation model, in which the product Demucs® made by Meta® may be used to provide audio separation.

As discussed herein, the present disclosure, provides for an alternative embodiment of the Dialogue Clarity Engine of 2.0 Stereo Audio: Dialogue Enhancement of "DRC'ed" Cinematic Stereo. In this embodiment, Dynamic Range Compression (DRC) is applied to the source cinematic mix. Then, Dialogue Isolation (DI) extracts active storytelling dialogue from the rest of the mix (e.g. M&E). Next, Dialogue Enhancement (DE) applies amplification to the separated storytelling dialogue L&R channels and attenuation to the residual L&R channels. The amplified dialogue and attenuated residuals are mixed after the DE but before ALN is applied. Audio Loudness Normalization (ALN) is applied to normalize the output stereo to the desired target loudness, for example to 16 LKFS or the same LKFS as the source measured integrated.

As discussed herein, the present disclosure provides for an alternative embodiment of the Dialogue Clarity Engine of Surround & Immersive Audio Dynamic Range Control of "Dialogue Enhanced" Center Channel. In this embodiment, Dialogue Isolation (DI) extracts active storytelling dialogue from the rest of the mix (e.g. M&E) in the Center channel using a 2-stem separation (ML) model. Dialogue in other audio channels may be considered as sound effects and not storytelling. Dialogue Enhancement (DE) applies amplification to the separated storytelling dialogue channel and attenuation to the residual channel so that the original program loudness is maintained. Dynamic Range Compression (DRC) is applied to the Dialogue Enhanced Center Channel resulting from the sum of Amplified Dialogue and Attenuated Residual. Audio Loudness Normalization (ALN) is applied to normalize the "DE+DRC enhanced" Center Channel to the desired target loudness, for example -16 LKFS or same LKFS as the Center Channel measured integrated.

As discussed herein, the present disclosure, provides for an alternative embodiment of the Dialogue Clarity Engine of Surround & Immersive Audio Dialogue Enhancement of "DRC'ed" Center Channel. In this embodiment, the Dynamic Range Compression (DRC) is applied to the source Center Channel. The Dialogue Isolation (DI) extracts active storytelling dialogue from the rest of the mix (e.g. M&E) in the Center channel using a 2-stem separation (ML) model. Dialogue in other audio channels may be considered as sound effects and not storytelling (or spoken words essential to the story) per say. The Dialogue Enhancement (DE) applies amplification to the separated storytelling dialogue channel and attenuation to the residual channel so that the original program loudness is maintained. The Audio Loudness Normalization (ALN) may be applied to normalize a "DRC+DE enhanced" Center Channel to the desired target loudness, for example -16 LKFS or same LKFS as the Center Channel measured integrated.

As discussed herein, the present invention allows for provision of accessible audio, meaning that a listener can hear and understand the dialogue being spoken in the content. In some embodiments, one option to activate accessible audio includes an automatic activation and the streaming software application running on, e.g., a smart phone, laptop, Smart TV, or other smart playing device, when that device has access to a device microphone capable of measuring the noise floor and adjusting the crossfade renderer (X-Fade) to provide the desired listening experience.

In some embodiments, another option to activate accessible audio in situations where there is no access to a microphone or like device, the user will either use the remote control of the Smart TV, as discussed herein, to activate the accessibility renderer implemented within the streaming service app on a device, as discussed herein. This demonstrates the ability for a user to adjust accessibility features using a remote (or similar device) paired to the streaming service app. For example, variations of a short or long press of different buttons on the remote (e.g., volume up/down button) could be used to control different functions (such as the accessibility renderer). This embodiment may be beneficial when the user's device does not have a microphone capable of measuring noise floor, etc. Customization of the functions of the remote can be tailored to accommodate a user's ability to control the accessibility renderer (or Acc App and Decoder(s)) which may be part of a Smart TV OS streaming service application.

As discussed herein the present disclosure provides an Accessibility Fader (or X-Fade), which may be displayed on the UI (or UX, user experience) (see Figs. 12A-12C) which may be part of a streaming service application (e.g., Apple plus, Hulu, Amazon Prime Video, and the like) to activate the Accessibility Renderer. Additionally, there are many ways to implement an Accessibility Renderer or the X-Fade renderer. The present disclosure shows a power-preserving crossfade renderer may be used to implement an accessibility renderer. Other equations or configurations or techniques may be used for the X-fader if desired, some of which are discussed herein above.

In some embodiments, as discussed herein, an accessibility switcher can be activated on the UI/UX (user interface/user experience) of any streaming app delivering audio (premium entertainment, podcast, music etc.) to allow end users to control how much they want the content to become accessible by means of an Accessibility Fader (or X-Fade) which blends in real time both the Cinematic Audio and the Accessible Audio (Mac-Acc-Mix or DRC+DE processed) according to a limited set of pre-defined levels of accessibility which are pre-rendered and may be available on origin, start up, or as a default condition. In one example, 5 stereo streams are pre-rendered and available for streaming to the end-user according to which level of accessibility is selected on the X-Fade or UI/UX fader. This post-decode switching solution may be applied per language delivered to the end-user and does not require all languages to have the accessibility payload - this solution is fully backward compatible with legacy ABR (Adaptive Bitrate) switching technology and the payload remains unchanged. In some embodiments, an "accessibility switcher" may be a UI/UX element that allows a user to select a pre-rendered accessible audio stream. A "legacy ABR" (adaptive bitrate) Switcher is a known audio switching technology in the art, used by streaming services to select the best available stream by the device based on device capabilities, available network speed, customer membership plan (ads or premium etc.).

As discussed herein, in some embodiments, the present disclosure may have only 2 pre-rendered streams: the cinematic and the Max-Acc-Mix (or "drc+de" mix) accessible audio streams that enable a total accessibility rendering with only 2 streams/stereo pairs. However, in alternative embodiments, the renderer may select 2 out of 3 pre-rendered streams: the cinematic (Cin-Mix), the Mid-Acc-Mix (or "drc-only" mix) accessible and the Max-Acc-Mix (or "drc+de" mix) accessible audio streams that rely on a three-input progressive accessibility fader with 3 gain structure, as shown in Fig. 10C. In some embodiments, the "progressive" accessibility fader may be a cross-fade renderer that has access to 3 pre-rendered accessible audio streams and can more progressively render multiple layers of accessibility in real time, as discussed herein.

As discussed herein, the present disclosure provides an option to activate accessible audio through user control of the accessibility renderer of the streaming service application by using a device (e.g., a smartphone, tablet, etc.) that is paired to the streaming service app. This embodiment may be beneficial when the user's device does not have a microphone capable of measuring noise floor, etc.

In accordance with embodiments of the present disclosure, the accessibility renderer (or X-Fade) can be activated on the UI/UX of any streaming app delivering audio (premium entertainment, podcast, music etc.) to end users who can very precisely and continuously control how much they want the content to become accessible by means of an accessibility fader (or X-Fade) which blends in real time both the Cinematic Audio and the Accessible Audio (Mac-Acc-Mix or DRC+DE processed). Such a post audio decode rendering solution is applied per language delivered to the end-user and does not require all languages to have the accessibility payload - this solution is fully backward compatible with legacy ABR switching/decoding technology. However, the Accessibility payload is double to the legacy payload as a minimum of 2 stereo pairs shall be delivered to the renderer. In some embodiments, a "total" accessibility fader may be a cross-fade renderer that has access to only 2 pre-rendered accessible audio streams (1 stream is accessible and the other is not) and can fully render all the layers of accessibility in real time e.g. all at once.

As discussed herein, the present disclosure provides for NF-Adaptive and Complete Audio Accessibility, Dialogue Enhancement (DE) & Dynamic Range Control (DRC) are combined. In that case, Environmental Noise Floor (NF) may be estimated while filtering out human voice frequency range. Cross-fade (Left and Right) shall be power preserving so that the loudness and the stereo/spatial image are fully preserved. DRC is applied pre-encode and affects M&E loudest and softest parts (not dialogue). Once DRC is applied a target loudness normalization gain is applied to the accessible mix to make sure all the sound elements of the accessible mix are above the noise floor e.g. -16 LKFS is industry standard for noisy environments. PL stands for Program Loudness in LKFS unit as specified in ITU-R BS.1770-1. LRA or Loudness Range represents the measurement of the range between the loudest and softest part across all channels of an audio track. DPL or Dialogue to Program Loudness in LKFS as specified in ITU-R BS.1770-1.

In some embodiments, the Dynamic Range Control (DRC) & Dialogue Enhancement (DE) may be combined. In that case, the DRC may be applied first together with a target loudness normalization gain to make sure all the sound elements of the accessible mix are above the "worst case" noise floor (e.g. -16 LKFS is industry standard for noisy environments). DE is applied post DRC as the final enhancement to further boost the dialogue over the M&E.

In some embodiments, the present disclosure includes providing personalized accessibility to adaptive hearing abilities. Here, the accessible audio (e.g., Max-Acc-Mix) is decoded and rendered together with the Cinematic Audio (1) and then further equalized (2) to compensate for hearing loss frequency response of each user of a given streaming service. The hearing loss function may be provided (for compensation by the Personalized EQ) by a: 3rd party audiogram API such as Knisper®; device operating system (e.g. iOS, etc.); and/or streaming service app listening test mode.

In some embodiments, as described herein, the present disclosure includes providing accessible & personalized audio delivery for voice on demand (VOD). Accessible Stereo Mix may be produced by Studios and/or generated by media processing DCE which scales to the entire VOD catalog securely on premises. Accessibility Rendering (Cinematic (or Cin-Mix) crossfade to Max-Acc-Mix (or DE+DRC)) scales to all streaming environments & devices. The X-Fade renderer is driven either by the captured NF or controlled by the user within the streaming service app (e.g., the Acc App or Hub Acc App 16 of Figs. 2A-2D) with an accessibility fader or X-Fader. Personalized EQ (PEQ) may be applied after (or post) X-Fade renderer in the playback experience on a per-user basis. The hearing loss function may be measured during the streaming service profile set-up or provided by the device OS. The PEQ compensates for the hearing loss function of the active member profile by boosting certain frequency ranges within the X-Fade Mix to enable personalized hearing adjustment.

In some embodiments, the present disclosure includes a method for providing a multi-channel accessible stereo encoder (MASE) in accordance with embodiments of the present disclosure. MPEG AAC-LC and Dolby E-AC3 support "dual stereo" encoding mode e.g. 2x 2.0/stereo independently encoded. Dolby (E-AC3 + Joint-Object Coding) = Atmos encoder supports main and associated audio in a single bitstream. As discussed herein, native support for implementing the present disclosure may be provided with known open-source software audio processing tools, such as FFMPEG® or Gstreamer®.

The following defined terms and concepts may be referenced throughout the present disclosure and may be components of the system and method and/or various alternative embodiments of the system and method of the present disclosure, and in the aforementioned commonly-owned provisional patent applications.

The Cross-Fade Renderer, which may also be referred to herein as X-Fade, X-Fader, renderer, cross-fade or CFR, combines or blends multiple audio files or experiences with power preserving amplitude panning curves, instead of abruptly switching between audio streams with different functionalities or focuses. This involves the input of multiple audio assets or files or content with multiple audio channels in the WAV/PCM format, with a resulting output of 1 audio file with multiple audio channels in the WAV/PCM format, in one embodiment. The cross-fade renderer may use software running on a streaming service (or content provider) application that is running on iOS®, Android®, Roku®, etc., as discussed herein.

The Dialogue Clarity Engine (DCE) is a digital audio signal processing engine performing one or more of the following: (1) dialogue isolation (DI) from the other elements of the mix (usually implies source separation techniques with neural networks); (2) dialogue enhancement (DE) in terms of dialogue boost to increase the overall dialogue intelligibility; and (3) dynamic range control (DRC) of the mix to make the dialogue intelligible on any size of loudspeaker and any type of noisy environment. The input for this engine is typically audio asset or content with active dialogue (used for story telling), with the resulting output being an audio asset or content file with boosted active dialogue such that the overall loudness of the mix remains unchanged compared to the input audio source. DCE may be performed using software running on a streaming service-owned/provisioned hardware, as discussed herein.

Dialogue Isolation (DI) includes the isolation of the active story telling dialogue from the audio source mix. In particular, Dialogue Isolation (DI) involves using software, typically a machine learning (ML) model, such as an open-source artificial intelligence (AI) or machine learning (ML) model like Demucs by Meta, running on streaming service (or content provider) hardware, to isolate the active story telling dialogue from the asset audio source mix. DI involves the input of an asset audio source in uncompressed PCM format (e.g., N = 2ch, 6ch, 10ch, etc.), with resulting outputs of audio with dialogue content exclusively (e.g., K = 2ch, 1ch, 1ch etc.) and of audio with non-story telling dialogue (or non-dialogue or music and effects or M&E) content exclusively (e.g., the residual, L = 2ch, 5ch, 9ch, etc.).

Dialogue Enhancement (DE) applies amplification to the separated storytelling dialogue channel and attenuation to the residual channel so that the original program loudness is maintained. DE involves digital audio signal analysis and processing used to boost the active dialogue (used for story telling) and attenuate the other components of the mix to make the dialogue stand out further without modifying the overall loudness of the resulting mix compared to the source or input audio mix. The input for DE is an audio asset with active dialogue (used for story telling), with the resulting output being an audio asset with boosted active dialogue (used for story telling) such that the overall loudness of the mix remains unchanged. DE may be performed by software running on a streaming service-owned/provisioned hardware, as discussed herein.

Dynamic Range Compression/Control (DRC) involves digital audio signal analysis and processing to limit the span/range of the audio sample amplitude to avoid listener experiencing drastic loudness jumps going from quite to loud scenes. For the purposes of DRC, the terms compression and control are used interchangeably. The involves the input of a full dynamic range audio asset, with a resulting output of a compressed dynamic range audio asset. DRC is accomplished through use of a software running on a streaming service-owned/provisioned hardware. Examples of DRC profiles that are applied include: "Film Standard", "Film Light" or "Noisy Environment," and the like.

Enhanced Dialogue Insertion (EDI) (or Stereo EDI or Stereo Remix) uses known audio signal combining software to individually combine the left channel of the dialogue (or vocal) mix and residual (or M&E) mix and the right channel of the dialogue (or vocal) mix and residual (or M&E) mix to generate the dialogue enhanced left/right (L/R) channels. The inputs to stereo EDI or remix may be (1) the outputs of DRC + DE processing, or (2) the outputs of DE + DRC processing, with the resulting output of the EDI logic being a stereo pair L/R of fully accessible audio.

Loudness Range (LRA) is a measure the range between loudest and softest part across all channels of an audio track. Integrated Loudness (IL), defined by the LoudLAB company at: https://www.loudlab-app.com/sonicatom/en/2.html, which defines IL and various other audio terms described herein.

Accessibility Target Loudness (ATL) involves use of software to normalize the audio channels to a target audio loudness in LKFS unit. The input being stereo pair L/R channels as well as the target LKFS value (typically negative number such as -20 or -16 LKFS), with the resulting output being a normalized stereo pair L/R with measured audio loudness at the target LKFS value. The term gain may also represent the accessibility target loudness (value in LFKS unit).

Audio Loudness Normalization (ALN) is used to level set expectations on how loud the ALN audio output can get when played on consumer audio electronics/devices. By applying ALN, the integrated audio loudness of the processed audio will on average over the entire duration of the asset reach X LKFS where X is set by the content provider in conjunction with best practices and industry standards. The input for ALN being an Accessible Audio track (or Max-Acc-Mix) made up of DRC+DE or DE+DRC processed audio from the DCE 62, either 2 channel for stereo sources or 1 channel (center) for surround/immersive audio sources. The output of ALN is a Normalized Audio output of the ALN and DCE, which is either 2 channel for stereo sources or 1 channel (center) for surround/immersive audio sources. ALN involves the use of software running on a content provider/streaming service-owned/provisioned hardware. Audio Loudness Normalization (ALN) is applied to normalize the output stereo to the desired target loudness, e.g., -16 LKFS or the same LKFS as the source-measured integrated loudness (IL).

In some embodiments, the present disclosure includes a least a method of increasing the audio dialogue level of digital cinematic content while preserving creative intent of the cinematic content, comprising receiving a cinematic audio signal; receiving an accessible audio signal (e.g., Max-Acc-Mix); and combining the cinematic audio (Cin-Mix) signal and accessible audio (Max-Acc-Mix) signal to provide an improved dialogue audio signal which allows a listener to hear the dialogue over a noise floor.

The system and method of the present disclosure will work with any codec that provides the function and performance described herein. Examples of codecs (or encoding and decoding formats) that may be used with the present invention are shown at: https://en.wikipedia.org/wiki/Comparison of audio coding formats or known IAMF standard codecs from AOM at: https://aomedia.org/specifications/iamf/. As is known, "codec" is a hardware-based or software-based process that compresses and decompresses large amounts of data. Codecs are used in applications, such as in the present disclosure, to send media files efficiently over a network as well as to receive and play media files for users on the receiving end.

The term "accessible" audio mix or track, as used herein, means an audio track that has dialogue clarity across all noise environments, devices and abilities, such that the dialogue can be understood as if the listener was in a cinematic experience (without subtitles). Also, in the present disclosure, the audio or sound units of LKFS, dB, and TruePeak are used in various examples herein for illustrative purposes, and it should be understood by those skilled in the art how the units relate to each other.

Also, while some embodiments of the system of the present disclosure are shown as storing the encoded (and interleaved) digital audio track in an encoded server at a content provider side and then retrieving the same for use by the user/listener side, it should be understood that the encoded digital audio track may alternatively or additionally be sent directly (e.g., by the encoder or other hardware or software) over a communications network to the user/listener device(s), which decodes the digital audio tracks for use by user playing devices, as described herein.

Embodiments of the present disclosure may also include the method described herein wherein the creating an accessible audio signal comprises using a dialogue clarity engine. Embodiments of the present disclosure may also include the method described above wherein the dialogue clarity engine comprises: receiving the cinematic audio signal; and performing at least one of: Dialogue Isolation (DI), Dialogue Enhancement (DE), Dynamic Range Compression (DRC), Audio Loudness Normalization, Dialogue to Program (or non-dialogue or M&E or residual) Loudness (DPL), mono Enhanced Dialogue Insertion or EDI (or remix) and stereo EDI (or remix). Embodiments of the present disclosure may also include the method described above wherein the combining comprises using a cross-fade renderer.

In some embodiments, the crossfade experience may also rely on an accessible audio track mix (or accessible mix) that is generated by a mixer and not by the dialogue clarity engine (DCE) (which may be AI-based). Also, in some embodiments, to allow for wide compatibility with current production means from studios, the mixer (which generates the accessible mix or Max-Acc-Mix) may be tailored or pre-set to a worst-case scenario, such as, older customers with hearing disabilities, poor TV speakers, poor sound connectivity, and/or high environmental noise floor.

The system and method of the present disclosure includes the necessary computers, servers, devices and the like with the necessary electronics, computer processing power, interfaces, memory, hardware, software, firmware, logic/state machines, databases, microprocessors, communication links, displays or other visual or audio user interfaces, printing devices, and any other input/output interfaces, to provide the functions or achieve the results described herein. Except as otherwise explicitly or implicitly indicated herein, process or method steps described herein may be implemented within software modules (or computer programs) executed on one or more general purpose computers. Specially designed hardware may alternatively be used to perform certain operations. Accordingly, any of the methods described herein may be performed by hardware, software, or any combination of these approaches. In addition, a computer-readable storage medium may store thereon instructions that when executed by a machine (such as a computer) result in performance according to any of the embodiments described herein.

In addition, computers or computer-based devices described herein may include any number of computing devices capable of performing the functions described herein, including but not limited to: tablets, laptop computers, desktop computers, smartphones, smart TVs, set-top boxes, e-readers/players, and the like.

Although the disclosure has been described herein using exemplary techniques, algorithms, or processes for implementing the present disclosure, it should be understood by those skilled in the art that other techniques, algorithms and processes or other combinations and sequences of the techniques, algorithms and processes described herein may be used or performed that achieve the same function(s) and result(s) described herein and which are included within the scope of the present disclosure.

Any process descriptions, steps, or blocks in process or logic flow diagrams provided herein indicate one potential implementation, do not imply a fixed order, and alternate implementations are included within the scope of the preferred embodiments of the systems and methods described herein in which functions or steps may be deleted or performed out of order from that shown or discussed, including substantially concurrently or in reverse order, depending on the functionality involved, as would be understood by those reasonably skilled in the art.

It should be understood that, unless otherwise explicitly or implicitly indicated herein, any of the features, characteristics, alternatives or modifications described regarding a particular embodiment herein may also be applied, used, or incorporated with any other embodiment described herein. Also, the drawings herein are not drawn to scale, unless indicated otherwise.

Conditional language, such as, among others, "can," "could," "might," or "may," unless specifically stated otherwise, or otherwise understood within the context as used, is generally intended to convey that certain embodiments could include, but do not require, certain features, elements, or steps. Thus, such conditional language is not generally intended to imply that features, elements, or steps are in any way required for one or more embodiments or that one or more embodiments necessarily include logic for deciding, with or without user input or prompting, whether these features, elements, or steps are included or are to be performed in any particular embodiment.

Although the invention has been described and illustrated with respect to exemplary embodiments thereof, the foregoing and various other additions and omissions may be made therein and thereto without departing from the scope of the present disclosure. In addition, it should be understood that the present invention can alternatively be defined in accordance with the following embodiments:

1. A computer-based method for creating a maximum accessible audio mix (Max-Acc-Mix), comprising:

   receiving original cinematic mix (Cin-Mix) audio content; and
   adjusting the Cin-Mix using a dialogue clarity engine (DCE) having predetermined DCE gains to create the Max-Acc-Mix.

2. The method of embodiment 1, wherein the dialogue clarity engine comprises:

   receiving the cinematic audio signal; and
   performing at least one of: Dialogue Isolation (DI), Dialogue Enhancement (DE), Dynamic Range Compression (DRC), Audio Loudness Normalization (ALN), Enhanced Dialogue Insertion (EDI).

3. The method of embodiment 1 or 2, wherein the dialogue clarity engine (DCE) comprises at least one of: Dialogue Isolation (DI) which separates the dialogue audio and the non-dialogue audio, Dialogue Enhancement (DE) which amplifies the dialogue audio relative to the non-dialogue audio by a predetermined DE gain, Dynamic Range Compression (DRC) which compresses the non-dialogue audio or a combined dialogue audio and non-dialogue audio, and audio loudness normalization (ALN) which amplifies the dialogue audio or of the combined dialogue and non-dialogue audio using a predetermined ALN gain.

4. The method of one of embodiments 1 to 3, wherein the Dynamic Range Compression (DRC) comprises attenuation of predetermined upper or lower sections of a range of the non-dialogue audio or of the combined dialogue and non-dialogue audio by a predetermined DRC gain profile.

5. The method of one of embodiments 1 to 4, wherein the creating the MaxAccMix comprises adjusting the DCE amplification gains such that the dialogue audio and non-dialogue audio are both greater than a predetermined acceptable noise floor.

6. The method of one of embodiments 1 to 5, further comprising providing a UI that allows a content provider user/admin to adjust DCE Parameters, the DCE parameters comprising at least one of: noise floor, Dx Gain Factor, MNE Gain Factor, Gdx, Gmne, DCE Mode, DRC Gain profile, and ALN Gain.

7. The method of one of embodiments 1 to 6, wherein the Cin-Mix is in format of at least one of: mono, stereo, surround sound, and immersive sound.

8. The method of one of embodiments 1 to 7, wherein the Dialogue Enhancement (DE) comprises at least one of: amplification of the dialogue and attenuation of the non-dialogue, while maintaining the same overall loudness, and amplification of the dialogue only.

9. The method of one of embodiments 1 to 8, wherein the Dynamic Range Compression (DRC) comprises attenuation of predetermined upper or lower sections of a range of the non-dialogue audio or of the combined dialogue audio and non-dialogue audio by a predetermined DRC gain profile.

10. A computer-based method for generating an accessible audio mix (Acc Mix) of dialogue audio and non-dialogue audio (residual music/effects) that allows a listener user to understand the dialogue audio played on a user playing device (or listening device) in a listening environment having plurality of different actual noise floor levels, comprising:

receiving, at a user device, a cinematic mix (CinMix) and a maximum accessible mix (MaxAccMix) associated with video/audio content to be viewed and listened to by a user from the user device;

creating the AccMix audio mix by blending the CinMix and the MaxAccMix such that the resultant AccMix audio mix is power preserving and is greater than a noise floor (NF) in the listening environment of the user device, the AccMix having a range from the CinMix value to the MaxAccMix value, the value of AccMix being based on at least one of user input and the actual noise floor level.

11. The computer-based method of embodiment 10 wherein the AccMix is automatically set based on an actual noise floor in the listening environment, the actual noise floor being measured by a sound sensor which filters out human voices from the audio signal to provide the actual noise floor level.

12. A computer-based method of increasing the audio dialogue level of digital cinematic content while preserving creative intent of the cinematic content, comprising:

receiving a cinematic audio mix;
receiving an accessible audio mix; and
combining the cinematic audio mix and accessible audio mix to provide an improved dialogue audio mix which allows a listener to hear the dialogue over a noise floor.

13. The method of embodiment 12, wherein the combining comprises using a cross-fade renderer.

14. A computer-based method of fading from a first audio mix (MixA) to a second audio mix (MixB), comprising:

receiving the MixA audio mix;
receiving the MixB audio mix;
combining MixA and MixB using a cross-fade renderer having an output that transitions from MixA to MixB based on the position of a X-Fade slider.

15. The computer-based method of embodiment 14, wherein the cross-fade renderer is power preserving.

16. The computer-based method of embodiment 14 or 15, wherein MixA and MixB comprises at least one of: MixA = Main language original version (or Cin-Mix) and MixB = enhanced dialogue Main language (Max-Acc-Mix); MixA = Main language original version and MixB = Main language audio description; MixA = Main language original version and MixB = Alternate language audio voice-over; MixA = Main language original version and MixB = Alternate language audio description; MixA = home team commentary mix and MixB = away team commentary mix; and MixA = home team commentary mix and MixB = stadium sounds (no commentary) mix.

**Claims**

1. A computer-based method for generating a personalized accessible audio mix (Acc Mix) of audio content having dialogue audio and non-dialogue audio that allows at least one user to hear and understand the dialogue audio when played on a user playing device in a listening environment having an actual noise floor (NF) level, comprising:

receiving, at the user playing device, an original cinematic audio mix (CinMix) having the dialogue audio and the non-dialogue audio as set from a recording studio;
receiving, at the user playing device, a maximum accessible mix (MaxAccMix) of the dialogue audio and the non-dialogue audio, the Max-Acc-Mix being a audio modification of the CinMix such that a loudness range of the dialogue audio and a loudness range of the non-dialogue audio are greater than a predetermined acceptable noise floor and less than a predetermined maximum audio loudness limit; and
combining the CinMix and MaxAccMix to create the personalized AccMix audio mix which is power preserving and has an loudness of the dialogue audio that allows a user to hear and understand the dialogue audio when played on the user playing device in a listening environment having the actual noise floor (NF) level,
wherein the value of the personalized AccMix ranges from the CinMix value to the MaxAccMix value, and is a power preserving combination of CinMix and MaxAccMix therebetween, and the personalized AccMix value is set based on at least one of user input and the actual noise floor level.

2. The computer-based method of claim 1, wherein AccMix is automatically set based on an actual noise floor in the listening environment, the actual noise floor being measured by a sound sensor which filters out human voices from the audio signal to provide the actual noise floor level.

3. The computer-based method of claim 1 or 2, wherein the CinMix and the Max-Acc-Mix are received in a single stream or digital file and further comprising decoding the single stream to provide individual tracks for CinMix and Max-Acc-Mix.

4. The computer-based method of claim 1, wherein AccMix is adjusted manually using a X-Fade slider through a user interface.

5. The computer-based method of one of the preceding claims, wherein the at least one user comprises a plurality of users, each user being able to set their own personalized AccMix.

6. The computer-based method of one of the preceding claims, wherein the power preserving combination of CinMix and MaxAccMix is performed using a cross-fade renderer using sine and cosine curves as factors based on the position value of an X-Fade slider.

7. The computer-based method of one of the preceding claims, further comprising providing a personalized equalization of the AccMix based on Freq. Range weighting factors corresponding to the user.

8. The computer-based method of one of the preceding claims, further comprising providing a UI which provides at least one of: list of content to create an AccMix, Accessibility Fader, Voice-Over Fader, Live Sports Fader, Audio Description Fader, Adaptive Voice-Over, Language Selection, Language Level Selection, Personalized EQ Selection.

9. The computer-based method of one of the preceding claims, further comprising receiving a command from a user to adjust X-Fade.

10. A computer-based method for creating a maximum accessible audio mix (Max-Acc-Mix), comprising:

   receiving original cinematic mix (Cin-Mix) audio content; and
   adjusting the Cin-Mix using a dialogue clarity engine (DCE) having predetermined DCE gains to create the Max-Acc-Mix.

11. The method of claim 10 wherein the dialogue clarity engine comprises:

   receiving the cinematic audio signal; and
   performing at least one of: Dialogue Isolation (DI), Dialogue Enhancement (DE), Dynamic Range Compression (DRC), Audio Loudness Normalization (ALN), Enhanced Dialogue Insertion (EDI).

12. The method of claim 10 or 11, wherein the dialogue clarity engine (DCE) comprises at least one of: Dialogue Isolation (DI) which separates the dialogue audio and the non-dialogue audio, Dialogue Enhancement (DE) which amplifies the dialogue audio relative to the non-dialogue audio by a predetermined DE gain, Dynamic Range Compression (DRC) which compresses the non-dialogue audio or a combined dialogue audio and non-dialogue audio, and audio loudness normalization (ALN) which amplifies the dialogue audio or of the combined dialogue and non-dialogue audio using a predetermined ALN gain.

13. The method of one of claims 10 to 12, wherein the Dynamic Range Compression (DRC) comprises attenuation of predetermined upper or lower sections of a range of the non-dialogue audio or of the combined dialogue and non-dialogue audio by a predetermined DRC gain profile.

14. The method of one of claims 10 to 13, wherein the creating the MaxAccMix comprises adjusting the DCE amplification gains such that the dialogue audio and non-dialogue audio are both greater than a predetermined acceptable noise floor.

**15.** The method of one of claims 10 to 14, further comprising providing a UI that allows a content provider user/admin to adjust DCE Parameters, the DCE parameters comprising at least one of: noise floor, Dx Gain Factor, MNE Gain Factor, Gdx, Gmne, DCE Mode, DRC Gain profile, and ALN Gain.

*FIG. 1*

FIG. 2A

**200A** User/Listener Side (Smart TV w/Remote Control or User Device controlled Cross-Fade)

FIG. 2B

FIG. 2C

FIG. 2D - Mult. Decoders

Dialogue Clarity Engine (DCE) (Model 1)
(DI->DE->DRC->EDI->ALN)

FIG. 3A

Dialogue Clarity Engine (DCE) (Model 2)
(DRC->DI->DE->EDI->ALN)

FIG. 3B

Dialogue Clarity Engine (DCE) (Model 3)
(DI->DE->EDI->DRC->ALN)

FIG. 3C

Dialogue Clarity Engine (DCE) (Model 4)
(DI->DRC->DE->EDI->ALN)

*FIG. 3D*

EP 4 636 762 A1

Dialogue Clarity Engine (DCE) (Model 5)
(DI->DRC->ALN->DE->EDI)

*FIG. 3E*

FIG. 4

EP 4 636 762 A1

FIG. 5A

500

Content Server (Non-Encoded):

Interleaved Audio Stream for Accessible Audio - Any Language

| Cin-Mix English (original) |
| Max-Acc-Mix English (from DCE) |

AUDIO ENCODER

Sampled & Interleaved

Sample 1　　　Sample 3　　　Sample N

| Cin-Mix1 | Max-Acc-Mix1 | Cin-Mix2 | Max-Acc-Mix2 | Cin-Mix3 | Max-Acc-Mix3 | Cin-Mix4 | Max-Acc-Mix4 | ... | Cin-MixN | Max-Acc-MixN |

Sample 2　　　Sample 4

To Content Server (Encoded):

Encoded & Interleaved

FIG. 5B

515

Content Server (Non-Encoded):

Interleaved Audio Stream for Accessible Audio - 3 input X-Fade

| Cin-Mix English (original) |
| Mid-Acc-Mix English (from DCE) |
| Max-Acc-Mix English (from DCE) |

AUDIO ENCODER

Sampled & Interleaved

Sample 1　　　　　　　　Sample N

| Cin-Mix1 | Mid-Acc-Mix1 | Max-Acc-Mix1 | Cin-Mix1 | Mid-Acc-Mix2 | Max-Acc-Mix2 | ... | Cin-MixN | Mid-Acc-MixN | Max-Acc-MixN |

Sample 2

To Content Server (Encoded):

Encoded & Interleaved

FIG. 5C

530

Content Server (Non-Encoded):

Interleaved Audio Stream for Accessible Voiceover Audio - Any Language

| Cin-Mix English (original) |
| Max-Acc-Mix English (from DCE) |
| Cin-Mix Spanish (original) |
| Max-Acc-Mix Spanish (from DCE) |

AUDIO ENCODER

Sampled & Interleaved

Sample 1　　　　　　　　　　　　Sample N

| Cin-Mix1 English | Max-Acc-Mix1-Engl | Cin-Mix1-Spanish | Max-Acc-Mix1-Span | Cin-Mix2 English | Max-Acc-Mix2-Engl | Cin-Mix2-Spanish | Max-Acc-Mix2-Span | ... | Cin-MixN English | Max-Acc-MixN-Engl | Cin-MixN-Spanish | Max-Acc-MixN-Span |

Sample 2

To Content Server (Encoded):

Encoded & Interleaved

47

*FIG. 5D*

580

## Encoding and Decoding options

| | Encoding | Audio Fidelity | Decoding | Complexity |
|---|---|---|---|---|
| **2x AAC-LC**<br>**2x 2.0 streams** | Dual Stereo 2x 128 = 256 kbps | High Quality | 2 MPEG decoders | Low |
| **1x AAC-LC**<br>**1x4.0 stream** | Quad Mono 4x 96 = 384 kbps | Transparent Quality | <u>1 MPEG decoder</u> | Very Low |
| **2x EC3**<br>**2x 2.0 streams** | Dual Stereo 2x 160 = 320 kbps | High Quality | 2 Dolby decoders | Medium |
| **1x EC3**<br>**1x4.0 stream** | Quad Mono 4x 96 = 384 kbps | Transparent Quality | <u>1 Dolby decoder</u> | Low |
| **2x AC3**<br>**2x 2.0 streams** | Dual Stereo 2x 192 = 384 kbps | High Quality | 2 Dolby decoders | Medium |

Non Dolby Devices

Dolby Devices

*FIG. 5E*

EP 4 636 762 A1

*FIG. 6*

EP 4 636 762 A1

*FIG. 7*

DRC/EDI/ALN

FIG. 8

*FIG. 9*

# X-Fade Renderer Logic
## (Cinematic to Accessible)

Power-Preserving Crossfade

A —— $g_0$ Gain Curve Cos $(X \cdot 90°)$ Applied to Cin-Mix
B --- $g_1$ Gain Curve Sin $(X \cdot 90°)$ Applied Max-Acc-Mix

Cin-Mix Adj = (Cin-Mix) Cos $(X \cdot 90°)$
Max-Cin-Mix Adj = (Max-Acc-Mix) Sin $(X \cdot 90°)$

**Full Accessibility Crossfade**
Rendered Mono

*FIG. 10A*

EP 4 636 762 A1

# X-Fade Renderer Logic
## (Cinematic to Accessible Stereo)

1030

Power-Preserving Crossfade

1032

1034

A

B

$g_0$

$g_1$

1036

Amplitude (Gains)

1

0.8

0.6

0.4

0.2

0

0    0.2    0.4    0.6    0.8    1

X%

Full Accessibility

Slider Position (X)

A —— $g_0$ Gain Curve Cos (X·90°) Applied to Cin-Mix L0/R0
B --- $g_1$ Gain Curve Sin (X·90°) Applied to Max-Cin-Mix L1/R1

1020

Cin-Mix
L0/R0

Max-Acc-Mix
L1/R1

1021A    1021B    1025A    1025B

1022    100    1024

$g_0$    1023B    $g_1$

1023A    1027A

1028A    1027B    1028B

L    R

1009A    1009B

X-Fade Mix

**Full Accessibility Crossfade**
Rendered Stereo

EP 4 636 762 A1

*FIG. 10B*

**X-Fade Renderer Logic** 1040
(Cinematic to Accessible Stereo - Progressive)

**Progressive Accessibility**
Crossfade Rendered Stereo

A ——— $g_0$ Gain Curve Cos (X·180°) Applied to Cin-Mix L0/R0 (set $g_2$=0)
B — · — $g_1$ Gain Curve Sin (X·180°) Applied to Mid-Acc-Mix L1/R1
C – – – – $g_2$ Gain Curve Sin (X·180°) Applied to Max-Acc-Mix L2/R2 (set $g_0$=0)

*FIG. 10C*

*FIG. 11*

FIG. 12A

FIG. 12B

**Accessibility Fader:** 1210 — **Acc App UI** (Cross-Fade & Mode Selection) — Content Audio Files — Lang. Level — 1289

Enhanced Dialogue — 1212

Orig. Dialogue

X-Fade Mix  Volume [ ]

3:02:55

Select Content  Audio File 1

1286  **Personalized EQ**
3rd Party Audiogram: [X]
Device OS (e.g., IOS): [X]
CP App Listening test mode: [X]

| Name | Date Modified |
|---|---|
| Audio File 1 | Date 1 |
| Audio File 2 | Date 2 |
| Audio File 3 | Date 3 |
| Audio File 4 | Date 4 |
| ... | ... |
| Audio File N | Date N |

| Lang. | Level |
|---|---|
| US | Beg |
| ES | Int. |
| FR | Exp. |
| DE | |

**Voice-Over Fader:** 1280

VO Language Only — 1281
Middle-Even Split
Orig. Language Only

X-Fade Mix  Volume [ ]

3:02:55

**Live Sports Fader 1:** 1282

No Commetary — 1283
Middle-Even Split
No Crowd Noise

X-Fade Mix  Volume [ ]

3:02:55

1284 **Live Sports Fader 2:**

Visiting Team Only — 1285
Middle-Even Split
Home Team Only

X-Fade Mix  Volume [ ]

3:02:55

**Acc Features:**

| | | | |
|---|---|---|---|
| Hub Mode: [X] | Single Device: [X] | Personalized EQ: [X] | |
| Synch Smart TV: [X] | Remote: [X] | Adaptive Voice-Over: [X] | X-Fade Mix OK |
| Mic: [X] | Live Sports: [X] | Audio Desc: [X] | |

1288  1294

*FIG. 12C*

EP 4 636 762 A1

**FIG. 12D**

1300

Portal/DCE Logic

Enter

1302

Receive content selection from CP user/admin through Portal UI

1304

Retrieve Cin-Mix audio for selected content from Non-Encoded Content Server

1304

Retrieve default (or saved) DCE Model, DCE Gains & Noise Floor (NF) from DCE Parameters Server

1314

Receive Adj. NF, DCE Gains & DCE Model

1306

Perform DCE Model with DCE Gains & NF and create/update Max-Acc-Mix

1308

Provide Max-Acc-Mix to CP computer display UI for CP user/admin (Portal UI logic)

1310

Receive X-Fade position value from CP user/admin and Perform X-fade logic on Cin-Mix & Max-Acc-Mix to create X-Fade Mix, and play X-Fade Mix on speaker(s) for CP user/admin

1312

Max-Acc-Mix Acceptable?

No

Yes

1316

Save/update DCE Model, DCE Gain & NF for selected content in DCE Params Server and provide Max-Acc-Mix to Audio Encoder

Exit

*FIG. 13A*

**1320**

## Portal UI Logic

( Enter )

**1322**
Retrieve latest Cin-Mix audio and Max-Acc-Mix (by channel) and provide to waveform display tool (Real Data)

**1324**
Display Portal UI with Waveform Window with Cin-Mix & Max-Acc-Mix waveform, and user selected parameters, including: X-Fade & Vol. Control, Audio File list, and DCE Params

**1326** Receive updated value for X-Fade slider from User?

No

Yes

**1328** Update X-Fade gain value in X-Fade Logic and on UI

**1330** Receive updated DCE Model type?

No

Yes

**1332** Update DCE Model to selected DCE model and on UI

Receive updated value for DCE Params? **1334**

No

Yes

**1336** Update selected DCE Params with user selected DCE Params and on UI

Receive updated value for Volume slider? **1338**

No

Yes

**1340** Update overall volume to speaker and on UI

( Exit )

*FIG. 13B*

## Acc App Logic

**1350**

**Enter**

**1352** Receive content selection from user/listener (Remote or User Device)

**1353** Send Request to Content API and Receive Cin-Mix and Max-Acc-Mix from Decoder and Subtitles (if needed)

**1356** — Yes — Hub Mode? **1354**

Perform Hub Mode

No

**1357** Single Mode? **1358**

Yes — Perform Single Mode

**1359** No

Perform Remote Control Mode

Noise Floor Signal Available? **1360**

No

Yes — Receive Noise Floor (NF) signal from mic **1361**

**1362** Perform X-fade logic on Cin-Mix & Max-Acc-Mix to create X-Fade Mix based on NF or X-Fade slider position from user

Synch Selected? **1364**

No

Yes — **1366** Perform Synch with current audio/video

Personalized EQ Enabled? **1368**

No

Yes — **1370** Perform personalized EQ on X-Fade Mix based on Pers EQ parameters on User Attrib. Server

**1372** Play X-Fade/EQ Mix on speaker(s) for user/listener

Adaptive VO Enabled? **1374**

No

Yes — **1376** Display Adaptive Voice-Over Content

**Exit**

*FIG. 13C*

Acc App UI Logic

1380

```
                              ( Enter )
                                  │
                                  ▼
1382  ┌──────────────────────────────────────────────────────────┐
      │ Display Acc App UI on User Device or Smart TV display, and user │
      │   selected parameters, including:  X-Fade & Vol. Control for:  │
      │ Acc Fader, VO Fader, Live Sports Fader 1&2, Lang., Audio File list, │
      │       Pers. EQ, Level, and Acc Features.                   │
      └──────────────────────────────────────────────────────────┘
                                  │
                                  ▼
1384     ┌─────< Receive updated value for a X-Fade slider from User? >
      No │              Yes │
1386     │      ┌──────────────────────────────────────────┐
         │      │ Update X-Fade gain value in X-Fade Logic and on UI │
         │      └──────────────────────────────────────────┘
         │                          │
         └──────────────────────────▼
         ┌─────< Receive updated ACC Feature selection? >          1388
      No │              Yes │
1389     │      ┌──────────────────────────────────────────┐
         │      │ Update status for the ACC Feature and on UI │
         │      └──────────────────────────────────────────┘
         │                          │
         └──────────────────────────▼                            1390
         ┌─────< Receive updated Pers EQ, Lang., or Level selection? >
      No │              Yes │
1391     │      ┌──────────────────────────────────────────┐
         │      │ Update status for Pers. EQ, Lang., or Level and on UI │
         │      └──────────────────────────────────────────┘
         │                          │
         └──────────────────────────▼                            1392
         ┌─────< Receive updated value for Volume slider? >
      No │              Yes │
1393     │      ┌──────────────────────────────────────────┐
         │      │ Update overall volume to speaker and on UI │
         │      └──────────────────────────────────────────┘
         │                          │
         └──────────────────────────▼                            1394
         ┌─────< Receive selection of X-Fade Mix OK? >
      No │              Yes │
1395     │      ┌──────────────────────────────────────────┐
         │      │ Save values of X-Faders on server         │
         │      └──────────────────────────────────────────┘
         │                          │
         └──────────────────────────▼
                              ( Exit )
```

FIG. 13D

FIG. 14A

1402

(Cin-Mix) Cinematic Mix from Studio

96

DCE Params — 83

DCE 62

MaxAccMix

92

Cin-Mix

96

Audio Encoder 26

94 • • • 203

Audio Decoder 202

MaxAccMix — 207

CinMix — 209

X-Fade 100

X-Fade Mix

225

FIG. 14B

1420

Sports Mix from OB truck

96

DCE Params — 83

DCE 62

ComMix/ StadiumMix

92

DCE 62

Stadium/Mix

92A

Audio Encoder 26

94 • • • 203

Audio Decoder 202

ComMix/ StadiumMix — 207

SportsMix — 209

StadiumMix — 250A

X-Fade 100

X-Fade Mix

225

FIG. 14C

1440

Home Sports Mix from Truck

96A

Away Sports Mix from Truck

96B

(Optional) DCE 62

Audio Encoder 26

94 • • • 203

Audio Decoder 202

Home — 207

Away — 209

X-Fade 100

X-Fade Mix

225

EP 4 636 762 A1

FIG. 14D

FIG. 14E

EP 4 636 762 A1

*FIG. 15A*

FIG. 15B

EP 4 636 762 A1

## EUROPEAN SEARCH REPORT

**Application Number**

EP 25 17 1287

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CZYZEWSKI ANDRZEJ ET AL: "Adaptive Personal Tuning of Sound in Mobile Computers", JAES, AES, 60 EAST 42ND STREET, ROOM 2520 NEW YORK 10165-2520, USA, vol. 64, no. 6, 27 June 2016 (2016-06-27), pages 405-428, XP040680829, | 10-15 | INV. G10L21/0364 H03G3/32 H03G9/00 H03G9/02 |
| A | * sections 2, 2.1, 2.2, 2.3, 3, 3.1, 3.2, 3.3, 4.4 * | 1-9 | |
| A | US 2017/098452 A1 (TRACEY JAMES [US] ET AL) 6 April 2017 (2017-04-06) * paragraph [0045] - paragraph [0046] * | 13 | |
| A | US 2023/238016 A1 (SCHINDLER CHRISTIAN [DE] ET AL) 27 July 2023 (2023-07-27) * the whole document * | 14 | |
| A | US 2020/266788 A1 (MA GUILIN [CN] ET AL) 20 August 2020 (2020-08-20) * the whole document * | 14 | |
|  |  |  | **TECHNICAL FIELDS SEARCHED (IPC)** |
|  |  |  | G10L H03G |

The present search report has been drawn up for all claims

| Place of search | Date of completion of the search | Examiner |
|---|---|---|
| The Hague | 18 July 2025 | De Meuleneire, M |

## ANNEX TO THE EUROPEAN SEARCH REPORT
## ON EUROPEAN PATENT APPLICATION NO.

EP 25 17 1287

This annex lists the patent family members relating to the patent documents cited in the above-mentioned European search report.
The members are as contained in the European Patent Office EDP file on
The European Patent Office is in no way liable for these particulars which are merely given for the purpose of information.

18-07-2025

| Patent document cited in search report | Publication date | Patent family member(s) | Publication date |
|---|---|---|---|
| US 2017098452 A1 | 06-04-2017 | NONE | |
| US 2023238016 A1 | 27-07-2023 | CN 115668372 A | 31-01-2023 |
| | | EP 3935636 A1 | 12-01-2022 |
| | | JP 7314427 B2 | 25-07-2023 |
| | | JP 2023518119 A | 27-04-2023 |
| | | US 2023238016 A1 | 27-07-2023 |
| | | WO 2021228935 A1 | 18-11-2021 |
| US 2020266788 A1 | 20-08-2020 | CN 105142067 A | 09-12-2015 |
| | | CN 110808723 A | 18-02-2020 |
| | | EP 3149970 A1 | 05-04-2017 |
| | | US 2017222611 A1 | 03-08-2017 |
| | | US 2020266788 A1 | 20-08-2020 |
| | | US 2023163741 A1 | 25-05-2023 |
| | | US 2025070737 A1 | 27-02-2025 |
| | | WO 2015183718 A1 | 03-12-2015 |

EPO FORM P0459

For more details about this annex : see Official Journal of the European Patent Office, No. 12/82

**REFERENCES CITED IN THE DESCRIPTION**

**Patent documents cited in the description**

- US 63636400
- US 99962824